# EUROPEAN PATENT APPLICATION

(11) **EP 4 658 039 A1**
(43) Date of publication of application: **03.12.2025**
(21) Application number: 24178271.3
(22) Date of filing: 27.05.2024
(51) Int. Cl.: H10K 50/11, H10K 85/30, H10K 85/60, H10K 101/20, H10K 101/30, H10K 101/40, H10K 101/00

(54) **ELECTROLUMINESCENT DEVICE COMPRISING A METAL ORGANIC COORDINATION COMPOUND WITH ELECTRONIC SPIN AS HOST MATERIAL**

(71) Applicant: beeOLED GmbH, 01217 Dresden (DE)
(72) Inventor: Rothe, Carsten, 01099 Dresden (DE)
(74) Representative: Altmann Stößel Dick Patentanwälte PartG mbB

(57) **Abstract**

An organic electroluminescent device comprises:
a first electrode,
a second electrode, and
an organic emission layer EML comprising:
▪ one metal-organic host compound MOH, and
▪ one organic emitter compound OE, and
with
• the metal-organic host compound MOH having a total spin of ≥1/2 and/or possessing one or more unpaired electrons,
• the lowest electronically excited state within the emission layer EML being an exciplex EX_{MOH / OE} formed by a single electron transfer between the MOH and the OE,
• the energy of the first excited triplet state of the organic emitter T1_{OE} being resonant or higher as compared to the energy of the Exciplex EE_{EX}: T1_{OE} ≥ EE_{EX},
• the energy difference of the emitting first excited singlet state S1_{OE} and the energy of the exciplex being less than 0.4 eV,: S1_{OE} - EE_{EX} ≤ 0.4eV.

## Description

### Technical Field

The invention concerns an organic electroluminescent device with a light emission layer comprising a mixture of a heavy metal organic material containing at least one unpaired electron such that the total electron spin is not zero, which is hosting an organic emitter material, as well as methods for forming the electroluminescent device, the metal organic host material, and the use of the mixed layer.

### Background

Electroluminescent devices that make use of organic light emitting diodes (OLEDs) are state-of-the-art for flat panel display applications used in everyday consumer electronics. For OLEDs, special organic materials, so-called emitters, are employed for the purpose of converting electrical excitation into light emission. For full color display applications red, green, and blue emitters are needed. However, the ongoing material development is most exclusively focused on blue emitters. The reason is twofold: First, while existing red and green emitter materials do offer high efficiency combined with saturated colors and good chemical stability, todays blue emitting materials that do offer reasonable chemical stability exhibit poor light generation efficiency. Secondly, advanced consumer display layouts use color conversion to generate the red and green spectral portions from the short wavelength blue emission as this substantially reduces complexity in manufacturing. Therefore, only blue emitting electroluminescent OLED devices are needed in future display designs. Thus, there is an urgent need for a color-saturated deep blue emitter with high efficiency and with high good chemical stability.

For most organic emitters, the excitation that is formed upon recombination of an electron and a hole on is called an "exciton". Depending on the spins of the recombining charges, there are two types of excitons formed in a statistical manner: 75% probability of triplet excitons with spin 1, and 25% probability singlet excitons with spin zero are generated. If the emitter molecule is heteroaryl-based without any significant content of heavy metals, than, because of quantum mechanical selection rules that ensure spin-conservation, only the singlet excitons contribute to light emission via fluorescence (FL), whereas all triplets decay non-radiatively. Thus, fluorescent OLEDs are comparably inefficient as 75% of the invested electrical power is wasted.

In a related art, intrametallic emitters based on the d-f transitions of divalent Europium (WO2021/244801A1) and trivalent Cerium (WO2023/194363A1) are disclosed, respectively. The excitation on those intrametallic emitter has a decay time of a few hundred nanoseconds and is indifferent to electrical excitation with singlet or triplet character.

In another approach, the quantum mechanical heavy-atom effect is used by introducing fourth and fifth row d-block metal elements, such as Iridium, Osmium, Gold, or Platinum into the emitter. The presence of such heavy elements softens the selection rules for the excited states in the emitters, allowing also triplet excitons to emit light on useful timescales; known as phosphorescence (Ph).

In another approach, thermally-activated delayed fluorescence (TADF) has been used, wherein by thoughtful design of the organic emitter molecule, the energy difference between the non-emissive triplet and the emissive singlet exciton is engineered to be very small. This allows triplets to thermally up-convert into singlet excitons via the so-called reverse intersystem-crossing process, and thereby contribute to light emission.

However, the decay time of the excited states in intrametallic, TADF, or Ph blue emitters is relatively long with 100 ns to 2000 ns, compared to less than 1 ns for a typical fluorescent emitter. During the rather long existence of the excited state quenching by charges, known as exciton-polaron quenching, becomes unavoidable. The efficiency suffers, in particular at higher driving currents which are needed to generate the high luminance needed in modern display applications, a phenomenon known as efficiency roll-off. Besides the long excited state lifetime also the emission characteristics of TADF and phosphorescence emitters are not ideal. Here, spectra are often wide, leading to low color purity. Furthermore, those emitters have their emission dipole typically aligned at random with respect to the device substrate, leading to relatively low light outcoupling efficiency. In contrast, modern fluorescence emitters, in particular so-called multiresonant fluorescent emitters based on aromatic fused boron-nitrogen heteroaryl groups, such as 2,12-di-tert-butyl-5,9-bis(4-(tert-butyl)phenyl)-5,9-dihydro-5,9-diaza-13b-boranaphtho[3,2,1-de]anthracene, feature very narrow pure emission spectra and, owing to their flat molecular structure, have their emission dipole preferably horizontally aligned.

One approach is to separate the singlet-triplet interconversion and the emission on two different molecules, which each are best suited for their respective purpose. In those approaches, high efficient devices emission layers with four materials are needed: Two host materials are needed to funnel electrons and holes to the compound doing the intersystem crossing, this host system is often referred to as exciplex host. The interconversion material should have a high photoluminescence quantum efficiency (PLQY), therefore its energy levels (HOMO and LUMO) should be nested within the exciplex host energy levels to ensure charge confinement on the interconverting material. The interconversion material is typically referred to as sensitizer. Finally, a multiresonant fluorescent emitter is present at very low concentrations. The emission spectrum of the sensitizer overlaps with the absorption spectrum of the emitter such that Förster resonant long range energy transfer (FRET) becomes efficient. The competing FRET process shortens the excited state decay on the sensitizer, therefore easing the roll-off problem. The fluorescent emitter has a color pure emission spectrum and is horizontally aligned for high light outcoupling efficiency.

In one approach, TADF sensitizers are used, and the system is dubbed hyperfluorescent. In another approach, phosphorescent sensitizers are used, in particular Pt(ll) based sensitizers.

In another related art, an intrametallic Ce(lll) emitter is used as sensitizer, see CN116096114A.

In all those approaches, electron hole recombination takes place preferably on the sensitizer: the energy (the exciton) is first on the sensitizer and subsequently transferred to the emitter. In the absence of the emitter, a high photoluminescent quantum efficiency of the sensitizer is required.

Although there are many very impressive literature results, two issues prevent using the sensitizer-emitter emission layer from wide-spread use in consumer displays: First, it is very difficult in mass production to control the concentration of four materials simultaneously. Second, the concentration of the emitter should be very low, but not too low, which again is very difficult to control precisely. If the concentration is too low, the FRET process is not efficient anymore, leading to roll-off at the sensitizer. On the other hand, the emitter should have a lower emission energy vs the sensitizer. The latter is already nested within the exciplex system. Therefore, the emitter molecule constitutes an even deeper charge trap for at least one of the two charges. Thus, low concentrations are required in order to not disturb the charge mobility too much, and to avoid direct recombination on the emitter, which would not be efficient, as here triplet excitations are formed too.

Thus, there is an persistent need for an emission layer that does employ the attractive emission characteristics of multiresonant emitters, but at the same time is more robust in processing, in particular requires less than four materials to be coevaporated and avoids the need of finetuning or metering very low emitter concentrations.

It is an objective of this invention to provide electroluminescent devices, preferably based on multiresonant fluorescent emitters, that emit deep blue light with high efficiency after electrical excitation. It's a particular objective to pump the multiresonant emitter using an intersystem crossing material that enables the use of singlet and triplet excitations that may be generated inside the emission layer. It's a further objective to avoid long excited state decay times on the intersystem crossing materials such as to avoid excitation - polaron quenching associated with strong roll-off. Finally, it's a particular objective to provide an emission layer system that can be easily produced using mass production sublimation equipment and with the emission layer requiring only three or less materials, with all materials being used at concentrations of no less than two weight percent.

The objectives are achieved by an organic electroluminescent device comprising:
a first electrode,
a second electrode, and
an organic emission layer EML disposed between the first electrode and the second electrode, the organic emission layer comprising:
   ▪ at least one, preferably one metal-organic host compound MOH, and
   ▪ at least one, preferably one organic emitter compound OE, and
   ▪ optionally one or more further organic host compounds,
      with
      - the metal-organic host compound MOH having a total spin of ≥1/2 and/or possessing one or more unpaired electrons,
      - the lowest electronically excited state within the emission layer EML being an exciplex EX_{MOH/OE} formed by a single electron transfer between the MOH and the OE, preferably by
         (a) the energy of the highest occupied molecular orbital HOMO of the neutral metal-organic host compound HOMO_{MOH} being the highest energy HOMO of all materials present within the EML and the energy of the lowest unoccupied molecular orbital LUMO of the organic emitter compound LUMO_{OE} being the lowest energy LUMO of all materials present within the EML or
         (b) the energy of the lowest unoccupied molecular orbital LUMO of the neutral metal-organic host compound LUMO_{MOH} being the lowest energy LUMO of all materials present within the EML and the HOMO energy of the organic emitter HOMO_{OE} being the highest HOMO of all materials present within the EML,
      - the energy of the first excited triplet state of the organic emitter T1_{OE} being resonant or higher as compared to the energy of the Exciplex EE_{EX}: T1_{OE} ≥ EE_{EX},
      - the energy difference of the emitting first excited singlet state S1_{OE} and the energy of the exciplex being less than 0.4 eV, preferably less than 0.3 eV, more preferably less than 0.2 eV: S1_{OE} - EE_{EX} ≤ 0.4eV, preferably ≤ 0.3eV, more preferably ≤ 0.2eV.

In this energetic arrangement, electrons and holes recombine first into a charge transfer state distributed between the emitter and the host, which acts as a reservoir for energy. The charge transfer state has a poor coupling to the ground state, and its excited state lifetime is comparably long. While one charge is residing on the metal organic host, the latter has a higher emission energy as compared to the emitter, so it will never be electronically excited, in other words -as opposed to the electrical charge-, the energy is never on the host material. Consequently, resonantly Förster energy transfer cannot take place. Instead, the charge transfer (EX_{MOH/OE}, exciplex) state couples with the local excited singlet and triplet states of the emitter. The emitter is configured to have a low singlet-triplet gap. In the absence of the metal-organic host material singlet and triplet excitations would form on the emitter as this is the lowest energy material in the emission layer and the efficiency would be poor, as only the singlet excitations would contribute to light emission. Surprisingly, using a host with high electron spin with unpaired electrons in proximity and coupled via an exciplex to the local singlet a triplet state of the emitter, we observe a significant enhancement of the light generation efficiency of the emitter. Without invoking any elaborate theory, and without being bound to any theory, it is reasonable to assume that the spin of the host enables singlet - triplet intersystem crossing on the emitter. In other words, the high spin host switches on triplet harvesting on the emitter by a process that could be dubbed spin activated delayed fluorescence. There is ample evidence for this surprising interaction provided in this disclosure. The recombination and the interconversion of triplet into singlet excitation happens directly (or as part of) the emitter materials. As nearest neighbor Dexter, instead of long range Förster transfer is operative, low concentrations of emitter are not needed and in fact not preferred. Since recombination and emission are not on separate molecules, so the emission layer requires only two or three materials, instead of four. Preferably, the organic emission layer EML (disposed between the first electrode and the second electrode) comprises or consists of two or three components or compounds: at least one, preferably one metal-organic host compound MOH, and at least one, preferably one organic emitter compound OE.

The present invention provides an electroluminescent device that emits deep blue light of high efficiency. This is achieved by the emitter being part of the electroluminescent device above, which is part of the exciplex with the metal organic host material having an emission energy in the deep blue spectral region, in particular a singlet emission energy of more than 2.6 eV, or even more than >2.65 eV.

According to the present invention, preferably the electronic excitation (recombined electrons and holes) should never be on the metal organic host material. Instead, the latter should host one charge, while the organic emitter does host the complementary charge as part of an exciplex, EX_{MOH/OE}. The exciplex should have the lowest excited state energy within the organic layer, and the local singlet state of the organic emitter is less than 0.4eV higher in energy. Additionally, the metal organic host has a higher emission energy (EE_{MOH}) as compared to the emissive state of the organic emitter (S1_{OE}): EE_{MOH} > S1_{OE}. This is to ensure that the exciplex couples preferably with the emissive singlet state of the organic emitter and not with the metal organic host.

The objectives of this invention, generative color pure deep light with high efficiency, are further achieved by using an emitter molecule that has a narrow deep blue emission spectrum and that is preferentially horizontally aligned with respect to the device surface to improve light outcoupling. Horizonal alignment is often observed for fused aromatic flat molecules. Therefore, the organic emitter preferably comprises a plurality of fused aryl and/or heteroaryl groups, preferably comprising at least one boron atom, preferably with the ratio of emitting dipoles parallel to the substrate plane being >66%, more preferably >80%, and most preferably >90% with the sum of vertical and parallel emission dipoles being 100%. Such emitters are often referred to as mulitresonant emitters.

The objective of the inventions may in particular be achieved using multitenant boron-nitrogen heteroaryl emitter derived from any of the generic formulae (D-1) to (D-4): 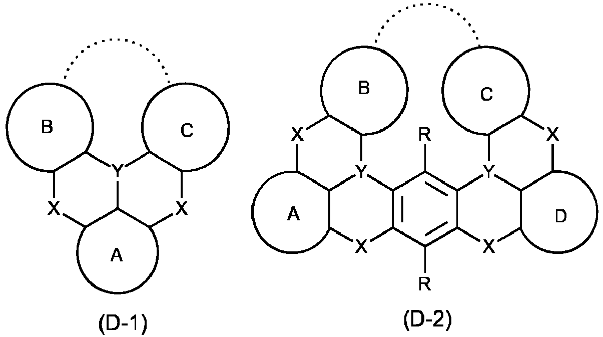 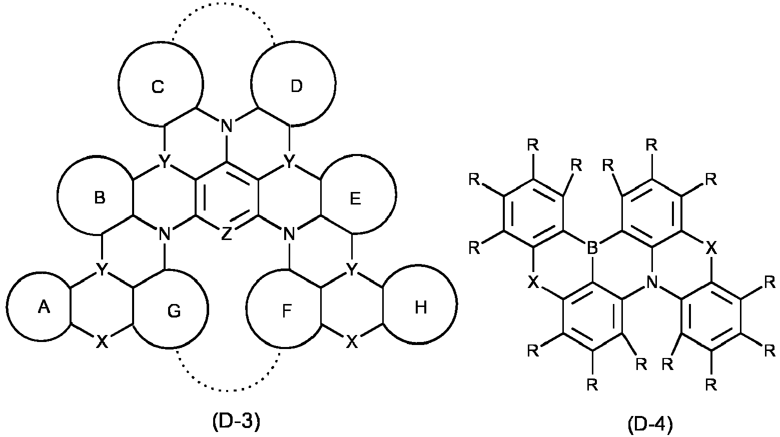 with,
- ring A, B, C, D, E, F, G, and H being each independently a substituted or unsubstituted aryl ring, or a substituted or unsubstituted heteroaryl ring, or a substituted or unsubstituted aliphatic ring, and
- a broken line connecting the B ring and the C ring in the formulae (D-1) or (D-2) and the broken lines connecting the C ring and the D ring and the G ring and the F ring in the formula (D-3) indicate that those rings are bonded or not, through a single bond or linking group at one of the available ring positions each and
- Z is CR₂ or NR, and
- X is each independently a single bond, NR, O, CR2, SiR2, S, or Se, and
- Y is each independently B, P, P(=O), P(=S), Al, Ga, As, CR, SiR, or GeR, preferably B, and
- R groups are each independently hydrogen, deuterium, halogen, aryl, heteroaryl, diarylamino, diarylboryl, alkyl, cycloalkyl, alkoxy or aryloxy, and adjacent R groups may be bonded to each other to form an aryl ring or heteroaryl ring.

These particular structures often allow for preferred horizonal alignment of the organic emitter molecule. At the same time, small energy differences between the first excited singlet and triplet state are often observed. Furthermore, emitters derived from such structures often exhibit emission with a narrow spectrum in the deep blue visible range.

Specifically suitable emitters derived from (D-1) to (D-4) are d01 to d12: 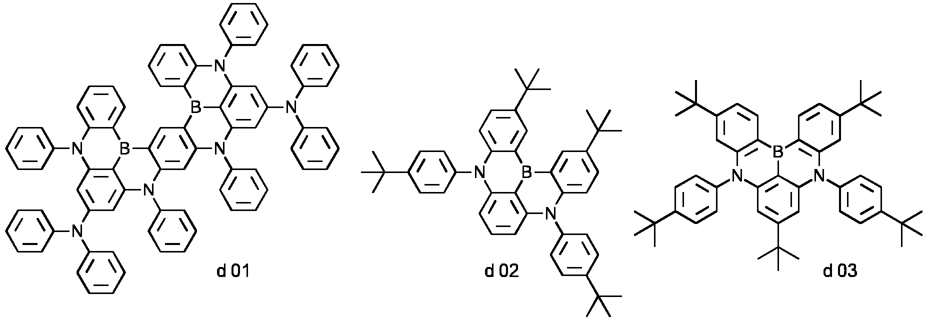 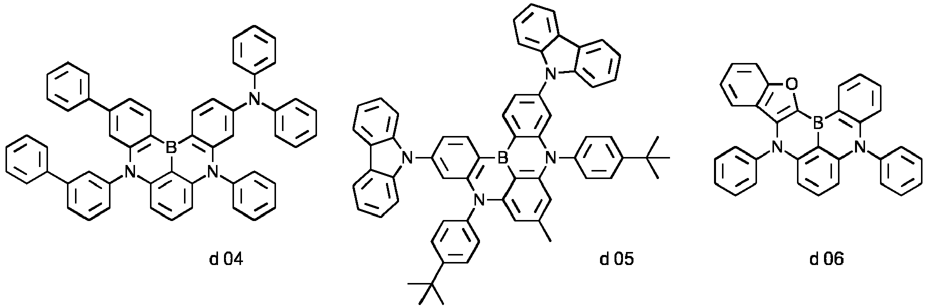 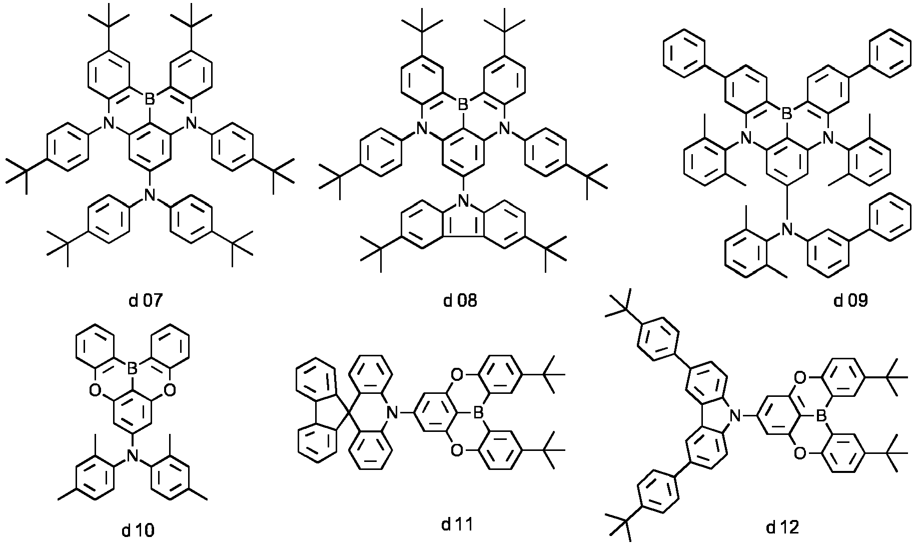 and the organic emitter used in the emission layer according to the invention may be selected from those lists and be derived from (D-1) to (D-4), or are d01 to d12.

The invention requires the use of metal organic complexes with unpaired electrons that preferably do not have their first electronically excited state in the visible spectrum but in the near-UV or very deep blue, in order to confine the energy (excitation) on the emitter, but not on the metal organic host material. Suitable metal cations to design such metal organic host complexes can be found within the lanthanides group. Of particular interest are metal-organic host materials comprising at least one metal cation selected from Gd(III), Ce(III), and Eu(II). The latter cations comprise one or seven unpaired electrons and, by choice of organic ligand, can be utilized in deep blue or UV emitting metal organic compounds suitable for this invention.

In a preferred emission layer according to the invention, the metal organic host compound being part of the exciplex with the emitter molecule does trap a charge as part of the exciplex but at the same time as well transports this type of charge. For example, if the metal organic host compound is configured to have the highest HOMO within the emission layer, it is preferred that the metal organic host compound as well transports holes towards the emitter. In various embodiments, this objective is preferably achieved iwhen the metal organic host compound comprises an organic ligand comprising one or more building blocks selected from CT-1 to CT-22: 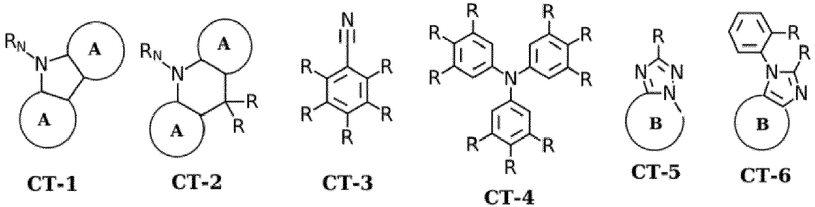 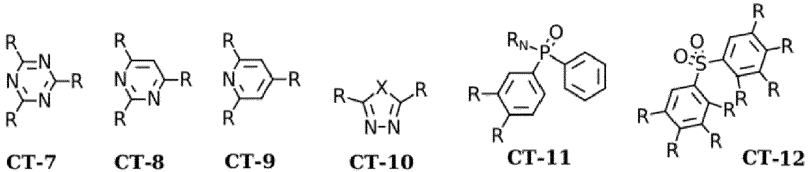 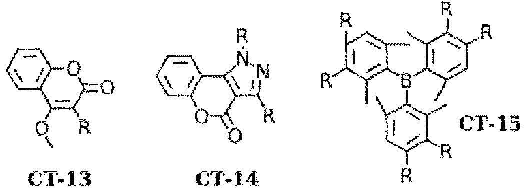 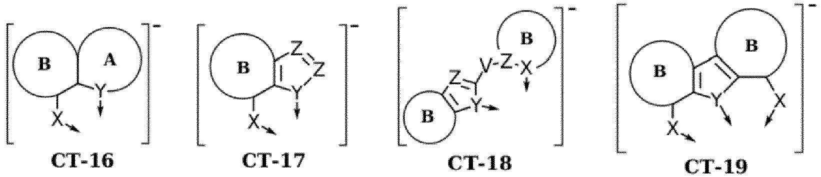 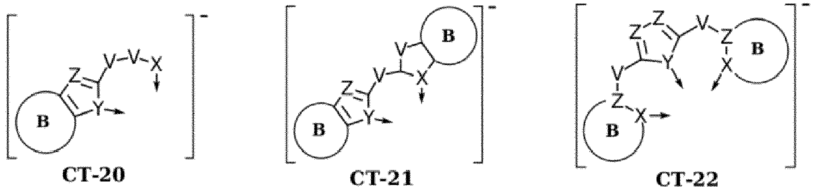 with
- arrows indicating a preferential coordination towards the metal center of the metal organic host compound MOH,
- **X** being independently in each occurrence a monovalent group selected from -O**R**, - S**R**, -N**R**2, -P**R**2,
- **V** being independently in each occurrence a divalent group selected from -O-, -S-, - N**R**-, -P**R**-, -C**R**2-, -Si**R**2-,
- **Y** being independently in each occurrence selected from N, or P,
- **Z** being independently in each occurrence selected from N, P, CR, SiR,
- **R** independently in each occurrence representing a monovalent organic group formed by removing a hydrogen atom from an organic molecule having at least one hydrogen, H, D, or halogen and **R_{N}** independently in each occurrence representing a monovalent organic group formed by removing a hydrogen atom from an organic molecule having at least one hydrogen , and

- **A** being independently in each occurrence a substituted or unsubstituted aryl ring, or a substituted or unsubstituted heteroaryl ring, or a substituted or unsubstituted aliphatic ring, and **B** being independently in each occurrence a substituted or unsubstituted aryl ring, or a substituted or unsubstituted heteroaryl ring, or a substituted or unsubstituted aliphatic ring or **B** representing no cyclic group, but instead the atoms being connected to B are saturated by H, or any organyl group R as defined above.

The light generation according to the invention proceeds via an exciplex. The latter is rather immobile, in particular not prone to energy transfer. Therefore, concentration quenching (high concentration of sites carrying an excitation) and coupling to impurity sites is not very pronounced. Consequently, the emission layer can tolerate an easy to manufacture, high concentration of exciplex forming sites and can be rather thin. In particular, the sum of the organic emitter concentration and the metal organic host within the emission layer according to the invention preferably is >20vol%, preferably >50vol%, or even 100%, that is, no other material apart from the metal organic complex and the organic emitter is substantially present within the emission layer and / or with the volume concentration of the metal organic host materials being at least 5 times, more preferably at least 10 times and most preferably at least 15 times higher as compared to the concentration of the organic emitting materials.

It is an objective of this invention to provide a simplified electroluminescent device structure with few different materials present. The metal organic host material may be configured to transport holes. Different from conventional phosphorescent OLEDs, this host has the shallowest HOMO within the emission layer, it is therefore comparably easy to injection holes into this compound. In the electroluminescent device according to the invention, the metal organic host material can be present in two or more organic layers and/or the metal organic host material can be present in all organic layers between the organic emission layer and one of the electrodes and / or the metal organic host material can be present as part of the hole injection layer in contact with the anode and being partly or completely oxidized into a cationic state by means of a suitable dopant material being present as part of the hole injection layer.

Preferably, the metal organic host compound comprises a macrocyclic or polymacrocyclic organic ligand with at least one of these ligands being described by the generic formula (1-1): 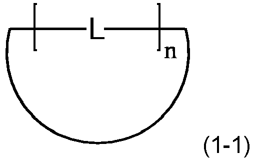 with
- **n** being 4 to 8, preferably 4 to 6; and
- **L** being independently in each occurrence a divalent organic group formed by removing two hydrogen atoms from an organic molecule having at least two hydrogens, with
- the shortest sequence of atoms linking each L with the remainder of the cyclic ligand being 3 to 5, preferably 3 atoms, and with
- one of those 3 to 5, preferably 3 atoms independently for each L being selected from N, P, S, Se, or O, preferably N, or O.

Such macrocyclic ligands may encapsulate the metal cation thereby forming particularly morphologically stable host materials which lead to stable exciplex formation together with the organic emitter molecule.

The objective of the invention is further achieved by using metal-organic host compounds containing a single organic ligand and a single metal cation; specifically, a metal cation of oxidation stage +2 or +3 in combination with a single two or threefold electrically negatively charged organic ligand respectively, such that the combination of the organic ligand with the cation forms a complex of neutral electrical charge. Such ligands without any non-covalently electrically charged parts or non-covalently bound anions may form particularly morphologically stable host materials which lead to stable exciplex formation together with the organic emitter molecule.

The objective is further achieved by an emission layer according to the invention that comprises at least one charge neutral organic host material (not the metal organic host compound MOH) at a concentration of >1vol%, preferably >10%, and most preferably >30%, based on an overall composition of the organic layer which is 100 vol%, with this host material preferably configured to transport electrons and/or holes and/or having a triplet energy higher than the singlet energy of the organic emitter compound.

Preferably the organic layer according to the invention comprising the metal organic host compound and the organic emitter and any optional host material is deposited from gas phase, in particular using an evaporation and/or sublimation and/or carrier gas process such as to fit the mass production of most OLED displays today.

### Brief Description of the Drawings

In the drawings, like reference characters generally refer to the same parts throughout the different views. The drawings are not necessarily to scale, emphasis is instead generally being placed upon illustrating the principles of the invention. In the following description, various aspects of the invention are described with reference to the following drawings, in which:
**FIG. 1** and **FIG. 2** for an emission layer according to the invention schematically depict the relevant energy levels of the charge redox state, and the relevant lowest electronically excited states, respectively.
**FIG. 3** and **4** exemplify metal organic host materials with two and trivalent metal cations, respectively, that may be present in electroluminescent devices according to the invention.
**FIG. 5** exemplifies organic emitter compounds that may be present in the electroluminescent device according to the invention as well as counter examples.
**FIG. 6, FIG. 7** and **FIG. 8** illustrate schematic cross sections of organic electronic devices according to various aspects.
**FIG. 9****. FOG. 10,** **FIG. 11,** and **FIG 12** depict electroluminescence device characteristics of various devices according to the invention and of comparative examples.
**FIG. 13** exemplarity shows photoluminescence excited state decay curves for thin films of a metal organic host, an organic emitter, and the mixed thin film of the two, respectively.

### Detailed Description

The following detailed description refers to the accompanying drawings that show, by way of illustration, specific details and aspects in which the invention may be practiced.

The word "exemplary" is used herein to mean "serving as an example, instance, or illustration". Any aspect or design described herein as "exemplary" is not necessarily to be construed as preferred or advantageous over other aspects or designs.

Various embodiments relate to electroluminescent devices comprising a mixture of a metal-organic host compound having at least one unpaired electron and an organic emitter compound and to methods on how to form said devices.

In this description, a metal-organic host, e.g. MOH, is taken to mean a compound with at least one metal bound to at least one organic ligand. The bond may be coordinative, without a direct metal carbon bond, or via a direct carbon-metal bond, or a combination thereof. The terms complex, (metal-organic) coordination compound, and metal organic host (molecule) will be used interchangeably. In this context, it is irrelevant, whether or not the metal organic host material is able to emit light or not.

Within this description, the terms HOMO and LUMO refer to the highest occupied molecular orbital and the lowest unoccupied molecular orbital, respectively. The terms are meant for one isolated molecule. Important for this description are the energies of the electrons residing in those frontier orbitals, corresponding to a single oxidation or reduction, respectively. In this description the term "HOMO" and "HOMO Energy" and "Energy of the electron in the HOMO" and "first oxidation Energy" are used interchangeably. The same applies for the LUMO Energy and its derived acronyms. Irrelevant in this description is the exact nature of the orbitals. In purely organic molecules they will often be molecular orbitals, for example an aromatic heteroaryl ring. In other embodiments, the HOMO and or the LUMO may substantially be located on a metal cation. For example, the oxidation of the metal organic host compound may primarily involve the oxidation of the central metal cation. In particular, the oxidation of Ce(lll) and Eu(ll) compounds may primarily result in corresponding positively charged compounds having a Ce(IV) and Eu(lll) cation, respectively, with the electronic configuration of the organic ligand being not substantially altered. As those energy levels are central to the design of state-of-the-art electroluminescent devices, there are in fact many methods on how to derive those values. HOMO and LUMO from isolated molecules in solution can be obtained using cyclic voltammetry (CV). More relevant are the energy levels in thin film which are affected by polarization effects of the surrounding environment. Here suitable experimental methods are derived from photo-electron spectroscopy such as ultraviolent photoemission spectroscopy (UPS) for the HOMO energy such as used for example in AC3 Riken Keiki instruments or X-ray Photoelectron Spectroscopy (XPS), which is suitable to measure LUMO energies. Further experimental techniques are very well known in the art, e.g. see R.J.Cox, Photographic Sensitivity, Academic Press, 1973, Chapter 15. Most elegant are quantum mechanical calculations using density function theory (DFT), where the film environment can be included by using a suitable dielectric constant. HOMO and LUMO in thin film relative to a known host material may as well be deducted from suitable hole or electron only devices where the material to probed is acting as charge trap or not. Preferred are HOMO and LUMO quantum mechanical calculations using density function theory (DFT), where the film environment can be included by using a suitable dielectric constant.

The term electronic transition means an energetic change of a molecule or exciplex that involves a change in quantum number of at least one electron. An example of a single electron transition often observed in aromatic or heteroaromatic organic molecules are π->π* or n->π* transitions. In this disclosure, the organic emitter compound preferably is configured as a pure organic material and the electronic transition responsible for the light emission is preferably originating from an heteroaromatic chemical group. Generally, the electronically excited states for such molecules correspond to one electron being removed from the HOMO of the molecule - called the hole - while an extra electron is residing on the LUMO. The lowest electronically excited state in most relevant cases is the one, where the hole and the excited electron have a parallel electron spin configuration, referred to as the triplet exciton. There are higher vibronically excited states, but of particular interest for this description is the lowest excited triplet state, T1 and its associated energy. The two spins being aligned antiparallel results in formation of a so-called singlet excitation, or exciton, S1. It is often the most emissive state of the organic emitter and as such - in particular its corresponding excitation energy - relevant for this description. Singlet and triplet molecular orbitals and energies are typically and preferably determined according to the present invention by quantum chemical calculations, using DFT methods. Experimentally, the energies can be determined by the corresponding onset or peaks of the phosphorescence or fluorescence emission spectra for the T1 and the S1 energies, respectively. Especially relevant for metal organic hosts, electronic transitions may as well be metal centred. Examples may be a spin flip in various Lanthanides, corresponding to an f-f transition. Other examples are metal centred f-d transitions occurring in particular Lanthanides.

In the OLED field of experts, the emission is usually classified as fluorescence if it originates from an optically allowed (spin-conserving) transition and decays within a few nanoseconds, such as the transition from the first excited singlet state to the singlet ground state of many purely organic molecules, or as phosphorescence if the emission originates from a spin-forbidden transition and decays with a few micro-milliseconds, such as from the first excited triplet state to the singlet ground state, often observed in heavy-metal containing metal organic complexes. The emission from the first electronically excited divalent Europium or first excited trivalent Cerium results from an optically allowed spin-conserving d-f transition, which, due to small overlap between the 5d and 4f orbitals, has a comparably long excited state lifetime of a tens to a few hundredths of nanoseconds (compared to typical fluorescence). Thus, it clearly is neither fluorescent, nor phosphorescent in the typical context used in the OLED field of experts. It should correctly be referred to as emission from an intrametallic transition.

Electronic transitions may as well happen between a metal and an organic molecule, in particular an organic ligand. For example, the metal may be an electron donor, getting reduced, while the organic ligand acts as acceptor getting reduced - a situation commonly referred to as metal-to-ligand charge transfer state. A charge transfer state may as well happen between two parts of a molecule, a situation often observed in so-called TADF organic emitter molecules. In its nature its an intramolecular charge transfer state between a donating and an accepting part of a molecule. A charge transfer state may as well be observed between two different molecules, for example between a metal organic compound and an organic molecule, which in this description will be referred to as exciplex.

In particular, an exciplex shall refer to a state between the metal organic host and the organic emitter that is only bonding - therefore only existing - if one of the two participating molecules of different kind is reduced while the other is oxidized. Its therefore an electronically excited state, created by transferring an electron from one molecule to another, for example from the metal organic host to the organic emitter. The bound state can therefore correctly be described as charge transfer state between a metal containing host and an organic guest. This exciplex may or may not be emissive. If its emissive, the energy of the exciplex typically corresponds to the emission energy. In preferred embodiments according to the invention, the exciplex does not emit but instead transfers its energy to the emissive singlet state of the organic emitter. The energy of the exciplex does mostly correspond to the energy difference between the lowest LUMO and the shallowest HOMO of the two participating molecules.

The metal organic host compound (MOH) should have a total electron spin of ≥ ½, in other words it should have at least one unpaired electron in its charge neutral molecular form. While any arrangement of unpaired electrons is within the scope of the invention, in particular embodiments the at least one unpaired electron may reside substantially on the organic ligand or parts thereof. This part of the organic ligand would thus be an organic radical, which is often associated with undesired absorption states. In preferred embodiments the one or more unpaired electrons are residing substantially on the one or more metal cation(s). Of particular interest are metal organic host materials where the metal orbitals carrying the unpaired electrons responsible for the spin are not involved in direct chemical bonds with the organic ligand, which would typically result in electron pairing and zero spin configurations. Such metal organic compounds are often formed by lanthanides and actinides, where the inner, partially filled f-orbitals are shielded by higher empty metal orbitals. The nature of the metal organic bond is mostly coordinative. As actinides are more or less radioactive, for application in consumer electronics, general preference is given to metal organic host compounds based on lanthanides. The metal organic host compound MOH typically is a powder, so charge neutral, in most cases a metal organic coordination compound. (of course in device it becomes (usually) positively charged).

In this invention, no electronic excited state shall have a lower energy as compared to the exciplex formed between the metal organic host and the organic emitter. Further preference is given to this exciplex being in the deep blue spectral region above 2.6 eV. Therefore, the lowest electron transition of the metal organic host material shall be higher than the exciplex energy and preferably higher than 2.6 eV. Even more preference is given to metal organic host compounds having their lowest lying electronic transition above the first excited singlet state of the organic emitter, which itself is above the exciplex energy. Preferred are metal organic host compounds based on Lanthanide cation having unpaired electrons and having their lowest lying electronic excitation at 2.6 eV or higher. For most lanthanide cations the lowest lying transition corresponds to an f-f transition with energies often well below 2.6 eV. Preferred are Lanthanide cations in which the lowest electronic transition is not within the f-shell but corresponds to an f-d transition. Therefore, preferred are metal organic host compounds based on Eu(II), Gd(III), and Ce(III). Those cations possess 7 and 1 unpaired electrons respectively,with total electronic spin of 7/2, 7/2, and 1/2, respectively. During complex formation the metal cationic spin is readily preserved. In various embodiments, the electronic d-f metal cantered transition is sufficiently high in the deep blue spectral region above 2.6eV. Yet, within this disclosure, it shall not matter whether the lowest transition is metal centred or not. In various embodiments, the lowest excitation of the metal organic host compound may be ligand centred or may correspond to a metal-to-ligand charge transfer state. For the ligand centred transition, the lowest excited state would typically refer to the first excited triplet state of the building block. Therefore, preferred are organic ligands or building blocks of the latter, in particular, heteroaryl groups, with a high first excited triplet state of 2.6 eV or higher.

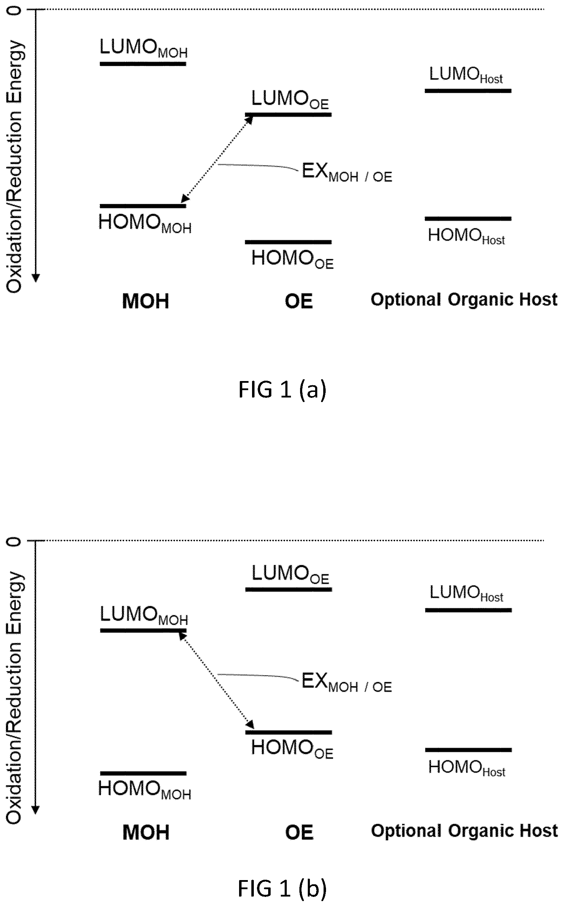

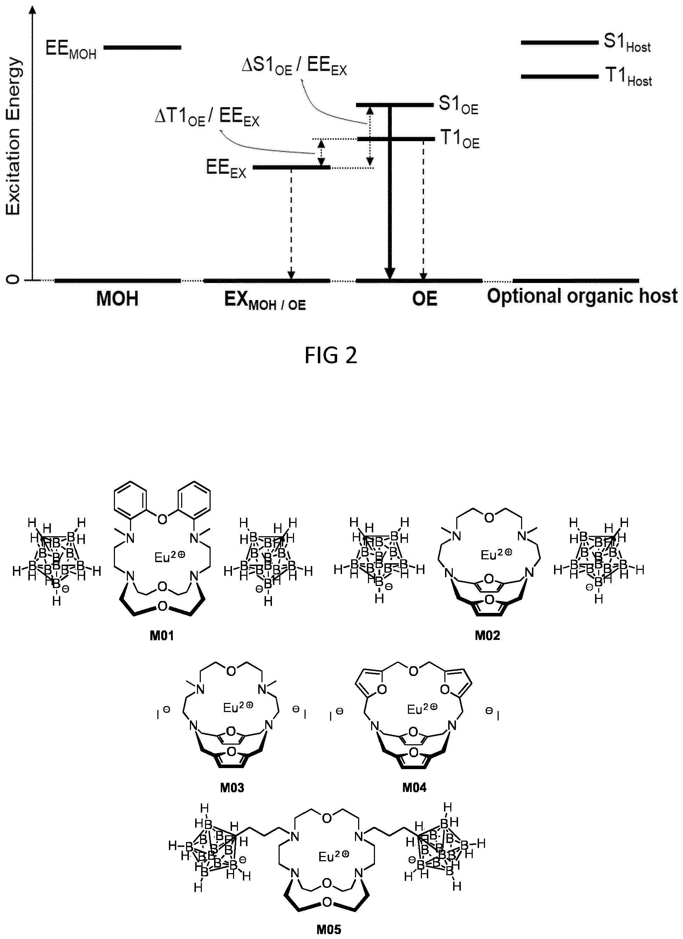

**Fig 1 (a)** and **(b)** and **Fig 2** further illustrate energy levels of the emission layer that are relevant for this disclosure. In particular, in Fig. 1 the HOMO and LUMO energy levels are shown, while the energies of the various electronically excited states are depicted in Fig. 2. Both figures illustrate the relative order of the various energies, the absolute values are not of relevance, the figures are only taken to guide and illustrate the present description.

According to the invention the emission layer contains the (at least one) metal organic host compound and the (at least one) organic emitter compound, which both do form an exciplex. One or more additional organic host materials may be present within the emission layer, but those optional hosts preferably do not participate in the exciplex formation. Figure 1 depicts fictive HOMO and LUMO values of an emission layer according to the invention of a metal organic host and an organic emitter and an additional host material. The upper dashed lines indicate the vacuum level of zero energy. In particular, Fig 1 (a) illustrates the situation, where the exciplex is formed by the positively charged metal organic host compound and the negatively charged organic emitter. Here, the energy of the HOMO of the metal organic host compound (HOHO_{MOH}) is the highest within the EML: within the three materials present in this example emission layer, the metal organic host compound is preferably oxidized. The lowest LUMO energy of all materials present within this emission layer is located on the organic emitter compound, LUM_{OE} and the organic emitter compound is preferably reduced. The exciplex according to the invention may form between the HOMO of the metal organic host compound and the LUMO of the organic emitter, EX_{MOE / OE} indicated by a dashed line. Fig. 1 (b) illustrates the alternative scenario with the LUMO of the metal organic host compound (LUMO_{MOH}) being the lowest LUMO within the emission layer and the HOMO of the organic emitter (HOMO_{OE}) being the highest HOMO, respectively. The exciplex according to the invention, indicated by a dashed line, may form between those oxidized HOMO and reduced LUMO orbitals, EX_{MOE / OE}.

An additional requirement for emission layers according to the invention is that the exciplex' first electronically excited energy, EE_{EX}, is the lowest possible electronic transition within the emission layer. While the HOMO / LUMO energy difference is a good approximation of the energy of an exciplex, this is not the case for localized organic emitters. Here, electron correlation energies lower the energy relative to the HOMO/LUMO difference substantially and the lowest electronically excited states are typically singlet and triplet states, depending on the spin configuration. Therefore, only considering the schemes depicted in Fig. 1 it is not evident that the exciplex should have the lowest excited state energy, possible is a lower excited state energy on either the local excitation on the metal organic host, the organic emitter or even the optional host materials. The correct energetics for the electronic transitions according to the invention are schematically illustrated in Fig. 2. Six relevant energy levels are depicted: The lowest local electronic excitation of the metal organic host, EE_{MOH}, the first excited singlet and triplet state energies of the organic emitter (S1_{OE}, and T1_{OE}), the first excited singlet and triplet state energies of an optional organic host (S1_{Host}, and T1_{Host}), and the energy of the exciplex formed according to the invention between the metal organic host and the organic emitter compound, EE_{MOH / OE}. In accordance with the invention the energy of the exciplex is the lowest energy within the emission layer. The emissive singlet excitation energy of the locally excited organic emitter (S1_{OE}) is higher than the energy of the exciplex: the corresponding energy difference ΔS1_{OE} / EE_{EX} should be smaller than 0.4 eV, preferably smaller than 0.3 eV and most preferably smaller than 0.2 eV to allow for efficient spin and thermally activated population of the local organic emitter S1 state from the exciplex energetic reservoir. In virtually all efficient organic emitter molecules, the first excited singlet state has a higher energy as compared to the first excited triplet state, with the latter typically being the lowest electronically excited state. According to the invention, the first excited triplet state energy of the organic emitter, T1_{OE}, should be resonant or above the energy of the exciplex, i.e. EE_{EX} ≤ T1_{OE}. In other words, the energy of the first excited triplet state of the organic emitter is sandwiched between the first excited singlet state of the organic emitter and the exciplex. It follows that the energy difference between the first excited triplet state of the locally excited organic emitter and the exciplex formed between the metal organic host and the organic emitter, ΔT1_{OE} / EE_{EX}, should be smaller than 0.4 eV, preferably smaller than 0.3 eV and most preferably smaller than 0.2 eV. In preferred embodiments, the exciplex predominantly energetically couples with the organic emitter, and less with the locally excited metal organic host. This is best achieved, when the excited state energy of the metal organic host, EE_{MOH}, is higher than the local singlet energy of the organic emitter, S1_{OE}, i.e. EE_{MOH} > S1_{OE}, a situation, which is schematically realized in Fig. 2 too. Similarly, any optionally present organic host material should not interfere with the energy transfer between the exciplex and the locally excited organic emitter; therefore, the lowest locally excited states of the optional organic host material, typically a T1 state, is preferably higher in energy as compared to the locally excited singlet state of the organic emitter. Preferably, the energy of the organic emitter, S1_{OE}, is deep blue, i.e. higher than 2.60 eV or more preferably higher 2.65 eV. Therefore, any optional organic host material present in the emission layer according to the invention preferably has a first excited triplet state energy ,T1_{Host}, of 2.60 eV or higher, or more preferably of 2.65 eV or higher.

In organic amorphous solids, such as predominantly found in electroluminescent devices, the individual organic molecule is typically imbedded or embedded within the layer in a rather unique way, depending on the exact nature and position of all neighbouring molecules. Similar, certain molecular degrees of freedom that do exist on a single molecule level, such as rotation degrees, may be frozen once the molecule becomes packed into an organic layer. Those typical features of amorphous organic layers contribute to inhomogeneous broadening of e.g. the conjugation length. Therefore, energy levels of organic layers, such as triplet energy or HOMO or LUMO energy are typically not sharp distinct single values, but instead fluctuate around a mean value depending on their position within the layer. In scientific literature, a Gaussian distribution is frequently taken as approximation of this energy distribution function, typically referred to as Density of States or DOS. Within this disclosure energy values are typical referred to as a fixed individual value and this is a good approximation, if the density of states is comparably narrow such that terms like "higher as" or "lower as" are meaningful because the two density distributions do not substantially overlap.

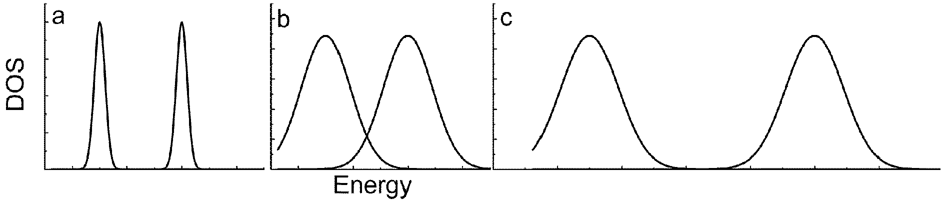

This simple situation is illustrated on the left of the drawing above as (a). Yet, the middle picture (b) illustrates the more realistic case, where two materials with significant wide DOS are compared. The centre of the DOS still has the same offset as in picture (a), i.e., the energy of one material is still "higher" as compared to the other one. However, this is clearly not the case for all pairwise material combinations within the organic layer. Generally preferred are energetic situation that hold true within most of the organic layer. For example, with respect to triplet energy, the energy of the excited state of the emitter may be below the centre of the DOS of the triplet energy of a certain surrounding host, as illustrated in the middle, (b) above. Yet, typically triplet levels are broadened by about 100 meV, therefore preferred is that the triplet energy of the organic emitter is even 0.05 eV and even more preferred 0.10 eV above the energy of the exciplex. This is illustrated by (c), where the same width as in (b) is used, but the energy difference is now sufficient, such that a clear energetic order between the two materials is established in nearly all cases.

As used herein, "deuterium" refers to an isotope of hydrogen. Deuterated compounds can be readily prepared using methods known in the art.

The terms "halo," "halogen," and "halide" are used interchangeably and refer to fluorine, chlorine, bromine, and iodine.

In this description, the arylene is a divalent organic fragment that is derived from an aromatic or heteroaromatic hydrocarbon (arene or heteroarene) by removing two hydrogen atoms from the aromatic or heteroaromatic hydrocarbon, preferably from different carbon and/or hetero atoms. One example is a (hetero) aromatic hydrocarbon that has had hydrogen atoms removed from two, preferably adjacent, hydrogen-bearing atoms (in case of aromatic hydrocarbon two carbon atoms, in case of heteroaromatic hydrocarbons two atoms selected from carbon and heteroatoms). An aromatic hydrocarbon or arene (or sometimes aryl hydrocarbon) is a cyclic hydrocarbon comprising only sp²-hybridized carbon atoms, leading to a delocalized π-system. An alkylene is a divalent organic fragment that is derived from an alkyl group by removing one additional substituent.

The term "alkyl" refers to and includes both straight and branched alkyl chain radicals and can furthermore also include cycloalkyl radicals. Preferred alkyl groups are those containing from one to fifteen, preferably one to ten, more preferably one to five carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group is optionally substituted, e.g., by halogen, preferably fluorine, or cycloalkyls.

The term "cycloalkyl radical" refers to and includes monocyclic, polycyclic, and spiro alkyl radicals. Preferred cycloalkyl groups are those containing 3 to 12, preferably 3 to 8 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group is optionally substituted, e.g., by halogen, deuterium, alkyl or heteroalkyl.

The terms "heteroalkyl" or "heterocycloalkyl" refer to an alkyl or a cycloalkyl radical, respectively, having at least one carbon atom replaced by a heteroatom. Preferably, the at least one heteroatom is selected from O, S, N, P, B, and Si, more preferably O, or N. Preferably, 1 to 5, more preferably, 1 to 3, most preferably, 1 or 2 heteroatoms are present in the radical. The radical can be covalently linked with the remainder of the molecule via a carbon or heteroatom (e.g., N). Additionally, the heteroalkyl or heterocycloalkyl group is optionally substituted as indicated for alkyl and cycloalkyl.

The term "alkenyl" refers to and includes both, straight and branched chain alkene radicals. Alkenyl groups are essentially alkyl groups with more than one carbon atom that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one, preferably 1 to 5, more preferably 1 to 3, most preferably 1 or 2 carbon atoms replaced by a heteroatom. Preferably, the at least one heteroatom is selected from O, S, N, P, B, and Si, more preferably O, S, or N. Preferred alkenyl/cycloalkenyl/heteroalkenyl groups are those containing two/three/one to fifteen carbon atoms. Additionally, the alkenyl, cycloalkenyl, or heteroalkenyl group is optionally substituted, as indicated above.

The terms "aralkyl" or "arylalkyl" are used interchangeably and refer to an alkyl group that is substituted with an aryl group. Additionally, the aralkyl group is optionally substituted, as indicated for alkyl and aryl.

The term "heterocyclic group" refers to and includes aromatic and non-aromatic cyclic radicals containing at least one, preferably 1 to 5, more preferably 1 to 3 heteroatoms. Preferably at least one heteroatom is selected from O, S, N, P, B, and Si, more preferably O, S, or N. Hetero-aromatic cyclic radicals may be used interchangeably with heteroaryl. Preferred hetero-non-aromatic cyclic groups are those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted, e.g., by halogen, deuterium, alkyl or aryl. The heterocyclic group can be covalently linked with the remainder of the molecule via carbon and/or heteroatoms, preferably one carbon or nitrogen atom. The heterocyclic group can as well be linked to the remainder of the molecules with two carbon and/or heteroatoms.

The term "aryl" refers to and includes both, single-ring aromatic hydrocarbon groups and polycyclic aromatic ring systems. The polycyclic rings may have two or more rings in which two carbons are common to two adjoining rings (the rings are "fused"), or wherein one carbon is common to two adjoining rings (e.g., biphenyl), wherein at least one of the rings is an aromatic hydrocarbon group, e.g., the other rings can be cycloalkyls, cycloalkenyls, aryl, heterocycles, and/or heteroaryls. Preferred aryl groups are those containing three to eight aromatic carbon atoms. Especially preferred is an aryl group having six carbons. Suitable aryl groups include phenyl and radialene. Most preferred is phenyl that can be substituted by non-aromatic groups, such as N. Additionally, the aryl group is optionally substituted, e.g., by halogen, alkyl, heteroalkyl, or deuterium.

The term "heteroaryl" refers to and includes both, single-ring aromatic groups and polycyclic aromatic ring systems that include at least one heteroatom. Heteroaryl groups form a subgroup of heterocyclic groups. The heteroatoms include, but are not limited to, and are preferably selected from, O, S, N, P, B, and Si. In many instances, O, S, or N are the preferred heteroatoms. Heteroaromatic ring systems with a single heteroatom are preferably single rings with five or six ring atoms, and the ring can have from one to five or six, preferably one to three heteroatoms. The hetero-polycyclic ring systems can have two or more rings in which two atoms are common to two adjoining rings (the rings are "fused"), or wherein one carbon is common to two adjoining rings (e.g., bipyridine), wherein at least one of the rings is a heteroaryl, e.g., the other rings can be cycloalkyls, cycloalkenyls. The hetero-polycyclic aromatic ring systems can have from 1 to 5, preferably 1 to 3 heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyrrole, pyrazole, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably 1,3,4-Oxadiazole, furan, thiophene, 1,2,4-triazole, 1,2,3-triazole, and pyrazole groups, from which one hydrogen atom has been removed from a hydrogen-bearing carbon or heteroatom to form the covalent link to the remainder of the molecule. The heteroaryl group with two hydrogens removed can as well be linked with two carbon and/or heteroatoms with the remainder of the molecules, in which case the heteroaryl group can be part of a larger cyclic group. Additionally, the heteroaryl group is optionally substituted, e.g., by halogen, deuterium, alkyl or aryl.

In various embodiments of the metal organic host, heterocyclic or heteroaryl groups with triplet level >2.6 eV or more preferably >2.65 eV, such as the groups derived from furan, dibenzofuran, benzothiophene, dibenzothiophene, dibenzoselenophene, carbazole, imidazole, pyridine, pyrazine, pyrimidine, triazine, and the respective aza- and/or thio-analogs of each thereof are of particular interest. There are many possible ways to probe the triplet energy level of an organic molecule. A simple way is to use suitable quantum mechanical calculations. A more experimental way takes the onset of the phosphorescence spectrum, which is usually detected using gated spectroscopy, as pioneered by Romanovskii et al. (Physical Review Letters 84.5 (2000): 1027). In combination with high triplet energy, generally preference is given to benzene or weakly polarizable, chemically hard heteroaryl groups, such as 1,3,4-Oxadiazole, furan, thiophene, 1,2,4-triazole, 1,2,3-triazole, and pyrazole, carbazole, dibenzofuran, dibenzothiophene, benzothiophene, and benzofuran groups.

The alkyl, cycloalkyl, heteroalkyl, heterocycloalkyl, alkenyl, cycloalkenyl, heteroalkenyl, alkynyl, aralkyl, heterocyclic group, aryl, and heteroaryl groups or residues, as used herein, are independently unsubstituted, or independently substituted, with one or more (general) substituents, preferably the substituents mentioned below.

Preferably, the (general) substituents are selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof with the number of carbon atoms and heteroatoms as defined above for the respective term.

In some instances, the preferred general substituents are selected from the group consisting of deuterium, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term.

In yet other instances, the more preferred general substituents are selected from the group consisting of deuterium, alkyl, cycloalkyl, aryl, heteroaryl, and combinations thereof with the number of carbon atoms and heteroatoms as defined above for the respective term.

The terms "substituted" and "substitution" refer to a substituent other than H that is bonded to the relevant position, e.g., a carbon or nitrogen. For example, when R represents monosubstitution, then one R should be other than H (i.e., a substitution). Similarly, when R represents di-substitution, then two of R should be other than H. Similarly, when R represents no substitution, R, for example, can be a hydrogen for available valencies of straight or branched chain or ring atoms, as in carbon atoms for benzene and the nitrogen atom in pyrrole, or simply represents nothing for ring atoms with fully filled valencies, e.g., the nitrogen atom in pyridine. The maximum number of substitutions possible in a straight or branched chain or ring structure will depend on the total number of available valencies in the ring atoms or number of hydrogen atoms that can be replaced. All residues and substituents are selected in a way that a chemically stable and accessible chemical group results.

It is to be understood that when a molecular fragment is described as being a substituent or otherwise attached to another moiety, its name may be written as if it were a fragment (e.g., phenyl, phenylene, naphthyl, dibenzofuryl) or as if it were the whole molecule (e.g., benzene, naphthalene, dibenzofuran). As used herein, these different ways of designating a substituent or attached fragment are considered to be equivalent.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include thirty to forty atoms that are not hydrogen or deuterium, or those that include up to 30 atoms that are not hydrogen or deuterium counted for all substituents of a given molecule, or for the respective molecule in total. In various embodiments, a combination of substituent groups will include up to twenty atoms that are not hydrogen or deuterium, counted for all substituents of a given molecule. A selection of suitable substituents are given in WO2021/244801A1, WO2022/218562A1 and WO2023/194363A1 which are included in this disclosure as a whole.

In some instances, a pair of substituents can be optionally joined (i.e., covalently linked with each other) or fused into a ring. In various embodiments the preferred ring formed by adjacent substituents is a five-, six-, or seven-membered carbocyclic or heterocyclic ring, including both instances where the portion of the ring formed by the pair of substituents is saturated and where the portion of the ring formed by the pair of substituents is unsaturated. As used herein, "adjacent" or "neighboring" means that the two substituents involved can be next to each other, or next to each other but separated by one heteroatom having the two closest available substitutable positions, such as 2, 2' positions in a biphenyl, or 1, 8 position in a naphthalene, or 2,3-positions in a phenyl, or 1,2-positions in a piperidine, as long as they can form a stable fused ring system. In some instances, a pair of non-adjacent substituents can be optionally joined usually by an, at least partial, alkane or heteroalkene chain of atoms, thereby forming another macrocyclic ring system as part of the coordinating macrocyclic ring present as part of the coordination compound. In some instances, a pair of substituents present on the same carbon atom can be optionally joined, i.e., into an aryl or heteroaryl group, thus, forming a spiro linkage at the given carbon atom.

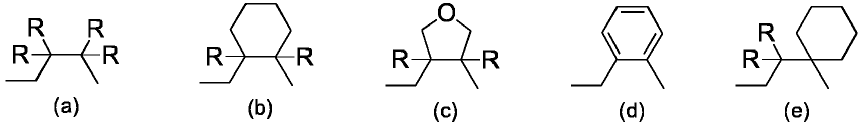

Drawings (a) - (e) illustrate examples of two or more residues, R, being situated on neighbouring carbon atoms (a), that fuse into cyclohexane (b), furane (c), benzene (d), and cyclohexane with spiro linkage (e). In other embodiments of this disclosure, substituents separated by more than two carbon atoms or heteroatoms may link with each other thereby preferably forming a at least partially aliphatic or heteroaliphatic cyclic ring, which will typically be a macrocyclic ring. An important example are two residues, R, on a macrocyclic ring (f) that covalently link to yield a cryptand-like organic molecule (g):

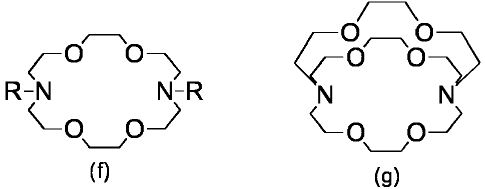

In this description, the term organyl refers to any chemically stable organic arrangement of atoms where one or more hydrogen atom has been removed such as to use those free vacancies to covalently link the organic group with another molecular entity. Thus, the term organyl encompasses the majority of the above defined organic groups e.g., fluorine, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term.

Organic groups or organic side groups are derived or formed by removing one or more hydrogen atoms from organic molecules containing at least a corresponding number of hydrogen atoms. For example, benzene results in phenyl or phenylene groups by removing one or two hydrogen atoms, resulting in a monovalent or divalent organic group.

In this description, a metal organic host compound is any material that contains at least one metal cation and at least one organic ligand and that can be processed such that within an organic emission layer an intimate contact with the organic emitter compound is realized. In various embodiments, the metal organic host compound and the organic emitter are simultaneously processed from gas phase such as sublimation using a co sublimation process, thereby forming a mixed layer. In various other embodiments, the metal organic host material and the organic emitter compound are processed sequential, for example by sublimation, thereby forming two individual layers. At the interface between the two layers the metal organic host and the organic emitter are in intimate contact, thereby forming the emission layer comprising the exciplex between the metal organic host and the organic emitter. Irrelevant in this context is whether the particular metal organic host material is able to emit light upon electrical and/or optical excitation or not. In order to take part in the exciplex formation according to the invention, the metal organic host material should be redox active, such that it can be oxidized and/or reduced reversibly. In some embodiments, the metal organic host material can only be oxidized from its neutral form reversibly, but the neutral form cannot be reduced without decomposition. In other embodiments, reversible reduction is possible, yet oxidation leads to irreversible decomposition. Irrelevant with this disclosure shall be whether the metal organic host compound is able to transport either one or both types of charges or not. Mandatory for this invention, the recombination of the electrons and holes within the emission layer should not take place directly on the metal organic host compound. Instead, the metal organic host compound is never electronically excited, but does form an exciplex together with the organic emitter compound.

In this description, the term "substantially" may refer to (relative) amounts of a compound and typically means at least 80 %, preferably at least 90 %, more preferably at least 95 %, specifically 100 %, not considering impurities or additives. It may define ranges of 80 to 100 % etc. for the content or purity of a compound. This definition refers for example to amounts like weight or volume or other parameters like wavelength. For single values, "substantially" allows for a variation or deviation from a given number by 20% or less, preferably 10% or less, more preferably 5% or less, specifically 1% or less. An emission substantially in the deep blue spectral region below 500 nm means that at least 80% of the emission events are below 500 nm etc. A substantially organic substrate contains at least 80% of organic substances. When not indicated otherwise, % means wt%.

The metal-organic host compound within the electroluminescence device according to the invention is required to either have a total spin of ≥1/2 and or possesses one or more unpaired electrons. While the unpaired electrons may be substantially located on organic parts of the metal organic host compound, i.e. as radical species, preferably the unpaired electrons are located predominantly at the metal cation. Suitable metal cations are found particularly within the Lanthanides and preferably within those Lanthanides, where the lowest electronically excited state is in the deep blue or higher (UV) spectral region. Of particular interest are metal organic host compounds comprising the Lanthanide cations Gd(III), Ce(III), and Eu(II).

Independent of the particular choice of metal, the organic ligand of the metal organic host may in general be aliphatic, or aromatic or mixture of the two. There may be one ligand or a plurality. To achieve charge neutrality, the metal organic host compound will comprise negatively charged ligands and/or anions. In various embodiments, there is one divalent cation present, and it is charge balanced by a twofold negatively charged anion or ligand. In various other embodiments, two, preferably identical, negatively charged anions or ligands are present. In various embodiments, there is one trivalent cation present, which is charge balanced by a trifold negatively charged anion or ligand. Yet in other embodiments, three, preferably identical, negatively charged anions or ligands are present. This invention as well encompasses metal organic host compounds that, in addition to the preferably spin active cation, such as Gd(III), contain cationic covalent or non-covalently bound organic or inorganic species such as amino groups or lithium cations that are individually not spin active. In such cases, additional negatively charged ligands or anions are present to achieve charge neutrality. For example, fourfold negatively charged ligands or anions may be present in a cerium compound. Or three or more negatively charged ligands or anions are present as part of a divalent Europium metal organic host compound. This invention as well encompasses dinuclear metal organic host compounds having more than one, preferably two, spin active metal cations present as part of the metal organic host compound, as long as the total electronic spin of the compound is ½ or higher.

In various embodiments, the metal organic host compound may include at least one negatively charged anion that is not covalently bound to any optionally present organic ligand. Without limiting the scope of the invention, examples of such anionic covalent attached substitutions may be any singly or multiple negatively charged organic or inorganic species that are sufficiently chemically stable. Generally, preference is given to anions that do not absorb visible light with a wavelength in the range of 380-700 nm, more preferably in the range of 430-500 nm. Further preference is given to lightweight anions with a molecular weight of less than 1000 g/mol, preferably less than 500 g/mol. The negatively charged anion may include more than one atom, preferably more than three atoms. Such larger anions are generally bulkier and, as such, are better suited for applications where drift of anions is not desired. Furthermore, the anion may have a molecular weight of at least 128 g/mol. Suitable anions are disclosed in WO 2021/244801. In case there are two or more non-covalently bound anions present, they may be the same or of different type, preferably the same.

For metal organic host compounds with non-covalently bound anions designed for divalent Europium, preference is given to anions that do not strongly interact with the central Eu cation. As such, preference is given to anions that do not tend to form strong chemical bonds with the central cation, but where the interaction is mainly of electrostatic nature. Accordingly, bulky anions in which the negative charge is distributed over many atoms are preferred. Further preferred are light weight anions with individually less than 1000 g/mol and more preferably less than 500 g/mol. Very well suited in this context, and therefore preferred, are substituted or non-substituted closo-carborates being present as part of the metal organic host compound used in the electroluminescence device according to the invention, according to the generic formulae a1 and a2:

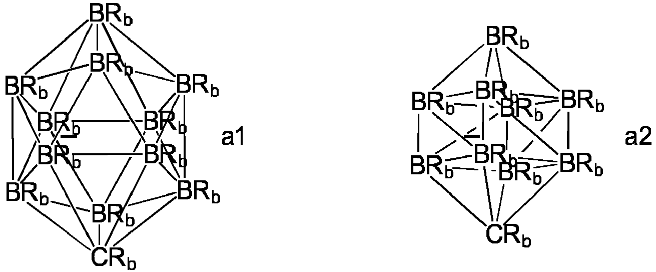

Here, R_{b} independently in each occurrence represents H, D, halogen - preferably chlorine, or any monovalent organic group formed by removing a hydrogen atom from an organic molecule having at least one hydrogen.

Besides the negatively charged anions, charge-neutral organic fragments, ligands, or molecules may be part of the coordination compound according to the invention. A typical example of a charge neutral ligand are one or more instances of tetrahydrofuran, which are often present after chemical synthesis prior to sublimation treatment.

While the metal organic host compound may comprise of a plurality of electrically charged or neutral organic ligands, particularly stable, and thus preferred, metal organic host compounds are constructed using a suitable lanthanide coordinated by a cyclic, in particular macro or polymacrocyclic organic ligand. The term macrocyclic shall refer to a monocyclic group or to cyclic organic molecules wherein the monocyclic chain comprises at least 12 atoms selected from Si, C, Se, B, N, P, O, and S whereby at least some of the bonds between those 12 atoms are aliphatic. Preferably, the metal organic host is designed such that the mono-macrocyclic group surrounds the central metal cation, preferably chosen from a lanthanide having unpaired electrons, in particular chosen from Eu(II), Ce(III), and Gd(III). Within this description, those - at least 12 - atoms will be referred to as the "macrocyclic atoms". They alone do not constitute the whole organic ligand, which typically comprises many more atoms, such as hydrogens or side groups substituting a certain hydrogen atom. 18-crown-6 is an example of an organic ligand with 6 macrocyclic heteroatoms, namely oxygens, and 12 macrocyclic carbon atoms, with overall 18 macrocyclic atoms. Yet, this particular organic ligand contains additional 24 hydrogen atoms and thus 42 atoms overall. The term polymacrocyclic refers to cyclic organic molecules comprising more than one macrocyclic ring according to the definition above. Kryptofix 2.2.2 is an example of a polymacrocyclic molecule that may be utilized with or without further substitutions as organic ligand to coordinate a suitable metal cation, such as Gd(III), Ce(III), or Eu(II).

The "aza" designation in the fragments described herein, i.e., aza-cryptate, etc., means that one or more carbon atom or (other) heteroatom of a parent compound is replaced by a nitrogen atom, without any limitation. For example, in a crown ether, -O- is replaced by - NH- to give the respective aza-crown ether. One of ordinary skill in the art can readily envision other nitrogen analogs of the aza-derivatives, and all such analogues are intended to be encompassed by the terms as set forth herein.

While there may be more than one macrocyclic ligand present within the metal organic host compound, in preferred embodiments one macrocyclic organic ligand coordinates one spin active metal cation in a molar ratio of 1:1. The macrocyclic organic ligand excluding the metal cation may be charge neutral and the positive charges of the spin active cation are charge compensated in the final metal organic host compound by suitable anions, alternatively the macrocyclic organic ligand excluding the metal is twofold or more-fold negatively charged and forms a complex of zero electrically charge once combined with the spin-active metal cation, with oxidation stage 2 or higher, respectively.

To achieve high stability, preference is generally given to metal organic host compounds comprising a macro- or polymacrocyclic organic ligand. The latter ligand may itself be charge neutral and one or more non-covalently bound anions, as described above, can be present as part of the metal organic host compound according to the invention.

Alternatively, the macro- or polymacrocyclic organic ligand that coordinates to a spin active lanthanide cation being part of the metal organic host compound being used in the electroluminescent device according to the invention may itself already be singly or multiply negatively charged. In various embodiments, suitable anionic groups are covalently attached to the organic ligand. Without limiting the scope of the invention, examples of such anionic covalent attached substitutions may be any singly or doubly or triple negatively charged organyl groups that are sufficiently chemically stable. Generally, preference is given to anionic groups that do not absorb light with a wavelength in the range of 380-700 nm, more preferably in the range of 430-500 nm. Further preference is given to lightweight anionic groups with molecular weight of less than 1000 g/mol, preferably less than 500 g/mol.

In preferred embodiments of the metal organic host compounds being present in the device of the invention, the sum of the negative charges of the covalently attached anionic groups matches the charge of the central spin active cation, such that the resulting metal-organic coordination compound is charge-neutral. In such a configuration, no unbound negatively charged anions are present, which elegantly avoids anion drift in device configuration under applied electric fields. Therefore, preferred are negatively charged ligands containing exactly two singly charged anionic groups or exactly one twofold negatively charged anionic group in case a single divalent spin-active metal cation such as Eu(ll) is used. In case a single trivalent spin-active metal cation such as Gd(III) or Ce(lll) is used, preferred are negatively charge organic ligands containing exactly three singly charge anionic groups or one threefold negatively charge anionic groups or one twofold combined with a singly negatively charged group. Independently of the identity of the metal cation, preferred are metal organic host compounds with identical and singly negatively charge.

Preference is given to anions that do not absorb light with a wavelength in the range of 380-700 nm, more preferably in the range of 430-500 nm. A wide range of inorganic or organic anionic side groups is within the scope of this invention. In various embodiments, anionic groups covalently linked to the organic ligand may be twofold or even higher charged, for example by attaching sulphate, phosphate, or chromate anionic groups. Similarly, an organic ligand may carry more negative charges as compared to the central spin-active metal cation. In such a case, a charge neutral compound may be obtained by incorporation of additional suitable organic or inorganic cations, such as ammonium, alkali, alkaline earth metal cations or similar into the metal organic host compound being part of the device according to the invention.

Instead of covalently attaching anionic groups, an organic ligand, for example a macrocyclic ligand, may as well comprise negatively charged heteroatoms, such as borates or negatively charged aryl groups, such as pyrrolate as part of the scaffold of the organic ligand. For example, this can be achieved by deprotonation of the aromatic pyrrole or triazole building blocks. The optional negative charge present in the ligand may as well be substantially localized on a particular heteroatom that is part of the scaffold of the organic ligand used in the invention. For example, a negatively charged borate may be used as one or two of the macrocyclic atoms being part of a macrocyclic organic ligand, illustrating a singly or twofold negatively charged macrocyclic ligand. Without limiting this scope, further possible covalently-linked anionic side groups are disclosed in WO2021/244801 and WO 2022/218562 and EP2023/058811, which are included as a whole. Particularly with respect to divalent Europium, preferred are covalently attached closo-carborate type cluster fragments according to the generic formulae a3 to a6:

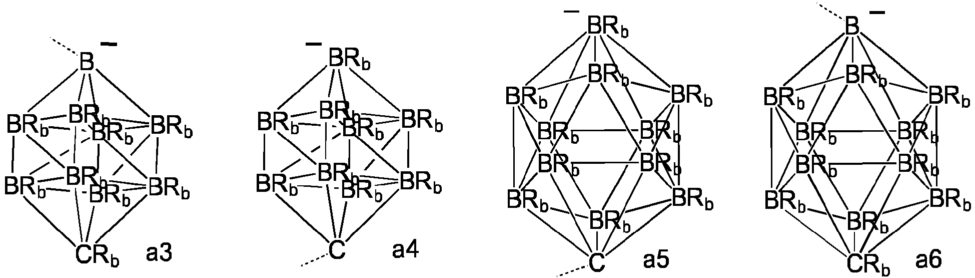

Here, R_{b} has the same meaning as above and the dashed lines indicate the most preferred covalent linkage of the closo-carborate fragment to the remainder of an organic ligand present in the metal organic host compound, for example a macro- or polymacrocyclic organic ligand. While the covalent attachment may proceed via any position R_{b} depicted in a1 and a2, synthetic attachment is most feasible at the carbon (1) position, as indicated in a4 and a5 and/or in the vertex positions (10 and 12) a3 and a6 respectively. Within those two options, general preference is given to the latter way of attachment.

To qualify as a macrocyclic organic ligand according to the generally accepted definition, preferably at least 9 macrocyclic atoms should be part of a single cyclic ring, the macrocycle. Clearly, the overall number of atoms being part of the macrocyclic organic ligand will be higher; note that only those carbon or heteroatoms are counted as macrocyclic atoms that do form the cyclic closed ring system around the central cation, i.e., the "macrocycle" according to the invention. For example, the classical dibenzo-18-crown-6 contains 18 macrocyclic atoms (12 carbon and 6 oxygen atoms, respectively, in the macrocycle), while overall 50 atoms are present. Preferred are organic macrocyclic ligands with 12 to 48 macrocyclic atoms as part of the cyclic ring, the macrocycle. Yet, for good coordination of the central cation, the cavity formed by the macrocyclic ring should neither be too small nor too large. This ideal cavity, however, depends on the cation used. For example, threevalent lanthanides require smaller macrocyclic rings as compared to divalent ones. For the latter the preferred ring number of macrocyclic ring atoms is 18-20.

The macrocyclic organic ligand may comprise any element with at least two valencies that is able to form chemically stable cyclic rings. Indeed, an overwhelmingly large number of macrocyclic rings is described in the literature, such as in WO2021/244801, for example, crown ethers, calixarenes, porphyrins, and cyclodextrins, which may be part of the coordination compound used in the device according to the invention. According to one embodiment, the macrocycle may only comprise non-coordinating atoms, such as Si, or C. However, preference is given to macrocycles with a plurality of heteroatoms being present that are able to coordinate central spin active cation. In such a situation, two macrocyclic heteroatoms may be direct neighbors within the macrocyclic organic ligand, and this may give very chemically robust macrocycles; preference is given to macrocycles with the coordinating heteroatoms being separated by at least one carbon atom, and more preference is given to arrangements, where each two macrocyclic coordinating heteroatoms are separated from each other by two, or three, or four carbon atoms.

The preferred macrocyclic organic ligand may be described by formula (1-1): 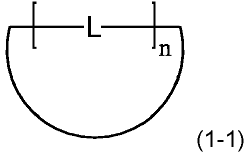 with n being 4 to 8, preferably 4 to 6; and L being independently in each occurrence a divalent organic group formed by removing two hydrogen atoms from an organic molecule containing at least two hydrogen atoms with the shortest sequence of atoms linking each L with the remainder of the macrocycle in the macrocyclic ligand being 3 to 5, preferably 3 atoms, and with one of those 3 to 5, preferably 3 atoms independently for each L being selected from the heteroatoms N, P, S, Se, or O, preferably N, or O, the other atoms of those atoms being carbon, wherein preferably the heteroatoms in the macrocycle are non-neighboring. Formula (1-1) describes macrocyclic organic ligands with a minimum of 12 and a maximum of 40 macrocyclic atoms in the one ring forming the macrocycle. In each instance of L, there is at least one heteroatom present. Thus, there are 4 to 8 heteroatoms preferably selected from N, P, O, S, or Se present that may coordinate to the central cation, which is preferably selected from Gd(III), Ce(III), and Eu(II). The linker L represents any (divalent) organyl group, such as, but not limited to, a linear (divalent) heteroalkane, a (divalent) heteroaryl, or any other (divalent) heterocyclic group. All those groups may be further substituted, for example, instead of a simple linear (divalent) heteroalkene, a branched (divalent) heteroalkene chain may be present. For (divalent) cyclic organyl groups, always the shortest sequence of atoms linking the (divalent) organyl group to the remainder of the ligand according to formula (1-1) shall constitute the macrocyclic atoms, i.e., should be 3 to 5 preferably 3 atoms. For example, if L represents a (divalent) furanyl group covalently connected to the remainder of the molecule in the 2,5 positions, then the shortest sequence of atoms is 3 and one oxygen is present. Similarly, if L represents a (divalent) pyrazinyl group covalently connected to the remainder of the molecule in the 2,6 positions, then the shortest sequence of atoms is 3 and one nitrogen is present. There is also a longer sequence of 5 atoms, which also has one nitrogen present, which, however, is not the shortest sequence of atoms according to the definition. Finally, an (divalent) aniline group connected via the 2,6 positions is considered. Again, the shortest sequence of atoms is 3, yet none of those 3 atoms is a heteroatom such as N, S, or O. The nitrogen present in aniline is not part of the shortest sequence of atoms in this situation, and as such this group does not fulfil the requirements of (1-1) and thus is not falling under the generic formula (1-1).

Within this invention, the metal organic host compound is not electronically excited during the operation of the electroluminescence device according to the invention. Instead, the light emission proceeds via the organic emitter molecule and is preferably in the deep blue spectral region of >2.6, preferably >2.65 eV. Spin active metal cations selected from Gd(III), Ce(III), and Eull) ensure that the central metal is not electronically excited. But as well ligand electronic transitions should preferably be avoided. With this in mind, the ligand is preferably configured such that its first excited triplet energy exceeds the singlet state of the organic emitter, i.e. it is preferably higher than 2.65eV. The organic ligand itself and its individual side groups may be chosen to have a sufficiently high triplet energy.

Without limiting the general scope of the invention, concrete examples of metal organic host compounds that may be used in electroluminescent devices according to the invention can for example be obtained by combining pairwise a specific charge neutral organic macrocycle or polymacrocyclic ligand - for example disclosed in WO2021/244801, WO 2022/218562, and WO2023194363A1 or WO2023/058811 - with two or more different or, preferably, identical anions such as disclosed in the above related arts. Two anions should preferably be used if a divalent cation is the spin active metal, while three anions are used for a trivalent cation being the spin active metal in the metal organic host compound. Similarly, a twofold or threefold negatively charged macrocycle or polymacrocyclic ligand may be selected to coordinate to a divalent or trivalent spin active cation and no additional non-covalently bound anions are part of the complex. Suitable multiple, negatively charged polymacrocyclic ligands may be found in the related arts WO2021/244801, WO 2022/218562, and WO2023194363A1. Clearly, metal organic host compounds without any macro- or polymacrocyclic ligand are within the scope of the invention too. Suitable compounds may be formed by choosing a suitable number of preferably identical, negatively charged non-cyclic ligands or anions, such as to form a complex of neutral electrical charge after insertion of the metal cation. In any case additional non-cyclic ligands may be part of the metal organic host too. As explained above, the invention as well encompasses using anions with higher than singe negative charge as well as organic ligands that are singly or higher than twofold or higher than trifold negatively charged.

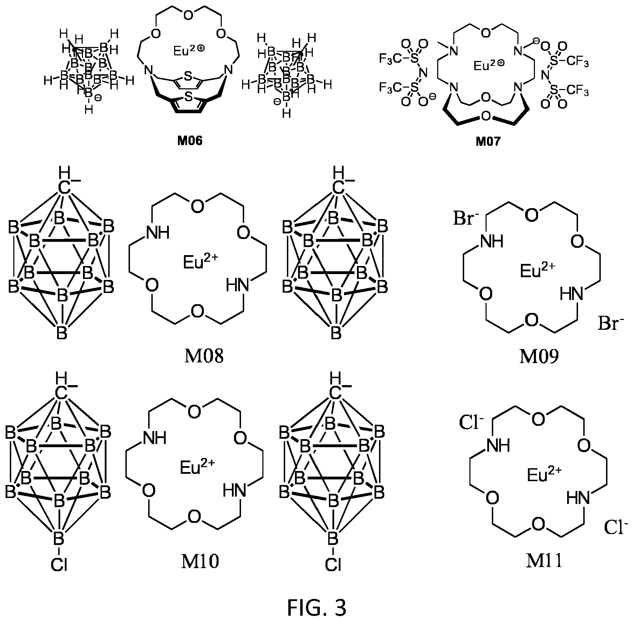

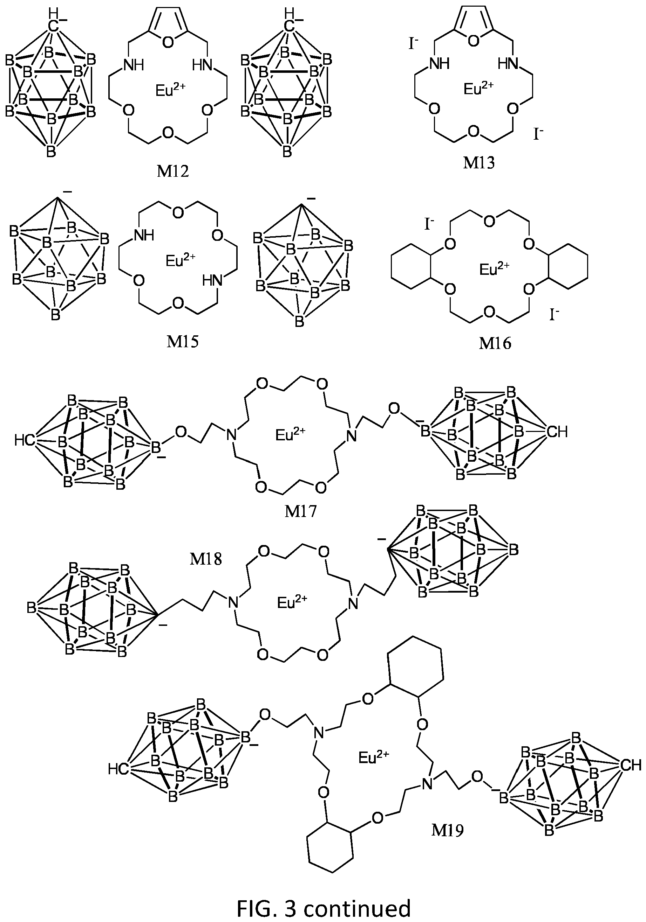

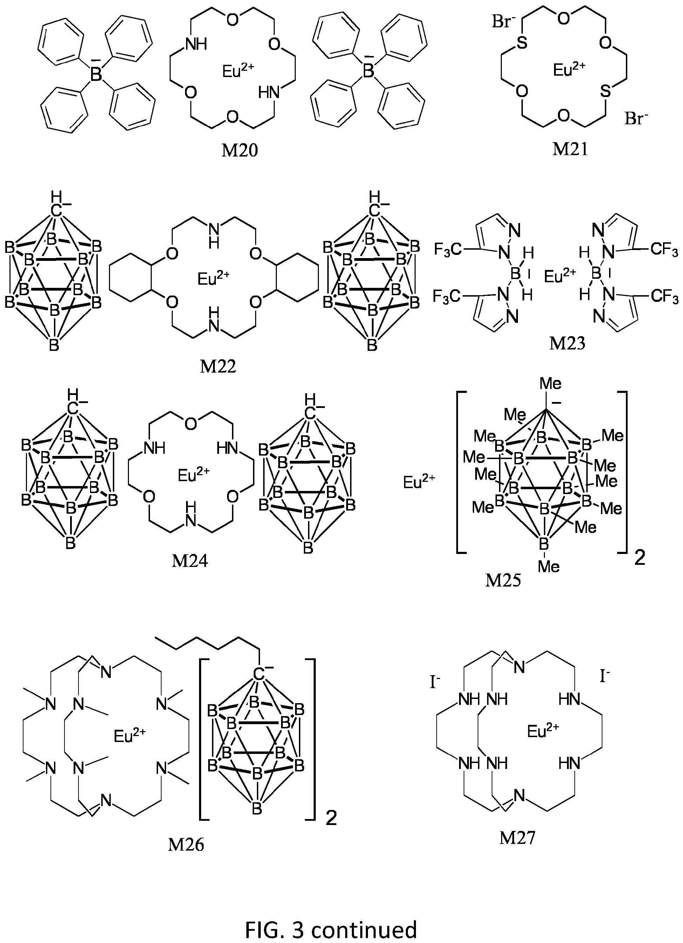

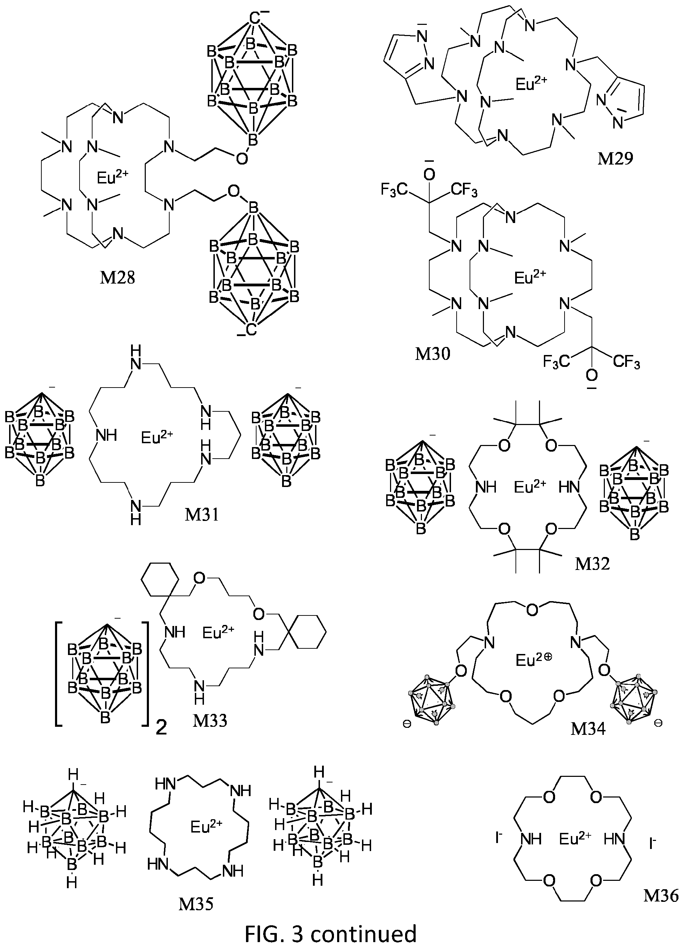

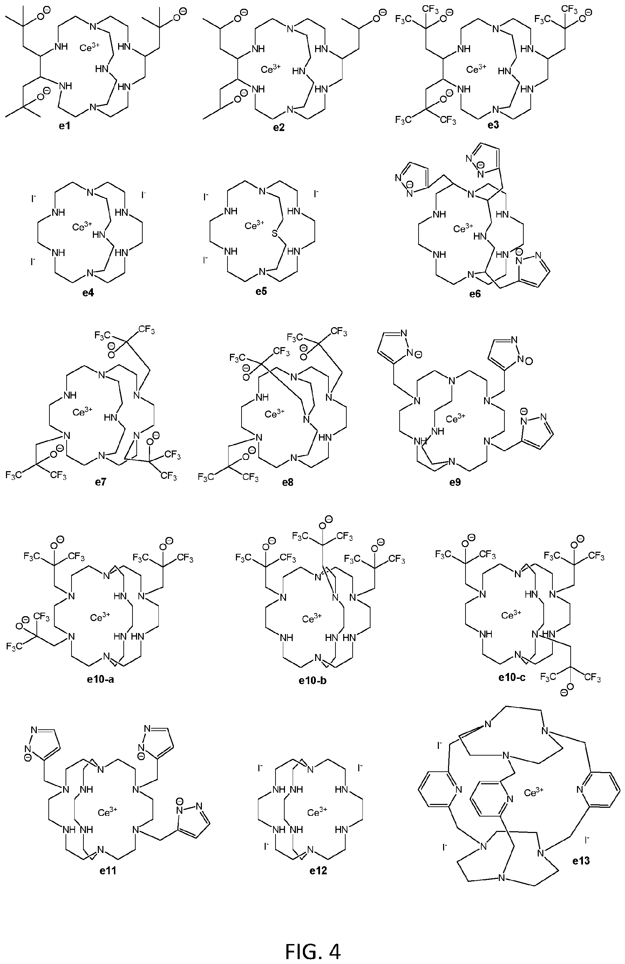

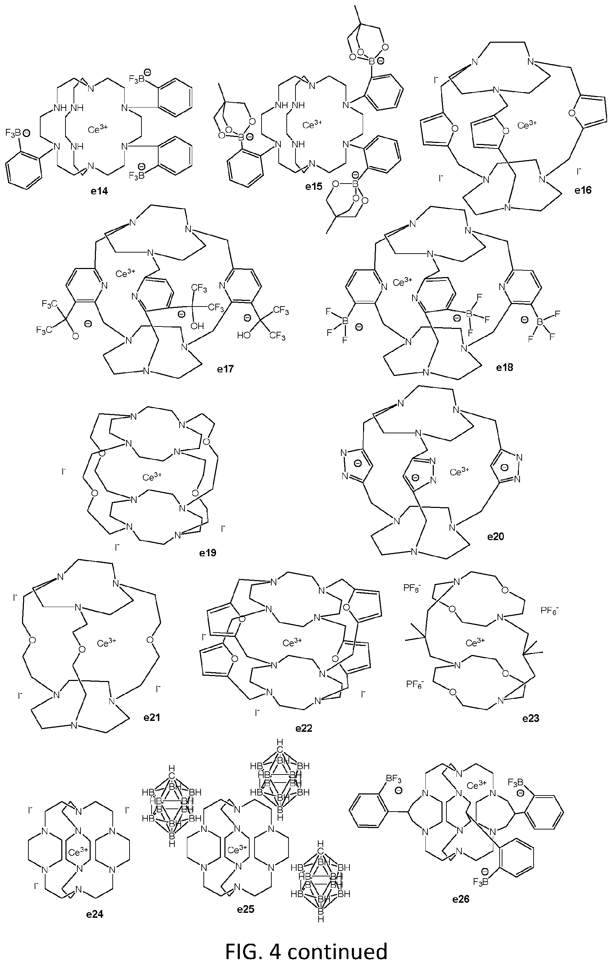

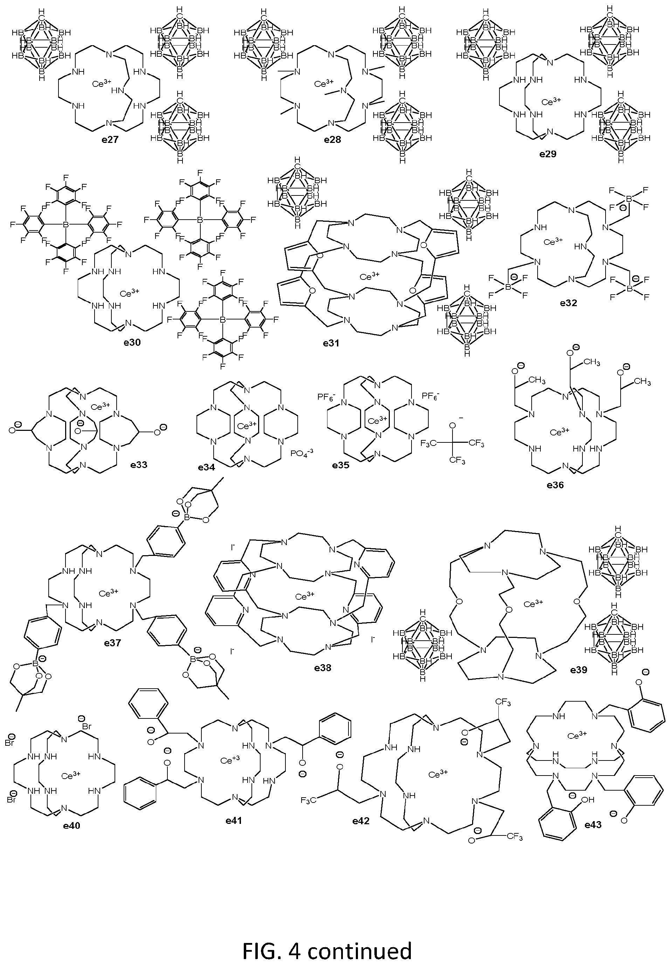

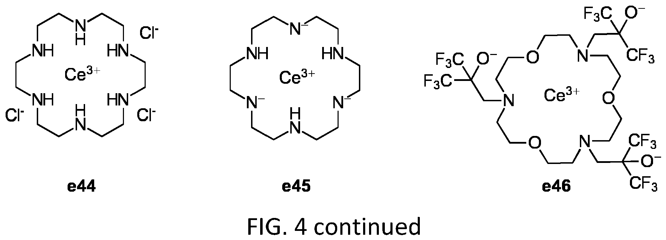

To serve as example, a limited set of charge neutral metal organic host compounds comprising divalent Europium and trivalent Cerium that may be present in the electroluminescent invention are shown as M01 to M35 in Fig. 3, and e1 to e46 in Fig.4. Obvious to those skilled in the art, many more compounds can be generated.

Most examples depicted in Fig. 3 and 4 comprise a macro- or polymacrocyclic ligand. Other organic ligands, charged or electrically neutral, are within the scope as well, such as borate type scorpionates, or amines. M23 and M25 serve as example of a divalent Europium complex having now cyclic organic ligand, but two identical organic anions, scorpionates and closocarborates, respectively. The figures are considered as representable for a divalent spin active cation (Figure 3) and a trivalent one (Figure 3), respectively. Especially, given their very similar chemistry, the complexes shown with Ce(lll) may identically be formed with any trivalent Lanthanide, especially with Gd(III). For purpose of example, only one type of divalent and trivalent cation is shown. For sake of clarity, most example in Fig. 3 and 4 are depicted with hydrogens. However, it is understood that those hydrogens may be substituted by any suitable organyl group, being identical or different in each instance of substitution.

In particular with respect to Fig. 3, examples M26 to M30 depict symmetrical polymacrocyclic ligands. M27 represents a simple yellow-emitting non-substituted charge-neutral aza-cryptand with two identical iodide anions present for charge compensation. M26 exemplifies a 6-fold methylated aza-cryptands that is blue emitting combined with two identical closo-carborate type anions. Many more examples are given in WO2021/244801. In M29 and M30 two identical negatively charged anionic side groups, pyrazolates and fluorinated alkoholates, respectively, are covalently attached to a tetra-methylated aza-cryptand at the nitrogen. M28 exemplifies attachment of two closocarborate type anions, substituting two neighbouring nitrogen atoms of the cryptand. Many more examples are given in the related art WO 2022/218562.

Examples M01 to M07 use an asymmetrical polymacrocyclic type ligand. In those 7 examples, the three organic bridges that link the two nitrogen atoms are of different length. In particular, two bridges comprise of 5 macrocyclic atoms with each one heteroatom, while the third bridge comprises of 11 macrocyclic atoms with three heteroatoms. The organic polymacrocyclic ligand is charge neutral and two identical negatively charged anions are covalently attached in M05, and non-covalently present in the other 6 examples. The organic ligand may be fully aliphatic, as for example in M05 and M07, or it may comprise aromatic groups of sufficiently high triplet energy, exemplified are furanyl, benzyl, and thiophene groups.

Most examples depicted in Fig. 3 comprise a macrocyclic type ligand (M08 to M22, M24 and M31 to M35) as those generally show high volatility when combined with divalent cations and are just preferably used if an Eu(!!) based metal organic host compound is intended for electroluminescent devices made by sublimation or evaporation process.

Most macrocyclic examples are derived from a preferred highly symmetrical generic macrocycle with 6 macrocyclic heteroatoms being selected from O, and/or N and overall 12 macrocyclic atoms, thus derivations of the 18C6 crown motive with 18 macrocyclic atoms. M31, M33, and M34 are examples with 5 heteroatoms and 20 macrocyclic atoms, while M35 illustrates the situation of only 4 heteroatoms and 18 macrocyclic atoms within the cyclic ring. M17 to M19 and M34 illustrates examples on how to covalently attach anionic side groups, here in particular closocarborates, to the macrocyclic ligand having 6 or 5 heteroatoms. All other macrocyclic examples in Fig. 3 use two identical non-covalently bound organic (for example M20) or inorganic anions (for example M21). While most of the examples in Fig. 3 are shown without further substitutions, M16 and others, M32, and M33 exemplify macrocyclic carbon substitutions with hydrogens present on one or more macrocyclic carbon atoms are substituted by methyl groups (M32), form a cyclohexane group as in M16 and others, or form a spiro cyclohexane group on a single substituted carbon atom (M33).

The compounds depicted in Fig. 4 are exemplary for the concept of using a spin-active trivalent cation as part of the metal organic host compound according to the present invention. As such, they are drawn for Ce(III), but equivalent compounds can be envisaged by those skilled in the art using any other trivalent cation, in particular trivalent lanthanide, in particular, Gd(III). All examples depicted in Fig. 4 are based on cyclic organic ligands, which, however, shall not limit the general scope of the invention. In particular, a plurality of negatively charge anionic ligands, for example based on pyrazolate-borates, or amines is well within the scope of the invention. The majority of cyclic ligands depicted in Fig. 4 are of the polymacrocyclic type (e1 to e43), while e44 to e46 are examples of using a single macrocyclic ligand. E44 and e45 are using 18 macrocyclic atoms with 6 nitrogens as macrocyclic heteroatoms while e46 uses three nitrogens plus three oxygens). E44 exemplifies the use of three inorganic non-covalently bound anions (chloride). In e45 three acidic nitrogen atoms are deprotonated thus serving as negative charges on the macrocyclic ring. Finally, in e46 three identical alcoholate anionic side groups are covalently attached via the nitrogen positions of the macrocyclic ligand.

It is to be understood that the polycyclic organic ligands can contain further substituents at any suitable carbon or nitrogen position, specifically organyl groups, organoheteryl groups, aryl groups, heteroaryl groups, heterocyclic groups, alkenyl groups, heteroalkyl groups, hetero cycloalkyl groups, cycloalkyl groups, alkyl groups or combinations thereof. Furthermore, halogen substituents may be present in the different compounds. In Fig. 4 such possible substituents have been mostly omitted for clarity.

For illustrative purpose coordination compounds comprising only biscyclic organic ligands are shown in examples e1-e12, 314, e15, e24-e30, e32-e37, e40-e43; while e23 is 4-cyclic; while e13, e16-18, e20, e21, e39 are 5-cyclic; and while e19, e22, e31, e38 are 6-cyclic. Coordination compounds comprising a charge neutral polycyclic organic ligand are shown in structures e4, e5, e12, e13, e16, e19, e21-e25, e27-e31, e34, e35, e38-e40. In all those cases, save e34, the charge compensation is achieved using three single electrically charged anions, which by definition are non-covalently bound to the organic polycyclic ligand, whilst in e34 a triple charged phosphate is used as charge compensating anion. Of the structures with non-covalently anions, e4, e5, e12, e21,e22, e24, e38, e40 use the halides iodide or bromide for charge compensation. In a preferred example, e23, e25, e27-e31, e34, e35, e39 contain anions with more than 3 atoms. Even more preferred, the anions used in examples e25, e27-e31, e39 have an (individual) molecular weight of greater than 128g/mol. Metal organic host compounds comprising a preferred threefold negatively charged polycyclic organic ligand are shown in structures e6-11, e14, e15, e17, e18, e20, e26, e32, e33, e36, e37, e41-43. In all those exemplary structures, save e20, 3 singly charged anionic groups are covalently attached to the polycyclic organic ligand. In case of e20, the negatively charged group is part of the scaffold of the macrocyclic ring system. In general the negatively charged anions may be covalently bound to any suitable atom of the polycyclic organic ring system, for example carbon or nitrogen atoms. By example of the latter case, structural isomers are obtained. Exemplarily for e10, the three possible structural isomers by connecting via the N- position of the polycyclic organic ligand, e10a-e10c are shown. Albeit typically only one substitution pattern is arbitrarily shown, it is understood that the structures shown in e6-11, e14, e15, e17, e18, e26, e32, e33, e36, e37, e41-43 shall comprise all possible isomers.

Many of the exemplary structures shown in Fig. 4 contain aromatic building blocks as part of the polycyclic organic ligands. For example, e13, e17, e18, e38 comprise pyridine; e16, e22, e31 furan; and e20 pyrazole. In each structure it is ensured that the aromatic building blocks contain no more than 8 aromatic carbon or heteroatoms, and that several such building blocks present in a single polycyclic organic ligand are being separated from each other by at least one aliphatic carbon or heteroatom. This ensures an efficient conjugation break between aromatic units and as such provides polycyclic organic ligands with sufficiently high triplet energy level such that the excitation within the emission layer according to the invention is confined on the exciplex or the organic emitter, but not the metal organic host and specifically not on the ligand of the metal organic host.

Suitable building blocks for the design of metal organic host materials that often combine good charge transport characteristics and a sufficiently high triplet energy to allow for the design of deep blue emission layers may be those of or derived from CT-1 to CT-22: 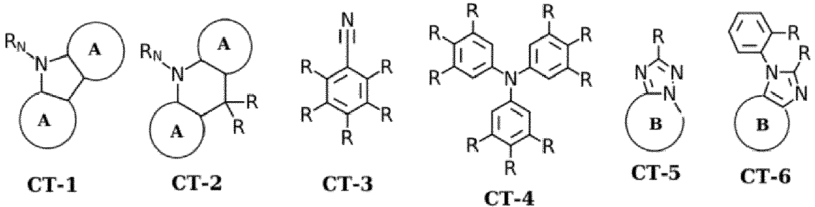 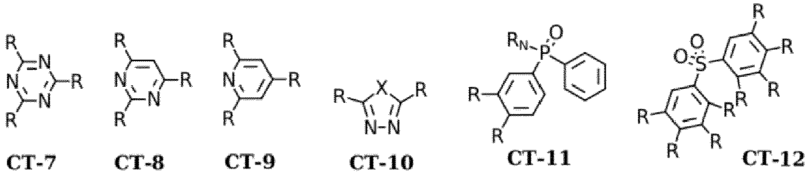 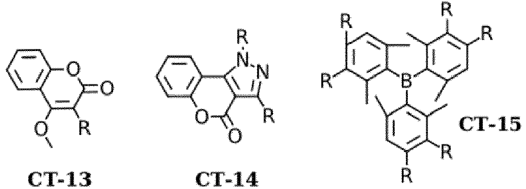 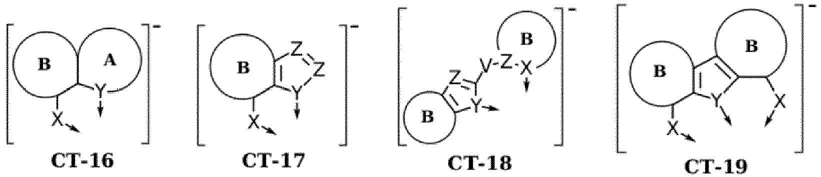 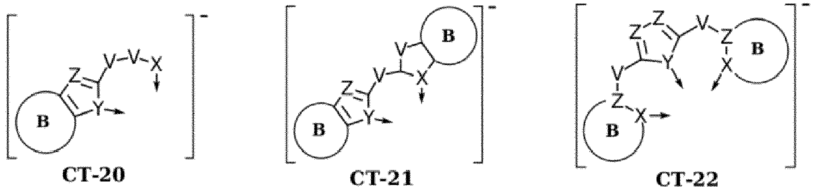 with arrows indicating a preferential coordination towards the metal center of the MOH, and **X** being independently in each occurrence a monovalent group selected from -O**R**, -S**R**, -N**R**2, -P**R**2, and **V** being independently in each occurrence a divalent group selected from -O-, -S-, -N**R**-, -P**R**-, -C**R**2-, -Si**R**2-, and Y being independently in each occurrence selected from N, or P, and **Z** being independently in each occurrence selected from N, P, CR, SiR, and **R and R_{N}** independently in each occurrence represent a monovalent organic group formed by removing a hydrogen atom from an organic molecule having at least one hydrogen and **R** may additionally each individually be selected from H, D, or halogen and **A,** and **B** being independently in each occurrence a substituted or unsubstituted aryl ring, or a substituted or unsubstituted heteroaryl ring, or a substituted or unsubstituted aliphatic ring, or **B** represents no cyclic group, but instead the atoms being connected to B are saturated by H, or any organyl group R as defined above. For example "B" shown in CT-20 may represent a cylic cyclohexene, or an phenyl group. In other embodiment, "B" is not a cyclic group and the two carbon atoms present in CT-20 are saturated by hydrogen atoms. In other embodiments, such hydrogens are substituted by any organyl group, halogen, or deuterium.

Here CT-16 to CT22 constitute formally negatively charge organyl groups, which are suitable for a direct metal-organic bond. CT-1 to CT-15 are charge neutral groups suitable to design coordination compounds. In various embodiments one or more negatively charge organyl groups derived from CT16 to CT22 are present within the metal organic host used in the emission layer according to the invention. In a preferred design of the metal organic host, the number of negatively charged organyl groups selected from CT-16 to CT-22 matches the oxidation stage of the spin active metal. For example, if a single Ce(lll) is present as spin active metal within the metal organic host compound than preferably three groups selected from CT-16 to CT-22 are present. The building blocks derived from CT-1 to CT-22 may be present as individual organic ligands as part of the metal organic host compound. For example, the triazine derived from CT-7 may from a charge neutral auxiliary ligand. In various preferred embodiments, the building blocks are covalently connected to each other forming a single organic ligand coordinating or chemically binding the central spin-active metal.

The electroluminescent device according to the invention comprises an organic layer comprising an organic emitter, with specific energy levels with respect to the metal organic host material. "Organic" implies that the emission of the emitter is substantially from aromatic or heteroaromatic groups and the emitter is not relying on the heavy metal effect, for example using Iridium or Platinum. As a substantially pure organic emitter, without heavy metal effect, the emitter will possess of an emitting singlet excited state, S1, and a non-emitting triplet excited state, T1, with the latter being the lowest electronically excited state. According to the invention, the organic emitter should possess a singlet to triplet gap of less than 0.4eV preferably of less than 0.3eV and most preferably of less than 0.2 eV. Therefore, typical pure aryl based aromatic deep blue emitter, such as anthracene or pyrene based, with their large singlet-to-triplet gap cannot fulfil this requirement. Instead, the organic emitter should have its HOMO and LUMO on different, preferably aromatic, parts of the organic molecule. Such organic emitters with suitable energies are often found within the class of thermally activated delayed luminescence compounds, TADF, and their photophysical properties, in particular the singlet and triplet energies, are widely tabulated, such that suitable organic emitters can easily be selected from the available literature, see for example the review of Wang et al. in Adv. Funct. Mater. 2021, 31, 2008332. TADF emitters are sometimes designed by covalently linking an electron donor to an electron acceptor group. The emission proceeds typically through a charge transfer state, whose energy is related to the twisting angle between the donor and the acceptor group. While those molecules often exhibit small singlet triplet energy gaps, there emission spectrum is rather wide. Preferred are TADF emitter, with the relative position of donor / acceptor part being invariant. Of particular interest for this invention are so called multiresonant emitter (see Kondo et al. in Nature Photonics Vol. 13, pg. 678-682 (2019)) which are characterized by an heteroaryl fused aromatic ring system comprising at least one donor and at least one acceptor atom, within the molecular plane. No undesired rotation can take place and those type of organic emitters often feature a desirable narrow emission spectrum, besides having a small singlet to triplet excitonic energy gap.

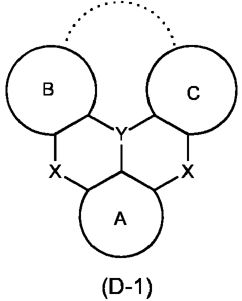

Generic formula (D-1) describes an archetypical multiresonant emitter with, ring A, B, and C being each independently a substituted or unsubstituted aryl ring, or a substituted or unsubstituted heteroaryl ring, or a substituted or unsubstituted aliphatic ring, and the broken line connecting the B ring and the C ring indicates an optional bond at the position/between free valences of the two rings through a single bond or linking group, and X is each independently a single bond, NR, O, CR2, SiR2, S, or Se, and Y is each independently B, P, P(=O), P(=S), Al, Ga, As, CR, SiR, or GeR, preferably B and R goups are each independently hydrogen, deuterium, halogen, aryl, heteroaryl, diarylamino, diarylboryl, alkyl, cycloalkyl, alkoxy or aryloxy.

In (D-1) Y typically serves as electron acceptor, often boron, while X is the electron donor, often nitrogen. The 6-membered rings comprising Y and X are forced into a plane by multiple covalent bonds, but still have a substantial charge-transfer character, that is, HOMO and LUMO are not equally distributed within the ring. The ring structures A, B, C further add to the stiffness of the structure.

The emitter described by the generic structure (D-1) may be further substituted at each position of A, B, and C, and/or X. A special case of substitution applies, if the organic emitter comprises of several identical or different units of the generic structure (D-1). Such instances may fuse to each other forming a larger substantially flat molecule. As well the subunits may be covalently linked to each other.

The preferred organic emitter has a first excited singlet state of 2.6 eV or even 2.65 eV in the deep blue spectral region. With respect to (D-1) and for Y being Bor and X being selected from nitrogen in both instances, it is preferred that the nitrogens together with the benzyl rings B, and C, do not form a carbazole group as this may lead to green emitting molecules. Preferred are emitter molecules having their emission dipole moment preferably parallel to the substrate such that the light emission perpendicular to the substrate is maximized. In most aromatic or heteroaromatic organic emitters, the emitter dipole is located with in the aromatic fused ring system. For example, for emitters derived from the generic structure (D-1) the emission dipole will follow the charge transfer state from Y → X within the plane of the molecule. General preference is given to emitter with large extended fused aromatic or heteroaromatic systems, which have the tendency to arrange themselves parallel to the surface of the organic layer during evaporation or sublimation process. This feature of molecules may be described by their Ovality (O), which is defined as the ratio of the normalized Volume to the area in a certain projection, see for details Hehre et al. in, Spartan '18 Tutorial and Users Guide Irvine CA. ISBN 978-1-890661-43-0. An ovality O = 1 describes a perfect spherical molecule. Preferred are organic emitter molecules with an ovality that is significantly higher than 1, more preferably O >1.8. The ovality of any molecule can be easily determined from DFT calculated molecular structures. Experimentally, the anisotropy of the emission dipole may be probed by ellipsometry of the absorption states on thin films. Alternatively, angular dependent emission spectroscopy can be used to probe the emission dipole anisotropy on actual working electroluminescent devices. Suitable is for example the Phelos system provided by Fluxim.

In literature an orientation factor, S', is defined as S'=1-(cos²Θ) with Θ being the average orientation of the emitter dipole. A material with a random orientation shows S' being 0.66. A perfect orientation parallel to the substrate plane corresponds to S' being equal to 1. A molecule that is preferably aligned parallel to the substrate plane shows a value of S' between 0.66 and 1.0. In other words, more than 66% of the emission dipoles and up to 100% of the emission dipoles are arranged parallel to the substrate plane.

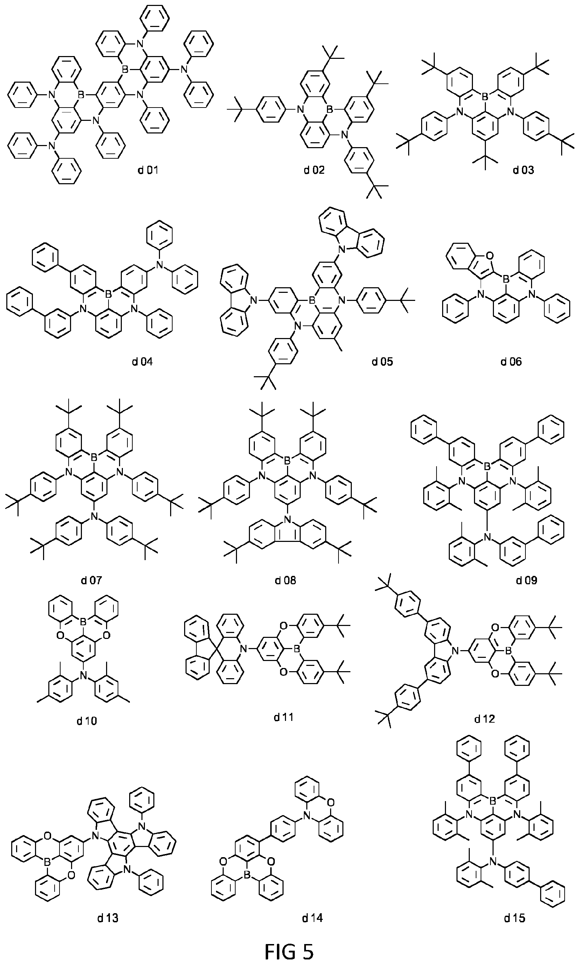

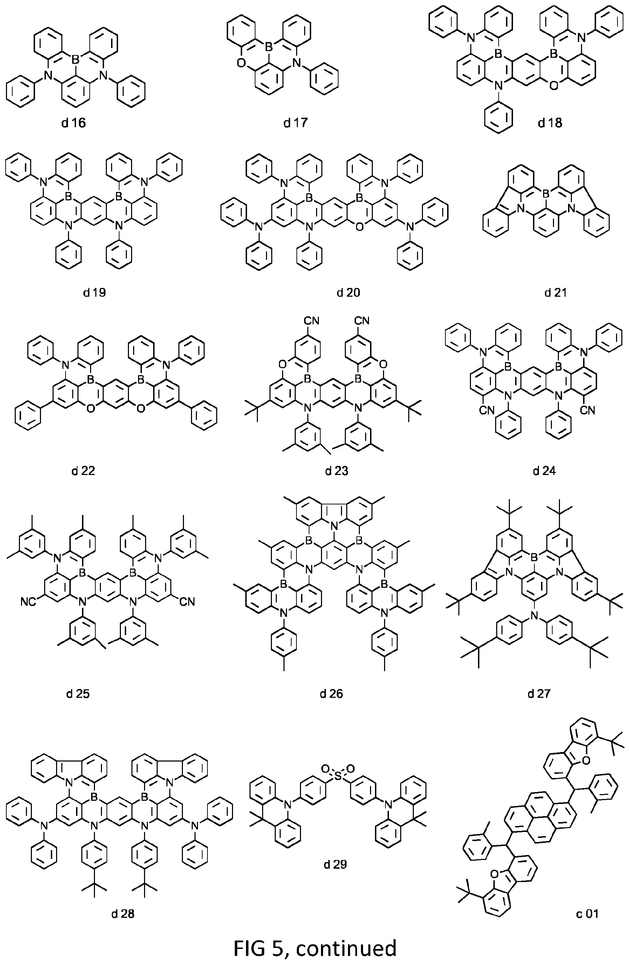

For illustration and without limiting the general scope of the invention, concrete examples of organic emitter materials that may be used in electroluminescent devices according to the invention are depicted as d1 to d29 in Fig. 5. Except d29, all these examples are based in the generic formula (D-1) with Y being Bor and X being N and/or O. D29 represents an example of a donor acceptor type TADF emitter. All examples d1 to d29 exhibit sufficient small singlet triplet energy gap of less than 0.4eV. C01 at the end of the figure represents a counterexample based on pyrene, where the singlet triplet gap is above 0.4eV and as such the emitter is not suited as organic emitter in the use according to the invention.

The high efficiency with narrow emission spectrum often observed for multiresonant organic emitters those systems highly attractive for application in consumer displays based on pixilated electroluminescent devices. Besides operational stability, for those applications, the efficiency of the organic electroluminescent device - preferably emitting in the deep blue spectral region, is of prime importance. According to the invention, the performance of such electroluminescent devices can be further improved by designing a low energy exciplex together with a spin active metal organic host material. In this description, an electroluminescent device or OLED may be any device or structure including substantially organic layers or subunits, where an electrical current of opposite charges is passed through an organic layer and after recombination generates visible light.

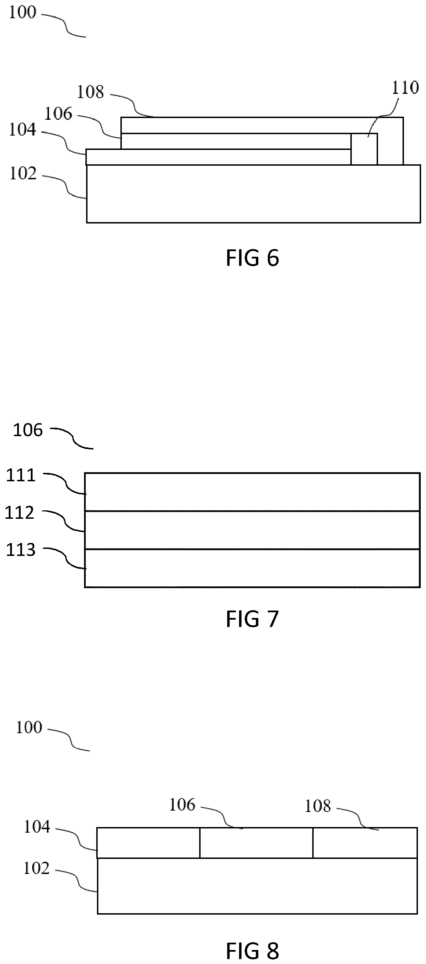

**FIG. 6** and **FIG. 8** illustrate embodiments of an organic electronic device 100 configured as electroluminescent device. The device includes a first electrode 104, e.g., on a substrate 102 or as the substrate; a second electrode 108; and an organic layer 106 arranged such that it is electrically interposed between the first and second electrodes 104, 108. The first and second electrodes 104, 108 may be electrically insulated from each other by an insulating structure 110, e.g., a resin or polyimide. The first and second electrodes 104, 108 may be stacked over each other (FIG. 6) or may be arranged in a common plane for example side-by-side (FIG. 8). In one embodiment according to the invention, the electroluminescent device 100 is configured as a large area OLED device with intended use for illumination, signage, or as a backlight. In another embodiment, the electroluminescent device 100 may include a plurality of OLEDs arranged in a pixelated layout (plurality of OLED pixels) that are individually electrically connected, e.g., for flat panel display applications. Here, individual pixels may have the capability of emitting light of substantially narrow spectral portions; especially of red, green, and blue. The exciplex according to the invention and comprising the organic emitter and the metal organic host compound may or may not be present in any of the individual pixels.

In another embodiment, the individual pixels may be configured to emit white light. Red, green, and blue spectral portions are generated by using suitable filter elements in optical contact with the respective pixelated OLEDs.

In another embodiment, the OLED pixels emit blue light, and the red and green spectral portions may be generated by using a suitable color conversion element in optical contact with the OLED pixels.

In another embodiment, the OLED pixels emit substantially in the near-UV spectral region with wavelength < 450 nm and the red and green and blue spectral portions may be generated by using a suitable color conversion element in optical contact with the OLED pixels.

The organic layer 106 may include the exciplex according to the invention comprising the metal organic host compound MOH and the organic emitter OE according to the present invention and as defined above or to any of the described or illustrated embodiments, e.g., the layer may contain just the exciplex system according to the invention, or the layer may comprise of further organic or non-organic materials. The organic layer may be a single layer or contain a plurality of sublayers. **FIG. 7** illustrates the situation where the organic layer 106 comprises a plurality of sublayers 111, 112, and 113. The exciplex according to embodiment one may be part partly or exclusively contained in one or more layers present in the overall organic layer 106.

The organic layer 106 is arranged electrically between the first and second electrodes 104, 108, such that an electronic current may flow from the first electrode 104 through the organic layer 106 to the second electrode 108 and vice versa during operation, e.g., in light emission applications. In other words, during operation, i.e., light generation, upon application of sufficient voltage, holes and electrons are injected from the anode and the cathode, respectively, and drift towards the organic layer 106, where charges of opposite sign recombine to form a short-lived localized excited state, preferably on the exciplex according to the invention. The short-lived excited state may transfer to the locally excited singlet state of the organic emitter and subsequently relax to the ground state thereby giving rise to light emission. The recombination may happen inside (bulk) or at the interface of the organic layer 106. For recombination within the bulk of the organic layer, both crucial parts of the exciplex according to the invention, the metal organic host and the organic emitter must be present within the organic layer. For recombination at the interface between two organic layers, the metal organic host may be present in only one of the two layers and the organic emitter in the other or both and/or the organic emitter is present in only one of the organic layers, while the metal organic host present in both layers or just the other. The exciplex may from at the interface between the two organic layers. Such different organic layers may simply be formed by a concentration gradient of one of the two crucial parts of the exciplex according to the invention, i.e. the metal organic host or the organic emitter. The electroluminescent devices according to various embodiments may have excellent emission properties, including a narrow deep blue emission spectrum with high emission quantum efficiency. The exciplex according to the invention is configured as a charge transfer state between two different molecule and as such has little singlet or triplet character it is therefore widely indifferent to excitation with either spin 1 or spin 0 electron-hole pairs. In other words, both singlet and triplet excitations are harvested, resulting in very efficient light emission. Additionally, the presence of the spin active element promotes the transfer of all excitations towards an fluorescent singlet emitter, preferably with narrow and deep blue emission spectrum and high emission quantum efficiency. As such, emission layers comprising the exciplex according to the invention may be ideally suited for application in organic electroluminescent devices, such as organic light emitting diodes (OLED). Relaxation pathways without light emission, such as thermal relaxation, may be possible too, but may be considered undesirable, as they lower the conversion efficiency of current into light of the device.

Within this disclosure, the at least one active light emission layer, for example 106 in Fig. 6 and 8, comprises an exciplex according to the invention comprising a spin active metal organic host and an organic emitter. In OLED devices the light emitting layer may be configured containing substantially only the emitting organic compound; in other words, there is a layer present that consists of chemically substantially pure organic emitter. In most state-of-the-art OLED designs the emitting material is not used as a pure layer, but instead imbedded into one or more charge neutral host materials, often configured to transport charges. According to the invention one of those charge neutral host materials must be a metal organic host material with unpaired electrons and/or having an electronic spin of ≥1/2. Even in case of a pure emission layer that is substantially only containing the organic emitting material, the charge recombination and thus the excitation generation very often happens at the interface of said pure emitter layer with an adjacent charge transport layer, in which case the exciplex according to the invention should be formed at the interface of the substantially pure organic emitter layer and the adjacent layer that will contain the metal organic host.

In various embodiments, the two compounds that do form the exciplex according to the invention, i.e. the metal organic host and the organic emitter, are in combination present within the emission layer according to the invention at a concentration of at least 20vol%, preferably at least 50vol%, with the sum of all materials present in the one or more emission layers being 100vol%. In various other embodiments, the combined concentration of organic emitter and metal organic hosts within the organic emission layers or parts thereof may be 100vol%. That means, besides the two compounds forming the exciplex according to the invention no other materials are present, save some trace amounts.

In various embodiments, the molar ratio of the organic emitter and the metal organic host material is close to 1:1, which will maximize the chance of exciplex formation. In other embodiments, the molar ratio significantly deviates from 1:1, preferably, there is more host material present as compared to organic emitter. In particular, there may be 5 times more host, more preferably 10 times more host and most preferably 15 times more host molecules present within the organic emission layer as compared to organic emitters. In other words, the molar ratio of metal organic host to organic emitter may be 5:1, preferably 10:1 and most preferably 15:1. For example, assuming equal translation of molar concentration into volume concentration (which is typically not the case), there may be 3 vol% of organic emitter present as part of the emission layer, but 15vol%, preferably 30vol%, more preferably 45vol% of metal organic host present.

In various embodiment the molar ratio and/or concentration of the organic emitter and the metal organic host may be substantially constant with a single emission layer according to the invention. In various other embodiments, the molar ratio and/or concentration of the metal organic host and the organic emitter that do form the exciplex according to the invention is not constant measured in the direction perpendicular to the emission layer. For example, it may be that the concentration of the organic emitter is higher at one or both interfaces of the organic layer as compared to the average within the overall emission layer. It may well be that within said emission layer one or more sublayers exists which contain substantially only the organic emitter. One or more metal organic host sublayers may as well be partially or fully depleted of the organic emitter. In case one or more substantially pure sublayers that do contain nearly exclusively either the metal organic host compound or the organic emitter are present, than the above preferred embodiments describing the volume and molar ratios may be applied to the average through all sub organic layers forming the emission layer.

The organic electronic device 100 may be configured to emit substantially monochromatic light such as red, green, blue, or polychromatic light such as white. Preferably, the device emits substantially in the blue spectral region. The light may be emitted through the first electrode 104 (bottom emitter), through the second electrode 108 (top emitter), or through first and second electrodes 104, 108 (bidirectional emitter). The light may as well be substantially emitted in a direction parallel to the organic layer 106 using suitable opaque electrodes 104, 108.

Further layers may be formed and in electrical connection between the first and second electrodes 104, 108, e.g., configured for charge carrier (electron or hole) injection, configured for charge carrier transport, configured for charge carrier blockage or configured for charge generation. For example, FIG. 7 may represent the situation where the exciplex disclosed in embodiment 1 or any other part of this description is present in layer 112 whereas the nearby layers 111 and or 113 may be configured as charge transport or charge blocking layers. The metal organic host according to the invention must be present in at least one of the sublayers 111, 112, or 113, but can be present each individually at same or different concentration in two or all sublayers being part of the emission layer 106. The metal organic host according to the invention may be configured as charge transport or charge blocking host or have any other function beneficial for the performance of the device, preferably it ensures high emission efficiency of the organic emitter.

The recombination of electrons and holes may happen within the emission layer 106 (within the bulk) or at the interface of the organic layer 106, which contains the organic emitter according to the invention and an adjacent organic layer comprising the spin active metal organic host material according to the invention. The adjacent layer may be configured to block charges such as electrons or to transport charges, such as holes. Independent of the exact configuration of the electroluminescent device, the emission layer shall be the layer where the exciplex according to the invention is formed. In various embodiments, the organic emitters and/or the metal organic host material that do take part in the exciplex according to the invention and as such are present in the emission layer according to the invention are present in one or more organic layers within the electroluminescent device. Those layers may or may not be directly adjacent to the emission layer. In a preferred embodiment, the metal organic host compound is capable of transporting charges, for example holes and it is present in all layers between the organic emission layer according to the invention and one of the electrodes. Such an embodiment allows for a very simple device architecture with few materials and with low energetic losses because the charge transporting metal organic host must at the same time have the lowest LUMO or highest HOMO, respectively to fulfil the energetic requirements of embodiment 1. In one embodiment, the metal organic host material used in the exciplex according to the invention is present at anode and is mixed with a reducing agent such that is predominantly oxidized.

Further optically functional layers, e.g., a further electroluminescent material and/or a wavelength conversion material may be formed between the first and second electrodes 104, 108 and in the optical path of the organic layer 106, e.g., on top of the second electrode 108 and/or on the opposite side of the substrate 102. In addition, encapsulation structures may be formed encapsulating the electrically active area, e.g., the area in which electrical current flows and may be configured to reduce or avoid intrusion of oxygen and/or water into the electrically active area. Further optically functional layers, e.g., an antireflection coating, a waveguide structure and/or an optical decoupling layer may be formed within the optical light path of the organic layer 106. In various embodiments, the light emitted by the organic electronic device 100 may be in optical contact to at least one optically active layer, including any optically active materials such as organic molecules or quantum dots. The optically active layer may be a spectral filter element, which may absorb part of the light emitted by the organic electronic device 100. In another embodiment, the optically active layer may absorb at least part of the light emitted by the organic electronic device 100 and may reemit it at longer wavelength (wavelength conversion), e.g., by quantum dots. As example, the organic (light) emitting layer (EML) 106 may be configured to emit light substantially at wavelengths shorter than 500 nm and the (additional) optically active layer may be configured to substantially reemit light at wavelengths longer than 500 nm. The optically active layer may be placed in between the anode and cathode of the organic electronic device 100 or outside of it. The optically active layer may as well be part of the organic layer (EML) 106. However, this will increase the number of components in this layer.

Preferably, further organic layers are formed between the first and second electrodes 104, 108 and in the electron and/or hole current path of the organic layer 106, e.g., on top of the second electrode 108 and/or on the opposite side of the substrate 102. For example, hole or electron blocking layers may be used to optimize the individual hole and electron currents through the organic electronic device 100. This may be known to those skilled in the art as charge balance to optimize efficiency and operational stability. In various embodiments, dedicated hole or electron charge transport layers may be present in the organic electronic device 100 to space the emission region from the first and second electrodes 104, 108. For example, layers 111 and or 113 being part of the light emission layer 106, depicted in FIG. 7 may be configured as electron - and/or hole blocking layers, while layer 112 forms the exciplex according to the invention. The hole and/or electron blocking material comprised within sublayer 111 and/or 113 may or may not contain the metal organic host and/or the organic emitter material present in the exciplex according to the invention.

Examples of hole transport materials include known materials such as fluorene and derivatives thereof, aromatic amine and derivatives thereof, carbazole derivatives, dibenzofuran, dibenzothiophene, and polyparaphenylene derivatives. Examples of electron transport materials include oxadiazole derivatives, triazine derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and its derivative, diphenoquinone derivatives, and metal complexes of 8-hydroxyquinoline and its derivatives and various silanes.

In various embodiments, those charge transport layers may include electrical dopant molecules, such as radialenes, or metals, such as lithium or ytterbium, or may be in contact to charge injection layers, such as LlQ or LIF.

Any of those auxiliary layers may be fully organic or may include inorganic functional moieties. For example, charge transport layers may be made of the class of Perovskite materials or may comprise LlF, or Ytterbium.

The emission layer, 106, comprising the exciplex comprising the metal organic host compound (MOH) and the organic emitter (OE) according to the invention as illustrated or described in any one of the embodiments may be used as a thin substantially organic layer of any thickness in the range of 0.1 to 100 nm, preferably in the range of 1 to 40 nm, most preferably 3 to 18 nm. Each individually, the concentration of the organic emitter compound and/or of the metal organic host compound throughout the cross section of the organic layer may be constant or varied. Typical variable concentrations are in the range of 0 to 100 vol%, i.e., the layer may be partially containing either no organic emitter or just organic emitter, and/or the layer may be partially containing either no metal organic host compound or just the metal organic host compound. For example, sublayers such as discussed in Fig. 7 may be formed within the emission layer. Such situations are indeed frequently observed if laterally movable evaporation sources are employed to co-sublime organic materials, such as the metal organic host material with the organic emitter to form the exciplex according to the invention.

In various embodiments, one or more additional and optional organic host materials may be present in the organic layer 106. According to the invention, those optional materials are preferably energetically configured to not participate in the exciplex according to the invention, see Fig. 1 and 2. In various embodiments, optional inorganic or preferably organic, host material may improve charge transport into and through the organic layer 106 or facilitate charge recombination. The optional material may as well improve the emission quantum efficiency of the organic emitter. The optional one or more second host material may be any organic or inorganic host material and the metal organic host taking part in the exciplex according to the invention, and the one or more optional host material may be considered as a co-host system. The organic layer EML 106 that contains the mixture of metal organic host MOH and organic emitter compounds OE according to the invention may contain (any) further organic and/or inorganic material in a range of 0.1 to 99.0 vol%, based on all further material and the organic layer EML, that is not intended to transport charges. An organic electronic device 100 according to various embodiments may be fully or partly fabricated using a wide range of commonly used techniques, including, but not limited to, deposition of all or some layers, from gas phase vacuum deposition, solution phase, or gas phase using a carrier gas method. According to various preferred embodiments guest-host systems comprising the organic emitter and metal organic host compound may both be processed using vacuum based techniques. In other words, the volatility of the metal organic host compound and the organic emitter material may be sufficiently high to allow for thermal vacuum processing techniques to be used. High volatility can for example be achieved by using spin active metal-organic coordination compounds employing size discriminating macrocyclic or polymacrocyclic organics ligands, such as exemplified in Fig. 3 and Fig. 4, as here the ionic character of the compounds is strongly suppressed, if compared to other organic salts without any size discriminating organic ligand. During the deposition process from gas phase, the metal organic host compound may be co-deposited with a second organic material, the second organic material may preferably be the organic emitter taking part in the exciplex formation according to the invention. The thermal sublimation or evaporation may proceed using two separate thermal sources, in other words, the guest-host film is formed in-situ after deposition. During such co deposition two or more additional materials (optional host materials) may be deposited using a triple or quadruple evaporation, whereby the exciplex forming guest-host system may be further diluted within the mixed layer to be deposited. Alternatively, a guest-host system may as well be thermally processed from one crucible. In other words, a mixture, for example of a spin-active metal organic host materials with the organic emitter, or a precursor thereof is already present before sublimation or evaporation. A precursor may for example comprise of an additional auxiliary ligand present as part of the spin-active metal organic host that dissociates during thermal evaporation and that is substantially not built into the organic layer comprising the exciplex according to the invention. Preferred in this situation are similar volatilities for the two materials to be co-processed. Alternatively, the metal organic host and the second organic material, for example being the organic emitter material according to the invention, may form a frozen glass, thereby forcing the individual components to sublime at similar temperatures.

For one or more aspects, at least one of the components set forth in one or more of the preceding figures may be configured to perform one or more operations, techniques, processes, and/or methods as set forth in the example section below.

### EXAMPLES

The examples set forth herein are illustrative of the present invention and not exhaustive.

Any feature contained in the examples may be combined with any other example (or combination of examples) or any of the claimed or disclosed embodiments of the invention, unless explicitly stated otherwise. The foregoing description of one or more implementations provides illustration and description but is not intended to be exhaustive or to limit the scope of aspects to the precise form disclosed. Modifications and variations are possible in light of the above teachings or may be acquired from practice of various aspects.

### Synthesis of metal organic host compounds used in the examples

All coordination compounds synthesized are hereafter referred to as **M15, M17, M28, M31** and **M36,** with their chemical structures depicted in Fig. 3, and **e10, e26** and **e46,** with their chemical structures being depicted in Fig. 4, respectively.

All experimental manipulations were carried out under inert atmosphere. Tetrahydrofuran (Acros Organics, extra dry, AcroSeal) was dried and distilled from K/benzophenone or purchased as anhydrous from Acros Organics. Toluene (Acros Organics, Extra Dry, AcroSeal) was purchased as anhydrous from Acros Organics, Methanol (Acros Organics, Extra Dry, AcroSeal) was purchased as anhydrous from Acros Organics. Europium(II) iodide, (Aldrich, AnhydroBeads, 10 mesh, 99.999% trace metals basis) was used as purchased. Triethylammonium closo-1-carbadecaborate and Trimethylammonium 12-hydroxy-1-carbadodecaborate (Katchem, >97%) were used as purchased.

Synthesis of **e10** was performed analogous to the description given in WO 2023/194363.

1,4,7,10,13,16,21,24-octaazabicyclo[8.8.8]hexacosane used as the starting material for the synthesis of M28 was obtained as described in WO 2023/194363.

An intermediate bis[bis(trimethylsilyl)amide] bis(tetrahydrofuran) europium(II) (Eu(HMDS)₂) was synthesized as described in WO2021/244801A1.

The organic ligand 1,4,10,13-tetraoxa-7,16-diazacyclooctadecane used for preparation of M15, M17 and M36 was purchased from Sigma-Aldrich, ≥96% and purified by distillation in vacuum prior to use.

The organic ligand 1,4,7,10,13,16-hexaazacyclooctadecane (purity ≥96%), used for preparation of e44, was purchased from Chemieliva and purified by distillation in vacuum prior to use.

The organic ligand 1,7,13-trioxa-4,10,16-triazacyclooctadecane, used for preparation of M24 (purity ≥96%) was purchased from Chemieliva and purified by distillation in vacuum prior to use.

The organic ligand 1,5,9,13,17-pentaazacycloicosane, used for preparation of M31 (purity ≥96%), was purchased from Chemieliva.

The organic ligand trimethylammonium 5,18-bis(2-(1-carbadodecaboryl-12-oxy)ethyl)-2,8,15,21-tetraoxa-5,18-diazatricyclo[20.4.0.0.9.14]hexacosane) used for the synthesis of M17 was synthesized as follows:
*Step 1*. 1.36 g (6.22 mmol, 2.2 eq.) of trimethylammonium 12-hydroxy-1-carbadodecaborate were dissolved in 25 ml of anhydrous THF and treated with 0.75 g (18.7 mmol, 6.6 eq.) of sodium hydride (60 %). The mixture was stirred at rt. for 2 hours. The mixture was filtered, the residue washed with small amounts of anhydrous THF and the filtrate was concentrated in vacuum to dryness. The obtained sodium 12-oxido-1-carbadodecaborate was redissolved in 25 ml of anhydrous THF and added to a solution of 1.48 g (2.83 mmol, 1.0 eq.) 2-Chloro-1-{18-(2-chloroacetyl)-2,8,15,21-tetraoxa-5,18-diazatricyclo[20.4.0.0^{9,14}]hexacos-5-yl}-1-ethanone in 20 ml anhydrous THF. The reaction mixture was stirred at room temperature for 15 h and quenched with 20 ml of an aqueous solution of NaCl (half-sat.). The layers were separated, and the aqueous layer was extracted with EtOAc. The combined organic layers were concentrated in vacuum. The residue was dissolved in a boiling mixture of H₂O/EtOH (4:3) and treated with 1.35 g (14.1 mmol, 5.0 eq.) of Trimethylammonium chloride. The mixture was cooled to 0 °C for 1 h, the precipitate filtered-off, washed with H₂O and dried in vacuum. The obtained Trimethylammonium salt was purified by recrystallization from EtOH/H₂O (4:3).
*Step 2.* The before obtained crystalline product was dissolved in 45 ml anhydrous THF and treated with 11.3 ml (22.5 mmol, 10 eq.) of a 2 M borane-dimethylsulfide complex solution in THF. The mixture was heated to reflux and stirred for 15 h. After cooling to rt, the reaction was quenched by carefully adding 20 ml of 4 M hydrochloric acid. The resulting mixture was then alkalized by adding 20 ml of an aqueous 12.5 M NaOH solution. The layers were separated, the aqueous layer was extracted with Et₂O and the combined extracts were washed with 20 ml of water and brine each. The organic layer was concentrated in vacuum to dryness. The residue was dissolved in a boiling mixture of water and THF. The solution was treated with 1.29 g (13.5 mmol, 6.0 eq.) Trimethylammonium chloride. The mixture was concentrated in vacuum until a white solid precipitated. The mixture was then cooled to 0 °C for 1 h and the precipitate filtered off, washed with water and dried in vacuum. The title compound was yielded as colorless powder in 46% yield over two steps.

**M17:** A mixture of trimethylammonium trimethylammonium 5,18-bis(2-(1-carbadodecaboryl-12-oxy)ethyl)-2,8,15,21-tetraoxa-5,18-diazatricyclo[20.4.0.09,14]hexacosane (1 eq. 128 mg, 0.17 mmol) and THF (1.75 ml) was treated with a solution of Eu(HMDS)₂ (synthesized as described in WO2021/244801A1) (105 mg, 0.17 mmol) in THF (1.75 ml) at rt. The mixture was stirred for 1 h at rt. The precipitate was filtered off, washed with THF (3x2 ml) and dried in vacuum. The title compound was yielded as colorless powder. Yield: 130 mg (97 %).

**M28:**
*Step 1*. Bis-protection of 1,4,7,10,13,16,21,24-octaazabicyclo[8.8.8]hexacosane was accomplished according to procedure described in J. Chem. Soc., Perkin Trans. 1, 1999, 3499. Particularly, 1,4,7,10,13,16,21,24-octaazabicyclo[8.8.8]hexacosane, obtained as described in EP22166525 (1.03 g, 2.77 mmol) and diethyloxalate (0.406g, 2.78 mmol) were dissolved in 10 ml of ethanol and refluxed for 12 hours. After removal of the solvent, a crude protected product was obtained. It was purified by column chromatography on basic alumina (eluent: dichloromethane/methanol 9/1). Yield: 0.71 g (52%).
*Step 2.* Methylation of the product obtained in a preceding step was methylated (remaining four hydrogen atoms were substituted by methyl groups) was accomplished by a standard methylation procedure described for of 1,4,7,10,13,16,21,24-octaazabicyclo[8.8.8]hexacosane in WO 2021/244801 A1. Yield: 0.48 g (89%).
*Step 3.* The resulting product was subjected to deprotection by refluxing in ethanol solution of NaOH, as described in J. Chem. Soc., Perkin Trans. 1, 1999, 3499. Particularly, the product from step 2 was stirred in 5M NaOH in water at 90°C overnight. The product was extracted with dichloromethane. The solvent was rotary evaporated. Dropwise addition of HCl-ethanol solution induced precipitation of the hydrochloride salt, which was washed twice with ethanol and dried in vacuo.
*Step 4.* Attachment of two (1-carbadodecaboryl-12-oxy)ethyl)-substituents to the product of Step 3 is accomplished as described above for the synthesis 5,18-bis(2-(1-carbadodecaboryl-12-oxy)ethyl)-2,8,15,21-tetraoxa-5,18-diazatricyclo[20.4.0.0.9.14]hexacosane) used for the preparation of M17.
*Step 5* (synthesis of **M28**)**.** M28 was obtained from the product of the Step 4 (1 eq. 141 mg, 0.17 mmol), Eu(HMDS)₂ (105 mg, 0.17 mmol) and THF (5 ml) as described above for the synthesis of M17. Yield: 142mg (95%).

**M36:** A solution of 0.91 mmol (1.0 eq., 368mg) europium(II) iodide in 11 ml THF was added dropwise to a solution of 0.91 mmol (1.0 eq., 240mg) of 1,4,10,13-tetraoxa-7,16-diazacyclooctadecane in 20 ml THF. The resulting suspension was stirred for 1 h at room temperature and then filtrated. The resulting powder was washed with THF and dried in vacuum at room temperature. Yield in the case of E2 is 0.5 g (82 %).

Synthesis of europium(II) (tetrahydrofuran)carbadodecaborate. A solution of 5.76 mmol (2.0 eq., 1170mg) trimethylammonium carbadodecaborate in 20 ml THF was dropwise treated with a solution of 2.88 mmol (1.0 eq., 1777mg) europium(II) bis[bis(trimethylsilyl)amido]bis(tetrahydrofuran)europium in 40 ml THF. The resulting suspension was stirred for 1 h at room temperature and then filtrated. The resulting powder was washed with THF and dried under reduced pressure. Yield: 97 %.

**M24:** A solution of 1.85 mmol (1.0 eq., 486mg) 1,7,13-trioxa-4,10,16-triazacyclooctadecane in 20 ml toluene was dropwise treated with a solution of 1.85 mmol (1.0 eq., 945mg) europium(II) (tetrahydrofuran)carbadodecaborate in 120 ml toluene. The resulting suspension was stirred for 1 h at room temperature. The solvent was removed in vacuum. The resulting solid powder was washed with diethyl ether. Yield: 77 %.

**M31:** was obtained analogously to M24 from europium(II) (tetrahydrofuran)carbadodecaborate and 1,5,9,13,17-pentaazacycloicosane.

**M15:** was obtained analogously to M24 from 1,4,10,13-tetraoxa-7,16-diazacyclooctadecane and europium(II) (tetrahydrofuran) carba-closo-decaborate.

Europium(II) (tetrahydrofuran) carba-closo-decaborate was prepared analogously to europium(II) (tetrahydrofuran)carbadodecaborate by using trimethylammonium salt of carba-closo-decaborate instead of the corresponding dodecaborate salt.

**e44:** was obtained by mixing 1,4,7,10,13,16-hexaazacyclooctadecane (1 eq, 300 mg, 1.16 mmol) and cerium(III) chloride (1 eq, 286 mg, 1.16 mmol) in 10 ml of dry MeOH by stirring at room temperature followed by filtration and washing of precipitated product. Yield 0.3g (40%).

**e46:** was obtained by using procedure for preparation of e10, described in EP22166525 by using the crown 1,7,13-trioxa-4,10,16-triazacyclooctadecane as a starting material instead of the aza-cryptand used in EP22166525.

After chemical synthesis, all coordination compounds were purified using gradient sublimation (Creaphys, DSU-10), and the purity of the title compounds was confirmed by elementary analysis with the C, H, N ratios deviating from the theoretical rations by less than 1%.

### Electroluminescent device examples

Representative embodiments of organic electronic devices according to various embodiments will now be described, including a detailed description of the fabrication process of the organic electronic device. Yet, it will be understood that neither the specific techniques for fabrication of the device, nor the specific device layout, nor the specific compounds are intended to limit the scope of the present invention.

Material definitions:
ITO: Indium tin oxide, transparent anode
MoO3: Molybdenum oxide
Yb: Ytterbium
Al: Aluminium
H1: [3-(9-Carbazolyl)-9-oxa-1-fluorenyl]tris(phenyl)silane
H2: 2-Phenyl-4,6-bis(3-(triphenylsilyl)phenyl)-1,3,5-triazine
H3: Bis[3,5-di(9H-carbazol-9-yl)phenyl]diphenylsilane
H4: [3-(4,6-diphenyl-1,3,5-triazin-2-yl)phenyl]tris(phenyl)silane
H5: 11-phenyl-11H-benzo[b]dinaphtho[2,1-d:1',2'-f]phosphepine 11-oxide
H6: Triphenyl[6-(triphenylsilyl)-9-oxa-3-fluorenyl]silane

The materials H1, H2, H3, H4, H5, H6, d01, d02, d29, and c01 are commercially available, compare Figure 5 for the chemical structures of the latter four organic emitting materials. H1, H2, H3, H4, H5, H6 were purchased from Jilin OLED Material Tech Co.,Ltd., and d01, d02, d29, c01 were purchased from Shenzhen Puri Materials Technology Co., Ltd. The materials were purified by sublimation prior use.

The organic electronic devices were prepared with the following generic layer sequences: ITO / 2 nm MoO3 / 70 nm H3 / **20 nm EML** / 5 nm H4 / 25 nm H5:Yb / 120 nm Al. Thus, in these examples the emission layer has an overall thickness of 20 nm.

The organic electronic device was fabricated on a 1"x1" size glass substrate, pre-coated with a transparent ITO anode and a pixel definition layer (Geomatec). The substrates were loaded into an ultra-high vacuum evaporation tool operating at around 10⁻⁷ mbar pressure. Here, the organic layers were deposited onto the substrate in the sequence stated above. In the case of more than one material present in the layer, the layer is homogeneously mixed using a simultaneous coevaporation, with the intended mixing ratio achieved by setting the evaporation rates of each material accordingly. The device was finished by evaporating a 120 nm film of cathode Al. The Al deposition was carried out using a structured shadow mask, such that the resulting overlap of pre-structured ITO, organic layers and Al gave an active area of 3.88 mm². Subsequently, the finished devices were transferred to a nitrogen atmosphere glovebox and encapsulated by gluing an additional encapsulating glass substrate on top to prevent oxygen- and water-induced degradation. A liquid getter is dispensed onto the encapsulating glass substrate which absorbs moisture. The electrical and electroluminescent properties of the device were measured using an integrated OLED characterization setup M7000 (McScience inc.).

The HOMO, LUMO values and the S1 and T1 transition energies of materials contained in the EML layer are shown in **Table 1.** In the case of H1, H2, d01, d02, d29, and c01 the HOMO, LUMO values are taken from literature. The HOMO, LUMO, and S1 values for the MOHs were calculated using common quantum chemical DFT methods. The expected error margins for each value are ±0.2 eV.

The two optional organic host materials H1 and H2 both have HOMO and LUMO values such that the HOMO value is always the largest, and the LUMO is always smaller than the OEs used. This ensures that the exemplified energy level alignment between OEs and MOHs according to the present invention as defined above and as depicted in Figure 1 and 2 is not influenced by the presence of the optional organic host within the emission layer. For example, comparing the HOMO values for H1 and M24, it is evident that the HOMO value of M24 is smaller by 0.5 eV compared to H1. Similarly, comparing the values of H1 and d01, the LUMO value of H1 is smaller by 0.3 eV compared to d01. Both cases fall under case (a) of the present invention, as defined above, compare Figure 1 (a).

**Table 1: HOMO, LUMO, emission energy values of materials used in the devices**

| | HOMO, eV | LUMO, eV | S1, eV | T1, eV |
|---|---|---|---|---|
| **Optional Host** | | | | |
| H1 | 6.00 | 2.50 | 3.00 | >2.75 |
| H2 | 6.70 | 2.75 | 3.00 | >2.75 |
| **OEs** | | | | |
| d01 | 5.50 | 2.80 | 2.64 | 2.62 |
| d02 | 5.70 | 2.90 | 2.67 | 2.62 |
| d29 | 5.90 | 2.90 | 2.77 | 2.75 |
| c01 | 5.60 | 3.00 | 2.71 | <2.30 |

| **MOHs** | | | | |
|---|---|---|---|---|
| M36 | 5.00 | 2.20 | 2.75 | -- |
| M15 | 5.40 | 2.70 | 2.68 | -- |
| M24 | 5.50 | 2.72 | 2.66 | -- |
| e10-C | 5.25 | 1.96 | 3.10 | -- |
| e44 | 5.44 | 2.00 | 3.00 | -- |
| M31 | 5.40 | 2.88 | 2.58 | -- |
| M17 | 5.10 | 2.40 | 2.75 | -- |
| e46 | 4.72 | 1.34 | 3.10 | -- |

The relevant energetic level parameters of the devices and the respective materials used in each device are summarized in **Table 2.** The column "use" specifies whether it is a reference device "Ref." with an organic emitter, but no metal organic host, an example according to the invention "Acc" with metal organic host and organic emitter and both having energy levels according to the invention, or it is a comparative example "C. ex.", which still contains a metal organic host and an organic emitter as part of the emission, but the energy level arrangement is not according to the invention. The next column specifies the optional organic host, H1, or H1 according to the above definitions. The next column specifies the type of metal organic host, MOH, being present in the emission layer and its partial layer thickness. "M31, 2" means that the Europium metal organic host M31 (compare Figure 3) is present at a partial layer thickness of 2 nm. Because the overall emission layer thickness is always kept constant to be 20 nm, M31 is present within the emission layer of this specific device D14 at 10 vol%. The next column quotes the type of organic emitter, OE, that is used in the emission layer. The partial layer thickness of the organic emitter within the emission layer is always kept constant at d_{OE}=0.6nm. The total EML thickness, d, is kept constant at 20 nm. Thus, the partial thickness of the optional organic host (H1 and H2), d_{Host}, is d_{Host} = 20 - d_{MOH} - d_{OE}. In all devices exemplified, the partial thickness of the OE component, d_{OE}, is 0.6 nm, which corresponds to approximately 3 vol%.

The next three columns illuminate the energy difference between the exciplex formed between MOH and OE, S1_{OE} - EE_{EX}, as well as difference in hole transporting level HOMO, ΔHOMO, and electron transporting level LUMO, ΔLUMO, between the MOH and the OE of blends used in devices. Referring to Table 1, the ΔHOMO and ΔLUMO values are determined by taking the HOMO and LUMO values of the OEs and subtracting the HOMO and LUMO values of MOHs, respectively, for each device. For example, for device D9, metal organic host M17 with HOMO=5.1eV is combined with organic emitter d01 having a HOMO of 5.50eV. Subtracting the latter from the first one arrives at a ΔHOMO=0.4eV. Thus, the HOMO of M17 is shallower by 0.4eV as compared to the OE d01 and the hole will preferably reside on the metal organic host M17. The LUMO of M17 is 2.40eV and the LUMO of d01 is 2.80eV, thus ΔLUMO=0.4eV. The OE has a deeper LUMO as compared to the metal organic host and an electron on a LUMO will preferably residue on the organic emitter instead of the metal organic host, as required by the lowest electronically excited state within the emission layer EML, case (a), as defined above. The energy of the exciplex, EE_{EX}, is determined by subtracting the LUMO energy of the organic emitter (being the deepest LUMO in the emission layer), LUMO_{OE}, from the HOMO of the metal organic host, HOMO_{MOH} (being the shallowest HOMO in the emission layer). In case of example D9, M17_{HOMO} - d01_{LUMO} = 5.10-2.80eV = 2.3eV. The second to last column in table 2 below indicate whether the emission of the organic emitter is higher or lower as compared the exciplex: S1_{OE} - EE_{EX} values are determined by subtracting the EE_{EX} value of the respective material combination for a particular device from the S1 value of the respective OE. For example, in case of D9, S1_{OE} - EE_{EX} = 2.64-2.30 = 0.34eV. The final column in table 2 quotes the external quantum efficiencies (EQE) of the devices as 1 cd/m² in percent.

Devices D1-D4 serve as reference devices, (Ref.) which only have two components - the organic host and an OE. These devices are used to determine the EQE at 1 cd/m² of resulting from the OE alone in a particular optional organic host material, to serve as reference. Here, reference D1 using the green-blue emitting multiresonant emitter v-DABNA achieves 16.6% efficiency, a value typically found in literature too. Device D2 uses a second deep blue emitting multiresonant emitter, t-DANBA and its efficiency is only 8.5%, which again is a typical value. D3 is using a donor-acceptor type TADF emitter and D4 a perylene one with a high singlet triplet gap. D1-3 all use OEs with small singlet-to triplet energy gap.

According to the present invention as defined above, in case (a), the examples according to invention are thus reflected by the following parameter values:
1. S1_{OE} - EE_{EX} < 0.4 eV, more preferably < 0.3 eV, even more preferably < 0.2 eV.
2. ΔHOMO > 0.
3. ΔLUMO > 0.
4. T1_{OE} ≥ EE_{EX}.

From the requirements mentioned above, the first requirement ensures that the energy difference between the singlet emission energy of the organic emitter, OE, is larger than the energy of the exciplex formed between OE and the metal organic host, MOH. The exciplex formed between the two materials may act as a reservoir for excitations, with the S1_{OE} - EE_{EX} acting as an energetic barrier to be overcome to populate the emissive singlet state, S1, of the OE. The second requirement ensures that the HOMO value of the MOH is smaller than the HOMO value of the OE. If this case is fulfilled, it is assumed that the hole in the EML created during device operation is localized on the MOH. The third requirement ensures that the LUMO value of the MOH is smaller than the LUMO value of the OE. If this case is fulfilled, it is assumed that the electron in the EML created during device operation is localized on the OE. The fourth requirement ensures that the lowest excited triplet state of the OE is higher in energy than the exciplex energy. This ensures that the overall lowest excited state in the system is the exciplex state.

To exemplify the metal-organic host compound MOH of the present invention, seven MOHs are created, which cover a broad range of structural motifs. Using Ce3+, the materials are e10-c, e44, e46. Using Eu2+, the materials are M36, M15, M24, M31, M17. Of the Ce3+ MOHs, e44 has anions that are electrostatically bound, while e10-C and e46 feature covalently attached anions. Of the Eu2+ MOHs, M17 features covalently attached anions, while all other Eu2+ examples use electrostatically bound anions. The variety of MOHs used reflects the validity of the invention independent of a specific material combination.

Among the devices D5-D18 shown in Table 2 those are considered examples according to the present invention for which the parameter values stated above are fulfilled for each combination given. In those cases, the EQE of the device is larger than the equivalent parameter of the reference device using the same OE-only, selected from D1-D4. Thus, examples according to invention (Acc.) are devices D5, D6, D7, D9, D11, D14, D15, D16, D17. Counter examples (C. ex.) are devices D8, D10, D12, D13, D18.

For example, device D15 features the metal organic host, MOH, M24 and OE d02. From the values of Table 2, the EE_{EX} value for this device is HOMO_{MOH} - LUMO_{OE} = 2.6 eV and S1_{OE} - EE_{EX} value is 0.07 eV; it is smaller than 0.4eV as required according to the invention. As well, the ΔHOMO and ΔLUMO are calculated by taking the individual HOMO and LUMO values for d02 and M24, and subtracting them from each other, resulting in ΔHOMO and ΔLUMO of 0.2 eV and 0.18 eV, respectively. Therefore, an exciplex is preferably formed between the deepest LUMO residing on the OE and the shallowest HOMO residing on the MOH, according to the requirements of the present invention, case (a). Finally, the triplet energy of the organic emitter d02=2.62eV is higher or resonant with the energy of the exciplex EE_{EX} = 2.60eV. All above four requirements regarding the energy levels are fulfilled in parallel. Thus, device D15 is an example according to the present invention. The EQE of device D15 according to the present invention is 19.6 %. Comparing to D2, which has an EQE of 8.5 % at the same condition, device D15 shows an efficiency increase of a factor of 2.3. The absolute efficiency observed for this t-DABNA emitter, d02, of nearly 20% EQE is the highest ever observed until present to our knowledge or understanding; it is not an improvement starting from a low efficiency. Therefore, and without invoking or being bound to any (elaborate) theory, it is evident that the combination of the metal organic host having a non-zero spin with the organic emitter in an exciplex does substantially improve the efficiency of the device.

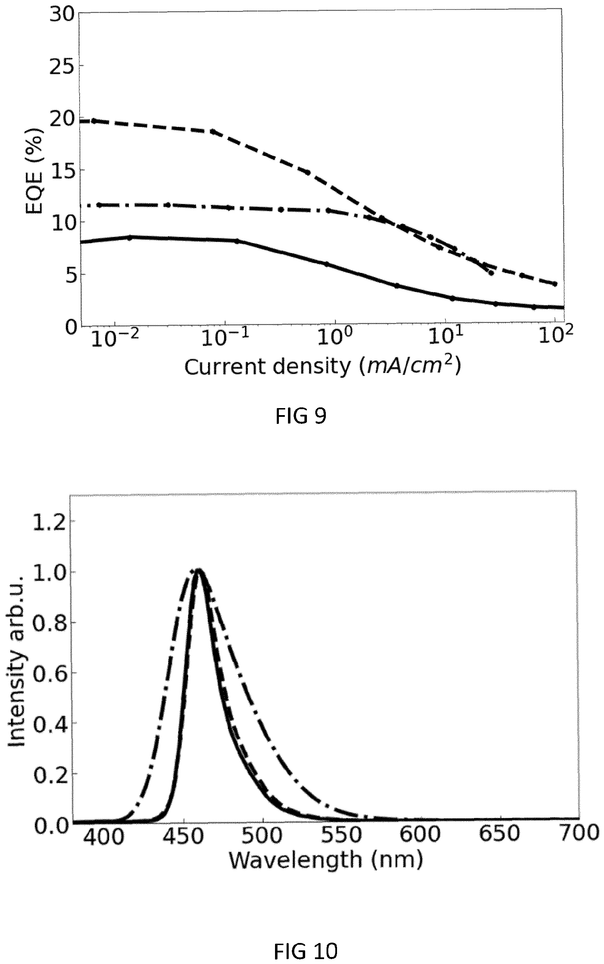

The efficiency (EQE) curves for D2, D15 and a device featuring M24-only in H1 are shown in **Figure 9****.** The corresponding electroluminescent spectra of the devices are shown in **Figure 10****.** In both figures the solid, dash-dot, and dashed lines correspond to device D2, M24-only in H1, and D15, respectively. From the curves depicted in Fig. 10 it is apparent, that the reference device D2 and the one with added MOH, D15 have exactly the same emission spectra, which is a clear indication that in both devices only the OE, d02, t-DABNA is emitting. The MOH alone, M24-only, has a distinguishably different emission from d02, in particular it is broader, in combination with d02, this broader emission is not visible. From Fig. 9, it is clearly seen that device D15 shows the highest efficiency of the three devices compared. In particular, the metal organic host alone has a significantly lower efficiency and the organic emitter alone has lower efficiency. Therefore, its only the combination of the MOH and the OE, having the right energy levels, that results in a record efficiency observed in this device D15.

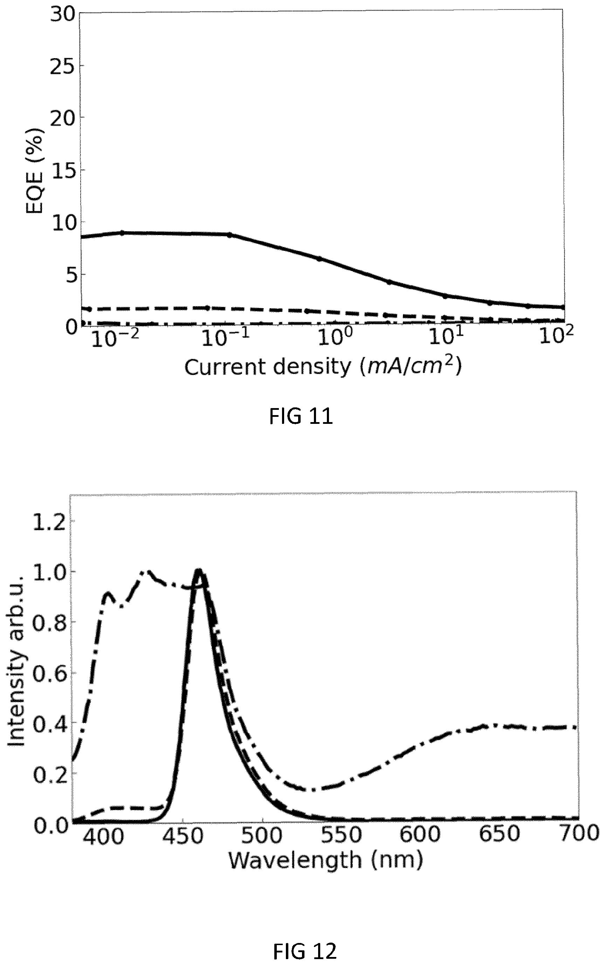

In detail explaining a further example, device D12 features the metal organic host, MOH, M36 combined with the organic emitter, OE, d02. From the values of Table 2, the EE_{EX} value for this device is HOMO_{MOH} - LUMO_{OE} = 2.1 eV and S1_{OE} - EE_{EX} value is 0.57 eV. Similarly, the ΔHOMO and ΔLUMO are calculated by taking the individual HOMO and LUMO values for d02 and M24, and subtracting them from each other, resulting in ΔHOMO and ΔLUMO of 0.7 eV and 0.7 eV, respectively. From the HOMO and LUMO values it becomes obvious that the exciplex between the MOH and the OE is indeed the lowest excited state within the emission layer. But the energy of the exciplex is much deeper as compared to the local singlet state of the organic emitter, i.e. 0.58 is higher than 0.4eV, being the requirement according to the invention. Thus, device D8 is a comparative example. Indeed, the efficiency of device D12, being 1.6%, is lowered by a factor of 5.3 compared to D2, 8.5%. Without invoking any elaborate theory, it is reasonable to assume, that the spin activated back transfer from the exciplex toward the local singlet state of the organic emitter is not possible anymore as the energy gap of nearly 0.6eV is too high. The efficiency curves for D2, D12 and a device featuring M36-only in H1 are shown in **Figure 11****.** The resulting electroluminescent emission spectra of the devices are shown in **Figure 12****.** In both figures the solid, dash-dot, and dashed lines correspond to device D12, D2 and M36-only in H1, respectively. From Fig. 11, it can be clearly seen that the efficiency of the reference device D2 is substantially reduced by adding the metal organic host M24.

Devices D10, D12, D13 all form an exciplex of the MOH with the OE for which the HOMO and LUMO requirements are well fulfilled. But they are comparative examples due to the energy requirement S1_{OE} - EE_{EX} < 0.4eV being not fulfilled. The resulting energy of the exciplex state is too low to effectively repopulate the local emissive singlet state S1 state of the OE, thus leading to non-radiative relaxation. In those comparative examples, the exciplex between MOH and OE is formed but efficiency is reduced relative to the reference devices having no MOH.

For device D8 the LUMO energy difference is not according to the requirements of the present invention, therefore the exciplex between the MOH and the OE is not formed. The excitation is directly formed on the MOH, and no significant enhancement, but as well no significant quenching, relative to the reference device having no MOH (D1) is observed. D8 serves as a comparative example due to the third requirement (the LUMO of the OE is not the globally lowest LUMO within the emission layer), as stated above, not being fulfilled. The resulting excited state is fully localized on the MOH in this case, and no exciplex state is formed.

In device D18 the first three requirements are well fulfilled, and the exciplex between MOH and OE is formed. In particular, the energy offset between exciplex and locally excited emissive singlet state, S1 of OE is only 0.28 as required by this invention. However, in this example the energy of the locally excited triplet state of the OE, T1, is well below the energy of the exciplex energy, which makes this device a comparative example due to the fourth requirement not being fulfilled. As a result, the lowest excited state in the system is the locally excited triplet state of the OE c01, depopulating the exciplex state. Consequently, the efficiency of the reference device D4 is significantly reduced by addition of the metal organic host, i.e. from 4.1% to 2.5%.

Finally, devices D6 and D7 serve as examples according to the present invention, although the calculated T1_{OE} - EE_{EX} and S1_{OE} - EE_{EX} parameters do not satisfy the conditions outlined for the emission layer EML, case (a), as defined above, exactly. However, the EQE values for both devices are larger, comparing to D1, thus suggesting that the efficiency enhancement takes place. This may be explained by considering the error margins of the energy values given in Table 1. The parameter T1_{OE} - EE_{EX} and S1_{OE} - EE_{EX} values for both devices D6 and D7 are well below the error margins expected.

Form all the experimental evidence it is reasonable to deduce that if the metal organic hosts interact with the organic emitter within an exciplex that spin-active intersystem crossing of the locally excited singlet and triplet states of the organic emitter is induced. The coupling of the exciplex to the local singlet of the organic emitter should lower its singlet excited decay time, because the exciplex energy is lower as compared to the singlet energy. At the same time, and if the energy offsets are chosen correctly, the exciplex energy should feed back to the locally excited singlet state at later times, given rise to a delayed luminescence component. In order to gain insight into the excited state dynamics of the blends used in the devices, thin films were fabricated and characterized by way of time-correlated single photon counting, using an excitation wavelength of 295 nm. The films had a total thickness of 50 nm. The partial layer thicknesses were 1.5 nm for d02, 5 nm for M24. The three films fabricated had the following composition: H6:d02, H6:M24, H6:M24:d02. The partial layer thickness was 48.5, 45 and 43.5 for H6, respectively. The sample H6:M24:d02 features a combination of M24 and d02 with the same ratio as in device D15.

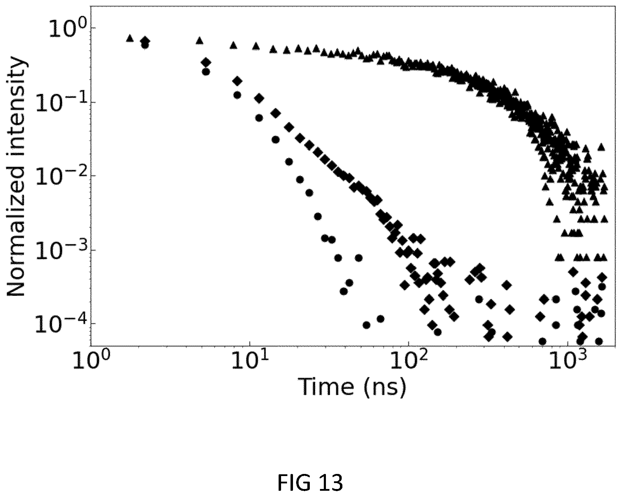

The resulting excited state decay curves are shown in **Figure 13****.** The triangle curve shows the H6:M24 film, which features a long-lived (few 100ns) monoexponentially decaying excited state, attributed to emission from the europium metal organic host M24, and its excited state decay time is consistent with values found in literature. The circle curve shows the H6:d02 film, of which only the prompt fluorescent component is obtained. The excited state lifetime in the nanosecond region. The diamond curve shows the mixed H6:M24:d02 sample. The emission spectrum of this sample exactly resembles that of the sample of H6:d02. In other words, only emission of the organic emitter d02 is observed, but not from the metal organic host M24. Yet, intriguingly adding the MOH m24 does lead to the appearance of a new component in the excited state decay of d02. In particular, the decay lifetime in the first 10 ns, compared to d02 alone, is significantly increased. Without going into elaborate theory or being bound by any theory, this appearing component is understood to be the result of the repopulation of the S1 state of d02, stemming from the exciplex reservoir. It is expected that the excited state dynamics observed here are also prevalent in the device, such that the new pathway for repopulating the singlet state of the OE is responsible for the EQE enhancement observed in the examples according to invention. The repopulation mechanism is like thermally activated delayed fluorescence (TADF), save the fact that the intersystem crossing, i.e. the mixing of singlet and triplet excitation is not mediated by temperature alone, but by external spin mixing.

**Table 2. Device number, its use, device EML comprising parts (material, partial thickness), ΔHOMO, ΔLUMO values of blends used in devices, EE_{EX}, T1_{OE} - EE_{EX}, S1_{OE} - EE_{EX} of each mixture, EQE values at 1 cd/m²**

| Device | Use | Host | MOH, nm | OE, 0.6 nm | ΔHOMO, eV | ΔLUMO, eV | EE_{EX}, eV | T1_{OE} - EE_{EX}, eV | S1_{OE} - EE_{EX}, eV | EQE, % |
|---|---|---|---|---|---|---|---|---|---|---|
| D1 | Ref. | H1 | -- | d01 | -- | -- | | | -- | 16.6 |
| D2 | Ref. | H1 | -- | d02 | -- | -- | | | -- | 8.5 |
| D3 | Ref. | H1 | -- | d29 | -- | -- | | | -- | 2.4 |
| D4 | Ref. | H1 | -- | c01 | -- | -- | | | -- | 4.1 |
| D5 | Acc. | H1 | M15,6 | d01 | 0.10 | 0.10 | 2.60 | 0.02 | 0.04 | 23.8 |
| D6 | Acc. | H1 | M24, 6 | d01 | 0 | 0.08 | 2.70 | -0.08 | -0.06 | 24.6 |
| D7 | Acc. | H1 | e44, 1 | d01 | 0.06 | 0.80 | 2.64 | -0.02 | 0 | 19.9 |
| D8 | C. ex. | H1 | M31, 2 | d01 | 0.10 | -0.08 | 2.60 | 0.02 | 0.04 | 14.4 |
| D9 | Acc. | H1 | M17,2 | d01 | 0.40 | 0.40 | 2.30 | 0.32 | 0.34 | 25.4 |
| D10 | C. ex. | H1 | e46, 2 | d01 | 0.78 | 1.46 | 1.92 | 0.70 | 0.72 | 4.3 |
| D11 | Acc. | H1 | e10-C, 2 | d02 | 0.45 | 0.94 | 2.35 | 0.27 | 0.32 | 13.2 |
| D12 | C. ex. | H1 | M36, 2 | d02 | 0.70 | 0.70 | 2.10 | 0.52 | 0.57 | 1.6 |
| D13 | C. ex. | H1 | e46, 2 | d02 | 0.98 | 1.56 | 1.82 | 0.80 | 0.85 | 5.4 |
| D14 | Acc. | H1 | M31, 2 | d02 | 0.30 | 0.02 | 2.50 | 0.12 | 0.17 | 17.8 |
| D15 | Acc. | H1 | M24, 2 | d02 | 0.20 | 0.18 | 2.60 | 0.02 | 0.07 | 19.6 |
| D16 | Acc. | H1 | e44, 2 | d02 | 0.26 | 0.90 | 2.54 | 0.08 | 0.13 | 18.3 |
| D17 | Acc. | H1 | M24, 2 | d29 | 0.40 | 0.18 | 2.60 | 0.15 | 0.17 | 4.7 |
| D18 | C. ex. | H2 | M24, 2 | c01 | 0.10 | 0.28 | 2.5 | <-0.20 | 0.21 | 2.5 |

The following are preferred embodiments of the invention. The respective features can be freely combined with each other without departing from the present invention.
1. An organic electroluminescent device comprising:
   a first electrode,
   a second electrode, and
   an organic emission layer EML disposed between the first electrode and the second electrode, the organic emission layer comprising:
      ▪ at least one, preferably one metal-organic host compound MOH, and
      ▪ at least one, preferably one organic emitter compound OE, and
      ▪ optionally one or more further organic host compounds, with
         - the metal-organic host compound MOH having a total spin of ≥1/2 and/or possessing one or more unpaired electrons,
         - the lowest electronically excited state within the emission layer EML being an exciplex EX_{MOH/OE} formed by a single electron transfer between the MOH and the OE, preferably by
            (c) the energy of the highest occupied molecular orbital HOMO of the neutral metal-organic host compound HOMO_{MOH} being the highest energy HOMO of all materials present within the EML and the energy of the lowest unoccupied molecular orbital LUMO of the organic emitter compound LUMO_{OE} being the lowest energy LUMO of all materials present within the EML or
            (d) the energy of the lowest unoccupied molecular orbital LUMO of the neutral metal-organic host compound LUMO_{MOH} being the lowest energy LUMO of all materials present within the EML and the HOMO energy of the organic emitter HOMO_{OE} being the highest HOMO of all materials present within the EML,
         - the energy of the first excited triplet state of the organic emitter T1_{OE} being resonant or higher as compared to the energy of the Exciplex EE_{EX}: T1_{OE} ≥ EE_{EX},
         - the energy difference of the emitting first excited singlet state S1_{OE} and the energy of the exciplex being less than 0.4 eV, preferably less than 0.3 eV, more preferably less than 0.2 eV: S1_{OE} - EE_{EX} ≤ 0.4eV, preferably ≤ 0.3eV, more preferably ≤ 0.2eV.
2. The electroluminescent device of embodiment 1, with the first excited singlet state S1_{OE}, and/or the peak emission energy of the organic emitter from the first excited singlet state being >2.6 eV, preferably >2.65 eV.
3. The electroluminescent device of embodiment 1 or 2, with the metal organic host having a higher emission energy EE_{MOH} as compared to the emissive state of the organic emitter S1_{OE}: EE_{MOH} > S1_{OE}.
4. The electroluminescent device of one of embodiments 1 to 3, with the organic emitter
   - comprising a plurality of fused aryl and/or heteroaryl groups,
   - preferably comprising at least one boron atom,
   - preferably with the ratio of emitting dipoles parallel to the substrate plane being >66%, preferably >80%, more preferably >90% with the sum of vertical and parallel emission dipoles being 100%.
5. The electroluminescent device of one of embodiments 1 to 4, with the organic emitter compound OE being a multiresonant emitter conforms to any of the generic formulae (D-1) to (D-4): 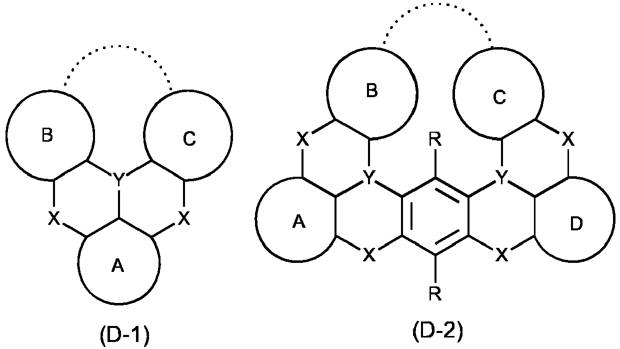 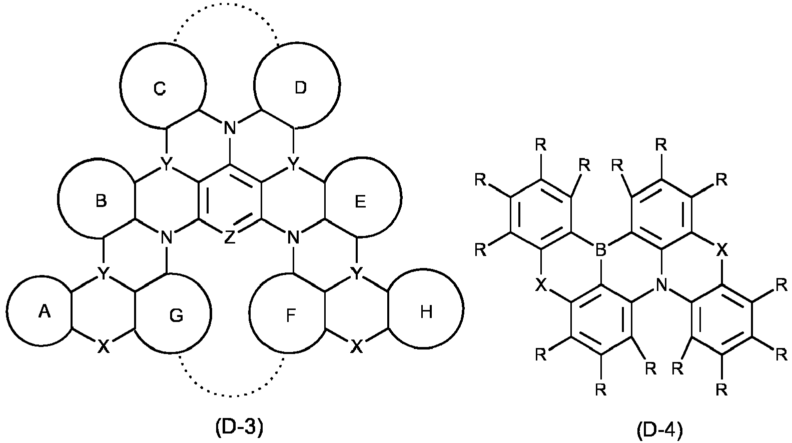 with,
   - ring A, B, C, D, E, F, G, and H being each independently a substituted or unsubstituted aryl ring, or a substituted or unsubstituted heteroaryl ring, or a substituted or unsubstituted aliphatic ring, and
   - a broken line connecting the B ring and the C ring in the formulae (D-1) or (D-2) and the broken lines connecting the C ring and the D ring and the G ring and the F ring in the formula (D-3) indicate that those rings are bonded or not, through a single bond or linking group at one of the available ring positions each and
   - Z is CR₂ or NR, and
   - X is each independently a single bond, NR, O, CR2, SiR2, S, or Se, and
   - Y is each independently B, P, P(=O), P(=S), Al, Ga, As, CR, SiR, or GeR, preferably B, and
   - R groups are each independently hydrogen, deuterium, halogen, aryl, heteroaryl, diarylamino, diarylboryl, alkyl, cycloalkyl, alkoxy or aryloxy, and adjacent R groups may be bonded to each other to form an aryl ring or heteroaryl ring.
6. The electroluminescent device of one of embodiments 1 to 5, with the organic emitter compound OE being selected from d01 to d12: 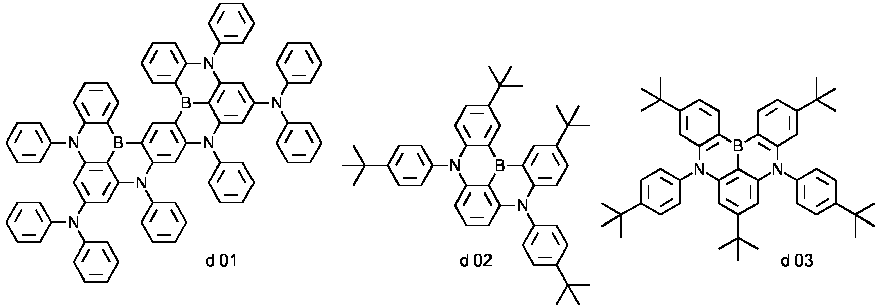 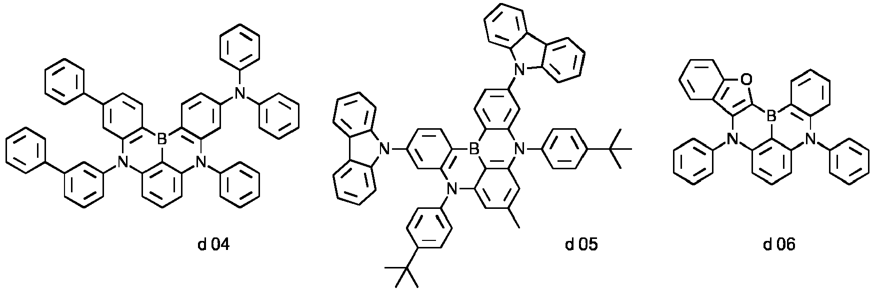 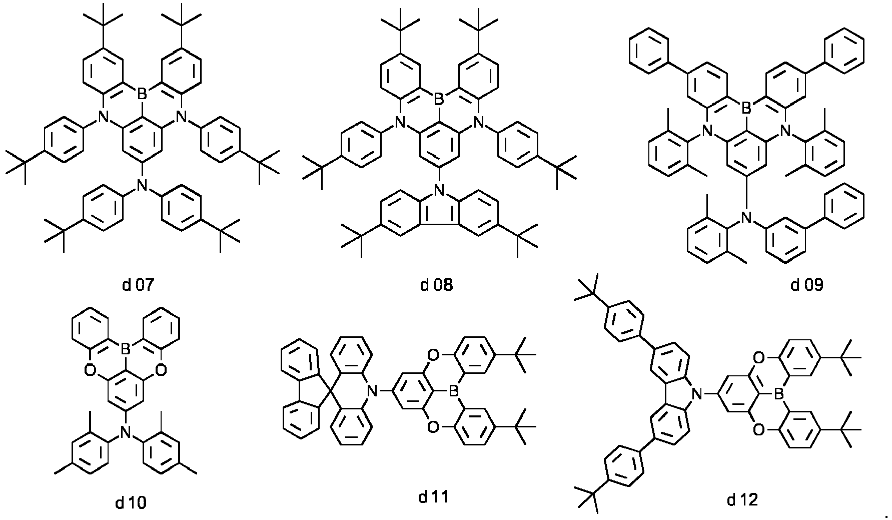
7. The electroluminescent device of one of embodiments 1 to 6, with the metal-organic host material MOH comprising at least one metal cation selected from Gd(III), Ce(III), and Eu(II).
8. The electroluminescent device of one of embodiments 1 to 7, with the metal organic host compound MOH, comprising one or more building blocks selected from CT-1 to CT-22: 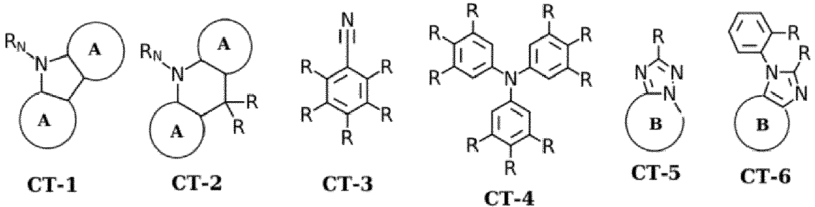 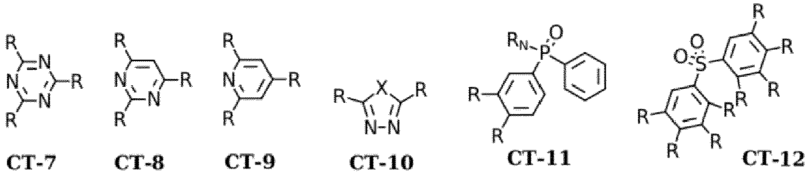 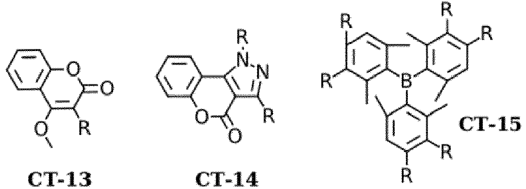 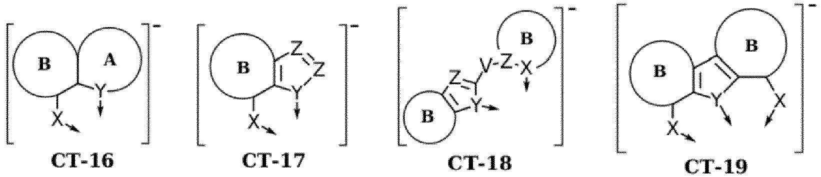 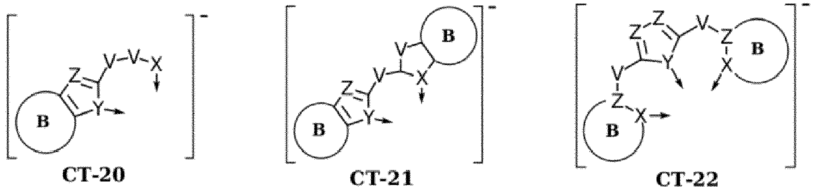 with
   - arrows indicating a preferential coordination towards the metal center of the metal organic host compound MOH,
   - X being independently in each occurrence a monovalent group selected from -OR, - SR, -NR2, -PR2,
   - V being independently in each occurrence a divalent group selected from -O-, -S-, - NR-, -PR-, -CR2-, -SiR2-,
   - **Y** being independently in each occurrence selected from N, or P,
   - **Z** being independently in each occurrence selected from N, P, CR, SiR,
   - **R** independently in each occurrence representing a monovalent organic group formed by removing a hydrogen atom from an organic molecule having at least one hydrogen, H, D, or halogen and **R_{N}** independently in each occurrence representing a monovalent organic group formed by removing a hydrogen atom from an organic molecule having at least one hydrogen , and

   - **A** being independently in each occurrence a substituted or unsubstituted aryl ring, or a substituted or unsubstituted heteroaryl ring, or a substituted or unsubstituted aliphatic ring, and **B** being independently in each occurrence a substituted or unsubstituted aryl ring, or a substituted or unsubstituted heteroaryl ring, or a substituted or unsubstituted aliphatic ring or **B** representing no cyclic group, but instead the atoms being connected to B are saturated by H, or any organyl group R as defined above.
9. The electroluminescent device according to one of embodiments 1 to 8, with the sum of the organic emitter compound OE concentration and the metal organic host compound MOH concentration being >20vol%, preferably >50vol%, or essentially no other material apart from the metal organic host compound MOH and the organic emitter compound OE being present within the organic emission layer EML, or with the sum of the organic emitter compound OE concentration and the metal organic host compound MOH concentration being 100%, and/or with the volume concentration of the metal organic host compound MOH being at least 5 times, preferably at least 10 times and more preferably at least 15 times higher than the concentration of the organic emitter sompound OE.
10. The electroluminescent device according to one of embodiments 1 to 9, with the metal organic host compound MOH being present in two or more organic layers and/or with the metal organic host compound MOHI being present in all organic layers between the organic emission layer and one of the electrodes and / or with metal organic host compound MOH being present as part of the hole injection layer in contact with the anode and being partly or completely oxidized into a cationic state by means of a suitable dopant material being present as part of the hole injection layer.
11. The electroluminescent device according to one of embodiments 1 to 10, with the metal organic host compound MOH comprising a macrocyclic or polymacrocyclic organic ligand with at least one of these ligands being described by the generic formula (1-1): 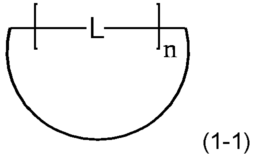 with
   - **n** being 4 to 8, preferably 4 to 6; and
   - **L** being independently in each occurrence a divalent organic group formed by removing two hydrogen atoms from an organic molecule having at least two hydrogens, with
   - the shortest sequence of atoms linking each L with the remainder of the cyclic ligand being 3 to 5, preferably 3 atoms, and with
   - one of those 3 to 5, preferably 3 atoms independently for each L being selected from N, P, S, Se, or O, preferably N, or O.
12. The electroluminescent device according to one of embodiments 1 to 11, with the metal-organic host compound MOH containing a single organic ligand and a single metal cation, preferably a metal cation of oxidation stage +2 or +3 in combination with a single two- or threefold electrically negatively charged organic ligand, such that the combination of the single organic ligand with the single metal cation forms a complex of neutral electrical charge.
13. The electroluminescent device according to one of embodiments 1 to 11, with the organic emission layer comprising at least one charge neutral organic host material at a concentration of >1vol%, preferably >10%, and more preferably >30%, based on the overall composition of the organic emission layer EML which is 100 vol%, with the host material preferably configured to transport electrons and/or holes and/or having a triplet energy higher than the singlet energy of the organic emitter compound OE, preferably with the HOMO energy of said neutral organic host material being 0.3 eV or less lower than that of the metal organic host compound in case the energy of the highest occupied molecular orbital HOMO of the neutral metal-organic host compound HOMO_{MOH} being the highest energy HOMO of all materials present within the EML and the energy of the lowest unoccupied molecular orbital LUMO of the organic emitter compound LUMO_{OE} being the lowest energy LUMO of all materials present within the EML, or preferably with the difference with the LUMO energy of said neutral organic host material being 0.3 eV or less shallower as compared to the metal organic host compound in case the energy of the lowest unoccupied molecular orbital LUMO of the neutral metal-organic host compound LUMO_{MOH} being the lowest energy LUMO of all materials present within the EML and the HOMO energy of the organic emitter HOMO_{OE} being the highest HOMO of all materials present within the EM L.
14. A charge neutral metal organic coordination compound according to formula (2-1): **with CB₁₁⁻ being selected from a5 or a6:** 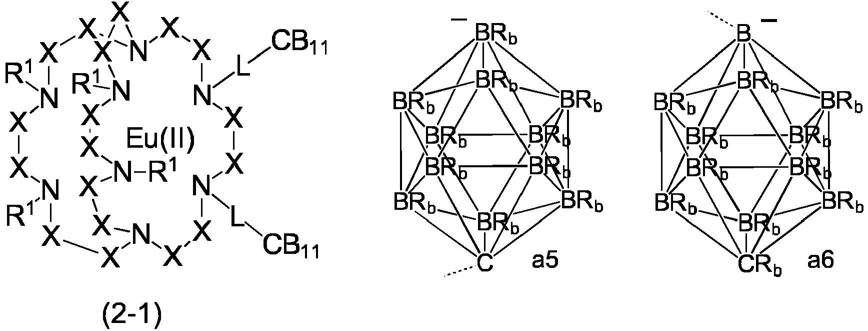 wherein
   - **R¹** is each individually selected from H, D, alkyl groups or aryl groups, preferably alkyl, more preferably methyl,
   - **X** is CR²₂ with R² being independently in each occurrence selected from H, D, halogen, or a monovalent organic group formed by removing one hydrogen atom from an organic molecule having at least one hydrogen, preferably H, D, halogen, alkyl, heteroalkyl, aryl or heteroalryl groups, more preferably H, or D and where two instances of R² present on the same or different carbon atoms can fuse and with
   - L is in both instances being a divalent organic group formed by removing two hydrogen atoms from an organic molecule having at least two hydrogens, preferably alkylen, alkyleneoxy, more preferably propylene, or ethyleneoxy and with
   - **CB₁₁⁻** in both instances being a closo-carborate anion according to formulae a5 or a6 with
      o the dashed lines indicating the covalent linkage to L, and **R_{b}** present in a5 and a6 independently in each occurrence represents H, D, halogen, or any monovalent organic group formed by removing a hydrogen atom from an organic molecule having at least one hydrogen, preferably **R_{b}** is H, or methyl.
15. A composition for forming an organic emission layer EML in an organic electroluminescent device, comprising:
   ▪ at least one, preferably one metal-organic host compound MOH, and
   ▪ at least one, preferably one organic emitter compound OE, and
   ▪ optionally one or more further organic host compounds, with
      • the metal-organic host compound MOH having a total spin of ≥1/2 and/or possessing one or more unpaired electrons,
      • the lowest electronically excited state within the emission layer EML being an exciplex EX_{MOH/OE} formed by a single electron transfer between the MOH and the OE, preferably by
         (e) the energy of the highest occupied molecular orbital HOMO of the neutral metal-organic host compound HOMO_{MOH} being the highest energy HOMO of all materials present within the EML and the energy of the lowest unoccupied molecular orbital LUMO of the organic emitter compound LUMO_{OE} being the lowest energy LUMO of all materials present within the EML or
         (f) the energy of the lowest unoccupied molecular orbital LUMO of the neutral metal-organic host compound LUMO_{MOH} being the lowest energy LUMO of all materials present within the EML and the HOMO energy of the organic emitter HOMO_{OE} being the highest HOMO of all materials present within the EML,
      • the energy of the first excited triplet state of the organic emitter T1_{OE} being resonant or higher as compared to the energy of the Exciplex EE_{EX}: T1_{OE} ≥ EE_{EX},
      • the energy difference of the emitting first excited singlet state S1_{OE} and the energy of the exciplex being less than 0.4 eV, preferably less than 0.3 eV, more preferably less than 0.2 eV: S1_{OE} - EE_{EX} ≤ 0.4eV, preferably ≤ 0.3eV, more preferably ≤ 0.2eV,
      • preferably the organic emission layer EML being defined as in one of embodiments 2 to 13.
16. The electroluminescent device according to one of embodiments 1 to 13, which is an OLED device or part of an OLED device.
17. A method for forming the electroluminescent device according to one of embodiments 1 to 13 or 16, which includes depositing the organic emission layer EML between the first electrode and the second electrode, preferably by vapour deposition techniques.
18. The use of the organic emission layer EML according to embodiments 15 in an organic electroluminescent.
19. An OLED device, comprising the electroluminescent device according to one of embodiments 1 to 13 or 16, which is a flat screen, laptop computer, TV set, consumer electronic device, video and/or stills camera, tablet or smartphone.

## Claims

1. An organic electroluminescent device comprising:
a first electrode,
a second electrode, and
an organic emission layer EML disposed between the first electrode and the second electrode, the organic emission layer comprising:
▪ at least one, preferably one metal-organic host compound MOH, and
▪ at least one, preferably one organic emitter compound OE, and
▪ optionally one or more further organic host compounds, with
• the metal-organic host compound MOH having a total spin of ≥1/2 and/or possessing one or more unpaired electrons,
• the lowest electronically excited state within the emission layer EML being an exciplex EX_{MOH/OE} formed by a single electron transfer between the MOH and the OE, preferably by
(g) the energy of the highest occupied molecular orbital HOMO of the neutral metal-organic host compound HOMO_{MOH} being the highest energy HOMO of all materials present within the EML and the energy of the lowest unoccupied molecular orbital LUMO of the organic emitter compound LUMO_{OE} being the lowest energy LUMO of all materials present within the EML or
(h) the energy of the lowest unoccupied molecular orbital LUMO of the neutral metal-organic host compound LUMO_{MOH} being the lowest energy LUMO of all materials present within the EML and the HOMO energy of the organic emitter HOMO_{OE} being the highest HOMO of all materials present within the EML,
• the energy of the first excited triplet state of the organic emitter T1_{OE} being resonant or higher as compared to the energy of the Exciplex EE_{EX}: T1_{OE} ≥ EE_{EX},
• the energy difference of the emitting first excited singlet state S1_{OE} and the energy of the exciplex being less than 0.4 eV, preferably less than 0.3 eV, more preferably less than 0.2 eV: S1_{OE} - EE_{EX} ≤ 0.4eV, preferably ≤ 0.3eV, more preferably ≤ 0.2eV.

2. The electroluminescent device of claim 1, with the first excited singlet state S1_{OE}, and/or the peak emission energy of the organic emitter from the first excited singlet state being >2.6 eV, preferably >2.65 eV.

3. The electroluminescent device of claim 1 or 2, with the metal organic host having a higher emission energy EE_{MOH} as compared to the emissive state of the organic emitter S1_{OE}: EE_{MOH} > S1_{OE}.

4. The electroluminescent device of one of claims 1 to 3, with the organic emitter - comprising a plurality of fused aryl and/or heteroaryl groups,
- preferably comprising at least one boron atom,
- preferably with the ratio of emitting dipoles parallel to the substrate plane being >66%, preferably >80%, more preferably >90% with the sum of vertical and parallel emission dipoles being 100%.

5. The electroluminescent device of one of claims 1 to 4, with the organic emitter compound OE being a multiresonant emitter conforms to any of the generic formulae (D-1) to (D-4): 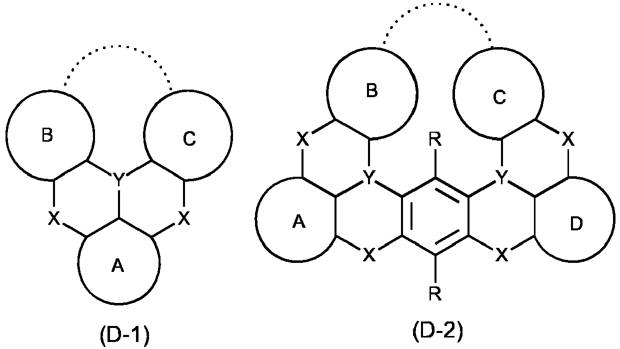 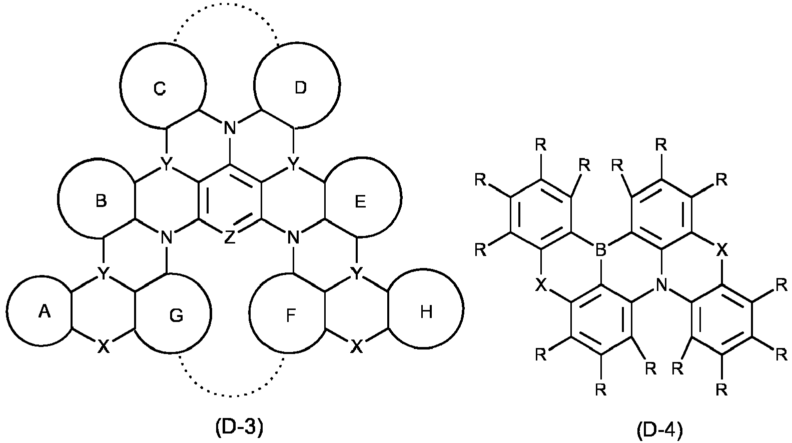 with,
- ring **A, B, C, D, E, F, G,** and **H** being each independently a substituted or unsubstituted aryl ring, or a substituted or unsubstituted heteroaryl ring, or a substituted or unsubstituted aliphatic ring, and
- a **broken line** connecting the B ring and the C ring in the formulae (D-1) or (D-2) and the broken lines connecting the C ring and the D ring and the G ring and the F ring in the formula (D-3) indicate that those rings are bonded ,or not, through a single bond or linking group at one of the available ring positions each and
- **Z** is CR₂ or NR, and
- **X** is each independently a single bond, NR, O, CR2, SiR2, S, or Se, and
- **Y** is each independently B, P, P(=O), P(=S), Al, Ga, As, CR, SiR, or GeR, preferably B, and
- **R** groups are each independently hydrogen, deuterium, halogen, aryl, heteroaryl, diarylamino, diarylboryl, alkyl, cycloalkyl, alkoxy or aryloxy, and adjacent R groups may be bonded to each other to form an aryl ring or heteroaryl ring.

6. The electroluminescent device of one of claims 1 to 5, with the organic emitter compound OE being selected from d01 to d12:

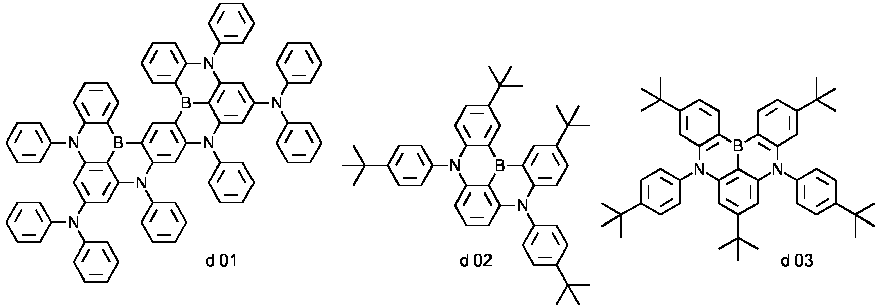

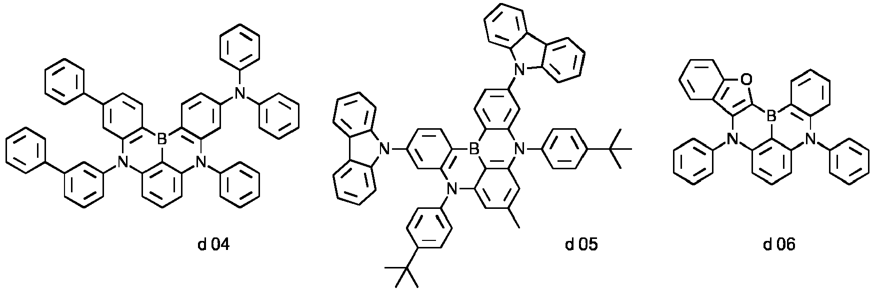

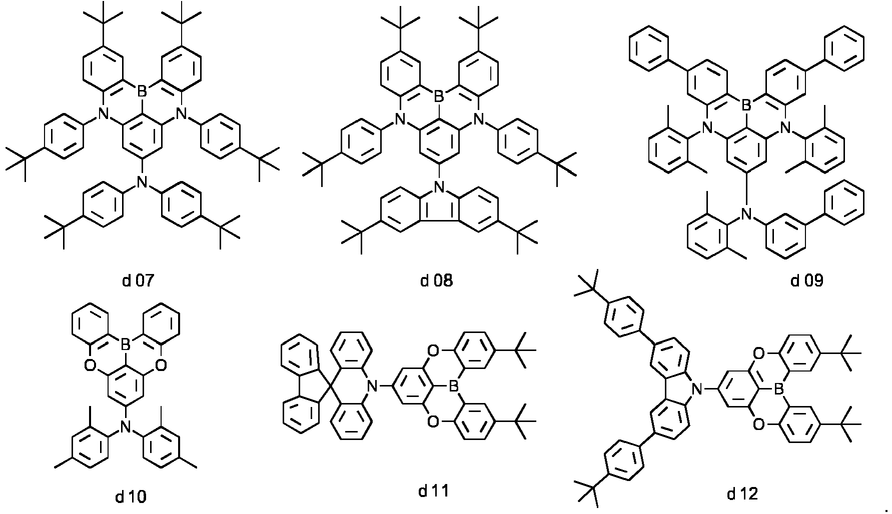

7. The electroluminescent device of one of claims 1 to 6, with the metal-organic host material MOH comprising at least one metal cation selected from Gd(III), Ce(III), and Eu(II).

8. The electroluminescent device of one of claims 1 to 7, with the metal organic host compound MOH, comprising one or more building blocks selected from CT-1 to CT-22: 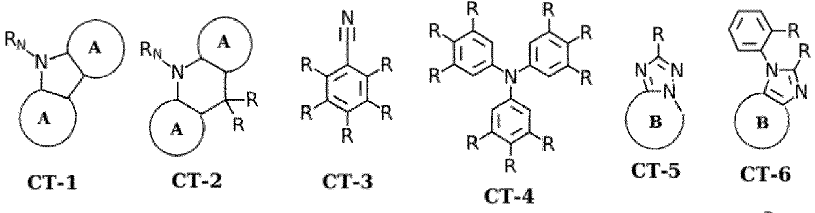 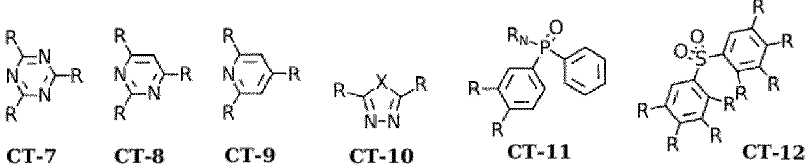 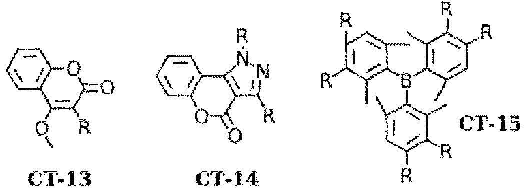 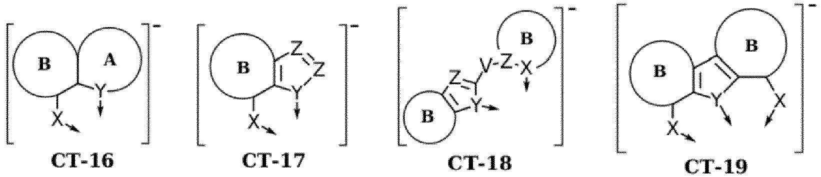 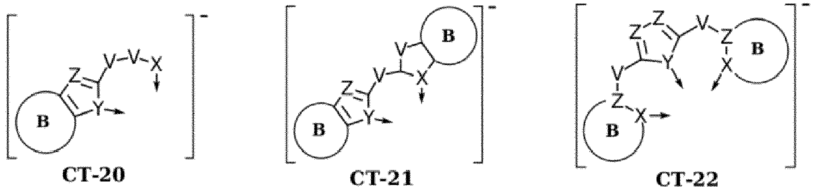 with
• arrows indicating a preferential coordination towards the metal center of the metal organic host compound MOH,
• X being independently in each occurrence a monovalent group selected from -OR, - S**R**, -N**R**2, -P**R**2,
• V being independently in each occurrence a divalent group selected from -O-, -S-, - N**R**-, -P**R**-, -C**R**2-, -Si**R**2-,
• **Y** being independently in each occurrence selected from N, or P,
• **Z** being independently in each occurrence selected from N, P, CR, SiR,
• **R** independently in each occurrence representing a monovalent organic group formed by removing a hydrogen atom from an organic molecule having at least one hydrogen, H, D, or halogen and **R_{N}** independently in each occurrence representing a monovalent organic group formed by removing a hydrogen atom from an organic molecule having at least one hydrogen , and
• **A** being independently in each occurrence a substituted or unsubstituted aryl ring, or a substituted or unsubstituted heteroaryl ring, or a substituted or unsubstituted aliphatic ring, and **B** being independently in each occurrence a substituted or unsubstituted aryl ring, or a substituted or unsubstituted heteroaryl ring, or a substituted or unsubstituted aliphatic ring or **B** representing no cyclic group, but instead the atoms being connected to B are saturated by H, or any organyl group R as defined above.

9. The electroluminescent device according to one of claims 1 to 8, with the sum of the organic emitter compound OE concentration and the metal organic host compound MOH concentration being >20vol%, preferably >50vol%, or essentially no other material apart from the metal organic host compound MOH and the organic emitter compound OE being present within the organic emission layer EML, or with the sum of the organic emitter compound OE concentration and the metal organic host compound MOH concentration being 100%, and/or with the volume concentration of the metal organic host compound MOH being at least 5 times, preferably at least 10 times and more preferably at least 15 times higher than the concentration of the organic emitter sompound OE.

10. The electroluminescent device according to one of claims 1 to 9, with the metal organic host compound MOH being present in two or more organic layers and/or with the metal organic host compound MOH being present in all organic layers between the organic emission layer and one of the electrodes and/or with metal organic host compound MOH being present as part of the hole injection layer in contact with the anode and being partly or completely oxidized into a cationic state by means of a suitable dopant material being present as part of the hole injection layer.

11. The electroluminescent device according to one of claims 1 to 10, with the metal organic host compound MOH comprising a macrocyclic or polymacrocyclic organic ligand with at least one of these ligands being described by the generic formula (1-1): 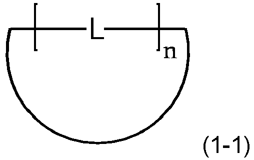 with
• n being 4 to 8, preferably 4 to 6; and
• L being independently in each occurrence a divalent organic group formed by removing two hydrogen atoms from an organic molecule having at least two hydrogens, with
• the shortest sequence of atoms linking each L with the remainder of the cyclic ligand being 3 to 5, preferably 3 atoms, and with
• one of those 3 to 5, preferably 3 atoms independently for each L being selected from N, P, S, Se, or O, preferably N, or O.

12. The electroluminescent device according to one of claims 1 to 11, with the metal-organic host compound MOH containing a single organic ligand and a single metal cation, preferably a metal cation of oxidation stage +2 or +3 in combination with a single two- or threefold electrically negatively charged organic ligand, such that the combination of the single organic ligand with the single metal cation forms a complex of neutral electrical charge.

13. The electroluminescent device according to one of claims 1 to 11, with the organic emission layer comprising at least one charge neutral organic host material at a concentration of >1vol%, preferably >10%, and more preferably >30%, based on the overall composition of the organic emission layer EML which is 100 vol%, with the host material preferably configured to transport electrons and/or holes and/or having a triplet energy higher than the singlet energy of the organic emitter compound OE, preferably with the HOMO energy of said neutral organic host material being 0.3 eV or less lower than that of the metal organic host compound in case the energy of the highest occupied molecular orbital HOMO of the neutral metal-organic host compound HOMO_{MOH} being the highest energy HOMO of all materials present within the EML and the energy of the lowest unoccupied molecular orbital LUMO of the organic emitter compound LUMO_{OE} being the lowest energy LUMO of all materials present within the EML, or preferably with the difference with the LUMO energy of said neutral organic host material being 0.3 eV or less shallower as compared to the metal organic host compound in case the energy of the lowest unoccupied molecular orbital LUMO of the neutral metal-organic host compound LUMO_{MOH} being the lowest energy LUMO of all materials present within the EML and the HOMO energy of the organic emitter HOMO_{OE} being the highest HOMO of all materials present within the EM L.

14. A charge neutral metal organic coordination compound according to formula (2-1): with CB₁₁⁻ being selected from a5 or a6: 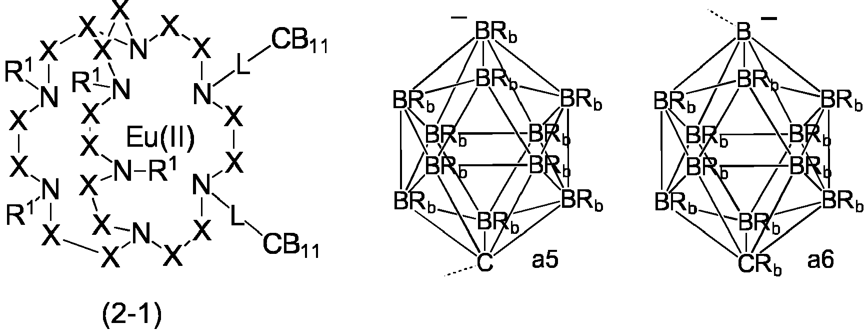 wherein
• **R¹** is each individually selected from H, D, alkyl groups or aryl groups, preferably alkyl, more preferably methyl,
• **X** is CR²₂ with R² being independently in each occurrence selected from H, D, halogen, or a monovalent organic group formed by removing one hydrogen atom from an organic molecule having at least one hydrogen, preferably H, D, halogen, alkyl, heteroalkyl, aryl or heteroalryl groups, more preferably H, or D and where two instances of R² present on the same or different carbon atoms can fuse and with
• **L** is in both instances being a divalent organic group formed by removing two hydrogen atoms from an organic molecule having at least two hydrogens, preferably alkylen, alkyleneoxy, more preferably propylene, or ethyleneoxy and with
• **CB₁₁⁻** in both instances being a closo-carborate anion according to formulae a5 or a6 with
∘ the dashed lines indicating the covalent linkage to L, and **R_{b}** present in a5 and a6 independently in each occurrence represents H, D, halogen, or any monovalent organic group formed by removing a hydrogen atom from an organic molecule having at least one hydrogen, preferably **R_{b}** is H, or methyl.

15. An organic emission layer EML composition for an organic electroluminescent device, comprising:
▪ at least one, preferably one metal-organic host compound MOH, and
▪ at least one, preferably one organic emitter compound OE, and
▪ optionally one or more further organic host compounds,
with
• the metal-organic host compound MOH having a total spin of ≥1/2 and/or possessing one or more unpaired electrons,
• the lowest electronically excited state within the emission layer EML being an exciplex EX_{MOH/OE} formed by a single electron transfer between the MOH and the OE, preferably by
(i) the energy of the highest occupied molecular orbital HOMO of the neutral metal-organic host compound HOMO_{MOH} being the highest energy HOMO of all materials present within the EML and the energy of the lowest unoccupied molecular orbital LUMO of the organic emitter compound LUMO_{OE} being the lowest energy LUMO of all materials present within the EML or
(j) the energy of the lowest unoccupied molecular orbital LUMO of the neutral metal-organic host compound LUMO_{MOH} being the lowest energy LUMO of all materials present within the EML and the HOMO energy of the organic emitter HOMO_{OE} being the highest HOMO of all materials present within the EML,
• the energy of the first excited triplet state of the organic emitter T1_{OE} being resonant or higher as compared to the energy of the Exciplex EE_{EX}: T1_{OE} ≥ EE_{EX},
• the energy difference of the emitting first excited singlet state S1_{OE} and the energy of the exciplex being less than 0.4 eV, preferably less than 0.3 eV, more preferably less than 0.2 eV: S1_{OE} - EE_{EX} ≤ 0.4eV, preferably ≤ 0.3eV, more preferably ≤ 0.2eV,
• preferably the organic emission layer EML being defined as in one of claims 2 to 13.

## Amended claims

### Amended claims in accordance with Rule 137(2) EPC.

1. An organic emission layer EML composition for an organic electroluminescent device, comprising:
at least one, preferably one metal-organic host compound MOH, and
at least one, preferably one organic emitter compound OE, and
optionally one or more further organic host compounds,
with the metal-organic host compound MOH having a total spin of ≥1/2 and/or possessing one or more unpaired electrons,
the lowest electronically excited state within the emission layer EML being an exciplex EX_{MOH/OE} formed by a single electron transfer between the MOH and
the OE, preferably by
(a) the energy of the highest occupied molecular orbital HOMO of the neutral metal-organic host compound HOMO_{MOH} being the highest energy HOMO of all materials present within the EML and the energy of the lowest unoccupied molecular orbital LUMO of the organic emitter compound LUMO_{OE} being the lowest energy LUMO of all materials present within the EML or
(b) the energy of the lowest unoccupied molecular orbital LUMO of the neutral metal-organic host compound LUMO_{MOH} being the lowest energy LUMO of all materials present within the EML and the HOMO energy of the organic emitter HOMO_{OE} being the highest HOMO of all materials present within the EML,
the energy of the first excited triplet state of the organic emitter T1_{OE} being resonant or higher as compared to the energy of the Exciplex EE_{EX}: T1_{OE} ≥ EE_{EX},
the energy difference of the emitting first excited singlet state S1_{OE} and the energy of the exciplex being less than 0.4 eV, preferably less than 0.3 eV,
more preferably less than 0.2 eV: S1_{OE} - EE_{EX} < 0.4 eV, preferably < 0.3 eV,
more preferably < 0.2 eV,
wherein HOMO and LUMO energies are obtained by quantum mechanical calculations using density function theory (DFT) or obtained using cyclic voltammetry (CV), ultraviolent photoemission spectroscopy (UPS) for the HOMO energy or Photoelectron Spectroscopy (XPS) for the LUMO energy,
with the metal organic host having a higher emission energy EE_{MOH} as compared to the emissive state of the organic emitter S1_{OE}: EE_{MOH} > S1_{OE}.

2. The composition of claim 1, with the first excited singlet state S1_{OE}, and/or the peak emission energy of the organic emitter from the first excited singlet state being >2.6 eV.

3. The composition of claim 2, with the first excited singlet state S1_{OE}, and/or the peak emission energy of the organic emitter from the first excited singlet state being >2.65 eV.

4. The composition of one of claims 1 to 3, with the organic emitter - comprising a plurality of fused aryl and/or heteroaryl groups,
- preferably comprising at least one boron atom,
- preferably with the ratio of emitting dipoles parallel to the substrate plane being >66%, preferably >80%, more preferably >90% with the sum of vertical and parallel emission dipoles being 100%.

5. The composition of one of claims 1 to 4, with the organic emitter compound OE being a multiresonant emitter conforms to any of the generic formulae (D-1) to (D-4): 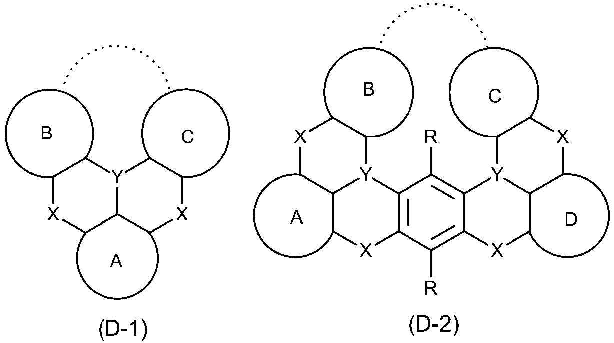 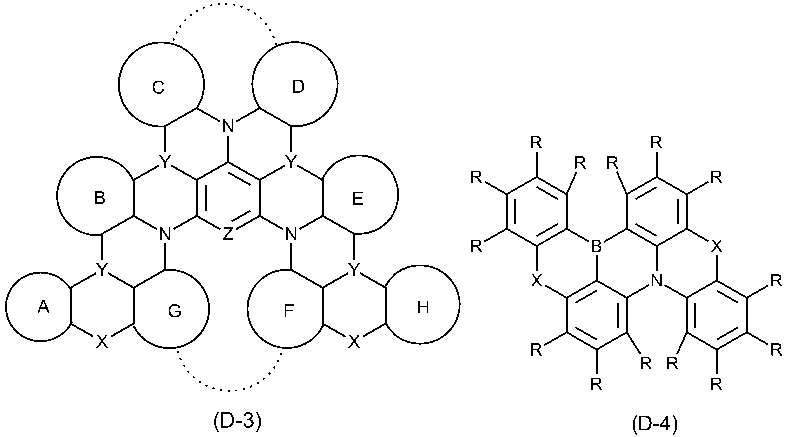 with,
- ring **A, B, C, D, E, F, G,** and H being each independently a substituted or unsubstituted aryl ring, or a substituted or unsubstituted heteroaryl ring, or a substituted or unsubstituted aliphatic ring, and
- a **broken line** connecting the B ring and the C ring in the formulae (D-1) or (D-2) and the broken lines connecting the C ring and the D ring and the G ring and the F ring in the formula (D-3) indicate that those rings are bonded ,or not, through a single bond or linking group at one of the available ring positions each and
- **Z** is CR₂ or NR, and
- **X** is each independently a single bond, NR, O, CR2, SiR2, S, or Se, and
- **Y** is each independently B, P, P(=O), P(=S), Al, Ga, As, CR, SiR, or GeR, preferably B, and
- **R** groups are each independently hydrogen, deuterium, halogen, aryl, heteroaryl, diarylamino, diarylboryl, alkyl, cycloalkyl, alkoxy or aryloxy, and adjacent R groups may be bonded to each other to form an aryl ring or heteroaryl ring.

6. The composition of one of claims 1 to 5, with the organic emitter compound OE being selected from d01 to d12:

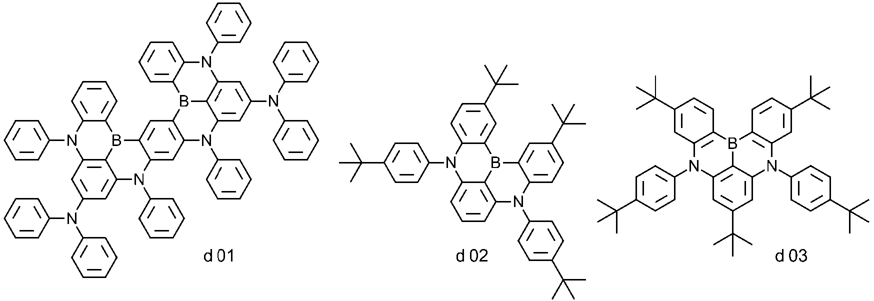

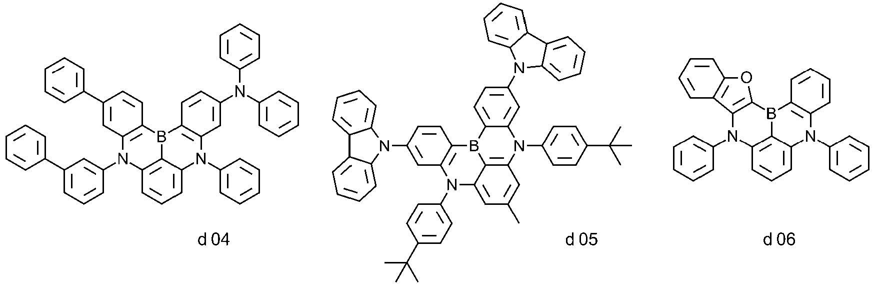

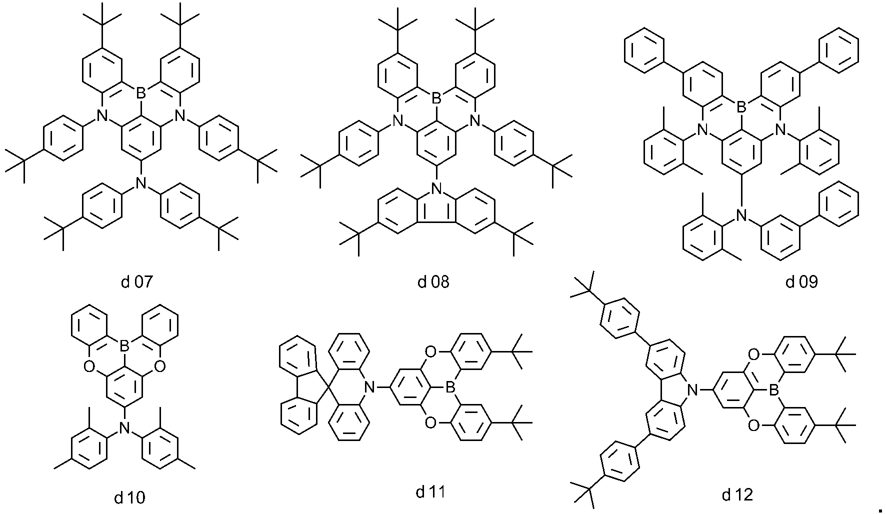

7. The composition of one of claims 1 to 6, with the metal-organic host material MOH comprising at least one metal cation selected from Gd(III), Ce(III), and Eu(II).

8. The composition of one of claims 1 to 7, with the metal organic host compound MOH, comprising one or more building blocks selected from CT-1 to CT-22: 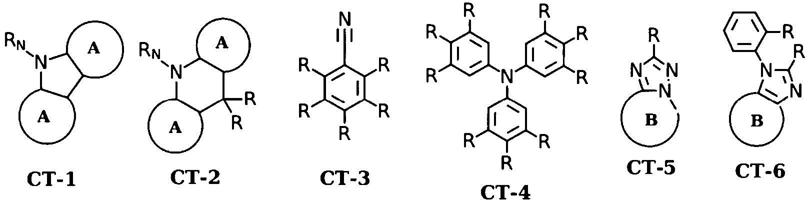 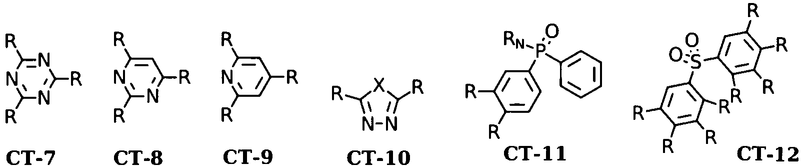 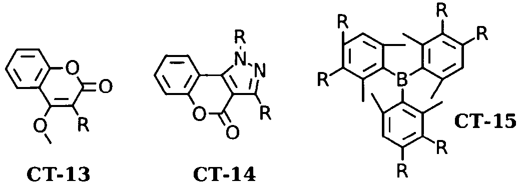 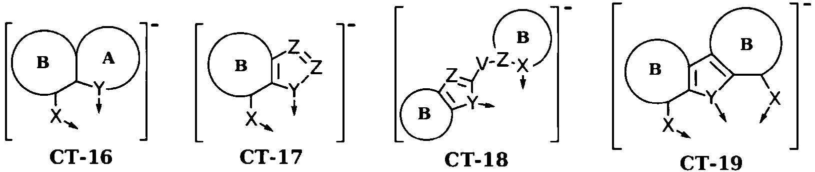 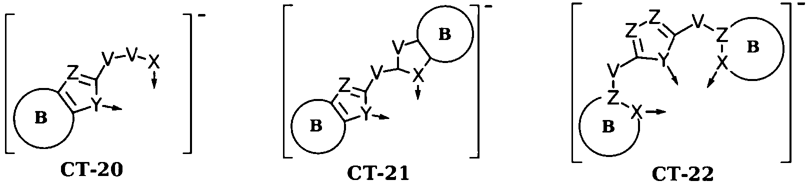
with
arrows indicating a preferential coordination towards the metal center of the metal organic host compound MOH,
**X** being independently in each occurrence a monovalent group selected from - O**R**, -S**R**, -N**R**2, -P**R**2,
**V** being independently in each occurrence a divalent group selected from -O-,
-S-, -N**R**-, -P**R**-, -C**R**2-, -Si**R**2-,
**Y** being independently in each occurrence selected from N, or P,
**Z** being independently in each occurrence selected from N, P, CR, SiR,
**R** independently in each occurrence representing a monovalent organic group formed by removing a hydrogen atom from an organic molecule having at least one hydrogen, H, D, or halogen and **R_{N}** independently in each occurrence representing a monovalent organic group formed by removing a hydrogen atom from an organic molecule having at least one hydrogen , and **A** being independently in each occurrence a substituted or unsubstituted aryl ring, or a substituted or unsubstituted heteroaryl ring, or a substituted or unsubstituted aliphatic ring, and **B** being independently in each occurrence a substituted or unsubstituted aryl ring, or a substituted or unsubstituted heteroaryl ring, or a substituted or unsubstituted aliphatic ring or **B** representing no cyclic group, but instead the atoms being connected to B are saturated by H, or any organyl group R as defined above.

9. The composition according to one of claims 1 to 8, with the sum of the organic emitter compound OE concentration and the metal organic host compound MOH concentration being >20 vol%, preferably >50 vol%, or essentially no other material apart from the metal organic host compound MOH and the organic emitter compound OE being present within the organic emission layer EML, or with the sum of the organic emitter compound OE concentration and the metal organic host compound MOH concentration being 100%, and/or with the volume concentration of the metal organic host compound MOH being at least 5 times, preferably at least 10 times and more preferably at least 15 times higher than the concentration of the organic emitter compound OE.

10. The composition according to one of claims 1 to 9, with the metal organic host compound MOH being present in two or more organic layers and/or with the metal organic host compound MOH being present in all organic layers between the organic emission layer and one of the electrodes and/or with metal organic host compound MOH being present as part of the hole injection layer in contact with the anode and being partly or completely oxidized into a cationic state by means of a suitable dopant material being present as part of the hole injection layer.

11. The composition according to one of claims 1 to 10, with the metal organic host compound MOH comprising a macrocyclic or polymacrocyclic organic ligand with at least one of these ligands being described by the generic formula (1-1): 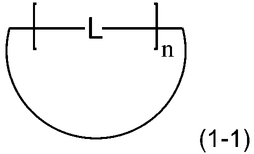
with
**n** being 4 to 8, preferably 4 to 6; and
**L** being independently in each occurrence a divalent organic group formed by removing two hydrogen atoms from an organic molecule having at least two hydrogens, with
the shortest sequence of atoms linking each L with the remainder of the cyclic ligand being 3 to 5, preferably 3 atoms, and with
one of those 3 to 5, preferably 3 atoms independently for each L being selected from N, P, S, Se, or O, preferably N, or O.

12. The composition according to one of claims 1 to 11, with the metal-organic host compound MOH containing a single organic ligand and a single metal cation, preferably a metal cation of oxidation stage +2 or +3 in combination with a single two- or threefold electrically negatively charged organic ligand, such that the combination of the single organic ligand with the single metal cation forms a complex of neutral electrical charge.

13. The composition according to one of claims 1 to 11, with the organic emission layer comprising at least one charge neutral organic host material at a concentration of >1vol%, preferably >10%, and more preferably >30%, based on the overall composition of the organic emission layer EML which is 100 vol%, with the host material preferably configured to transport electrons and/or holes and/or having a triplet energy higher than the singlet energy of the organic emitter compound OE, preferably with the HOMO energy of said neutral organic host material being 0.3 eV or less lower than that of the metal organic host compound in case the energy of the highest occupied molecular orbital HOMO of the neutral metal-organic host compound HOMO_{MOH} being the highest energy HOMO of all materials present within the EML and the energy of the lowest unoccupied molecular orbital LUMO of the organic emitter compound LUMO_{OE} being the lowest energy LUMO of all materials present within the EML, or preferably with the difference with the LUMO energy of said neutral organic host material being 0.3 eV or less shallower as compared to the metal organic host compound in case the energy of the lowest unoccupied molecular orbital LUMO of the neutral metal-organic host compound LUMO_{MOH} being the lowest energy LUMO of all materials present within the EML and the HOMO energy of the organic emitter HOMO_{OE} being the highest HOMO of all materials present within the EML.

14. A charge neutral metal organic coordination compound according to formula (2-1):
with CB₁₁⁻ being selected from a5 or a6: 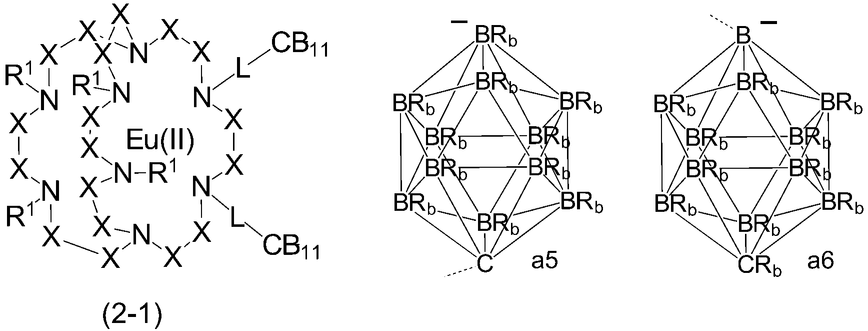
wherein
**R¹** is each individually selected from H, D, alkyl groups or aryl groups, preferably alkyl, more preferably methyl,
**X** is CR²₂ with R² being independently in each occurrence selected from H, D, halogen, or a monovalent organic group formed by removing one hydrogen atom from an organic molecule having at least one hydrogen, preferably H, D, halogen, alkyl, heteroalkyl, aryl or heteroalryl groups, more preferably H, or D and where two instances of R² present on the same or different carbon atoms can fuse and with
**L** in both instances being a divalent organic group formed by removing two hydrogen atoms from an organic molecule having at least two hydrogens, preferably alkylene, alkyleneoxy, more preferably propylene, or ethyleneoxy and with
**CB₁₁⁻** in both instances being a closo-carborate anion according to formulae a5 or a6 with the dashed lines indicating the covalent linkage to L, and **R_{b}** present in a5 and a6 independently in each occurrence represents H, D, halogen, or any monovalent organic group formed by removing a hydrogen atom from an organic molecule having at least one hydrogen, preferably **R_{b}** is H, or methyl.

15. An organic electroluminescent device comprising a first electrode, a second electrode, and an organic emission layer EML according to one of claims 1 to 13 disposed between the first electrode and the second electrode.
